(19)

Europäisches
Patentamt
European
Patent Office
Office européen
des brevets

(11) **EP 2 267 467 A1**

(12) **EUROPEAN PATENT APPLICATION**
published in accordance with Art. 153(4) EPC

(43) Date of publication:
**29.12.2010 Bulletin 2010/52**

(21) Application number: **08870760.9**

(22) Date of filing: **30.11.2008**

(51) Int Cl.:
*G01R 23/15* (2006.01)   *G01R 23/10* (2006.01)
*H03D 3/00* (2006.01)   *H03K 5/19* (2006.01)

(86) International application number:
**PCT/JP2008/071742**

(87) International publication number:
**WO 2009/090801 (23.07.2009 Gazette 2009/30)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.01.2008 JP 2008006315**
            **15.01.2008 JP 2008006316**
            **15.01.2008 JP 2008006317**

(71) Applicant: **Nagasaki University,**
**National University Corporation**
**Nagasaki-shi**
**Nagasaki 852-8521 (JP)**

(72) Inventor: **KUROKAWA, Fujio**
**Nagasaki-shi**
**Nagasaki 852-8521 (JP)**

(74) Representative: **Kohler Schmid Möbus**
**Patentanwälte**
**Ruppmannstraße 27**
**70565 Stuttgart (DE)**

(54) **FREQUENCY DETECTION DEVICE, FREQUENCY DETECTION METHOD, CIRCUIT CONTROL DEVICE, CIRCUIT CONTROL METHOD, DELAY CIRCUIT CONTROL METHOD, AND DELAY CIRCUIT SYSTEM**

(57)    Disclosed are a device and a method for comparing a detected frequency signal (first frequency signal) and a second fre- quency signal which is obtained by delaying the detected frequency, to determine whether the frequency transitioned to a predetermined area on high frequency side or reached a predetermined value on the upward direction side. The frequency detection device (1) comprises: a delayed signal output circuit (11) that outputs a second frequency signal (F2) obtained by delaying the first frequency signal (F1), which has a frequency that changes over time, by a set period (Δi ); and a determination circuit (12), which inputs the first frequency signal (F1) and the second frequency signal (F2), determines whether or not the cycle of the first frequency signal (F1) is included in the cycle of the second frequency signal (F2) and/or whether or not the cycle of the second frequency signal (F2) is included in the cycle of the first frequency signal (F1), and outputs a determination signal.

Fig. 1

(A)

(B)

(C)

EP 2 267 467 A1

**Description**

Field of the invention

(invention A):

The present invention relates to a technique to compare the second frequency signal (this first frequency signal is retarded for predetermined time, and it is signaled) with the first frequency signal (a detecting signal). Specifically, the present invention relates to a frequency detection apparatus (and frequency detection methods) that can judge what the predetermined value is reached, and frequency of the first frequency signal added.

(invention B)

The present invention relates to the arts for detecting (a) input current (the input current of the electric circuits such as power converter circuits), (b) input voltage, (c) output current, (d) output voltage, (e) voltage occurring to the electric reactor, (f) reactor current, (g) the voltage between the terminal of the switch, (h) switch current,(i) voltage appearing to the diode (a commutation diode, a rectifier diode), (h) diode current. Specifically, the present invention relates to a good controlled electric circuit controller (and an electric circuit control method).
Even more particularly, the present invention relates to the electric circuit comprising the frequency detecting circuit which converts a detection level into frequency signal specifically.
Specifically, the present invention relates to an electric circuit controller (and an electric circuit control method) which can judge changes (frequency of the frequency signal having changed in a predetermined level or the frequency of the cover detecting signal having reached the predetermined value) such as current or the voltage by simple structure.

(invention C)

The present invention relates to the delay circuit (and a delay circuit system) comprising a plurality of impedance circuits connected to a gland in the path of the input signal.
Specifically, the present invention relates to a delay circuit (and a delay circuit system) which minute delay can be generated and can perform a circuit design easily.

Background-Art

(invention A)

A technique to detect that frequency of the measuring signal reached reference frequency is known conventionally.
In this technique, at first the periodic signal of the reference is generated, and, then, the phase of this reference periodic signal and the phase of the measuring signal are compared.
In this kind of technique, Recursive Discrete Fourier Transform may be used (patent document 1).
Also, anAFC (Automatic Frequency Control) loop may be used (patent document 2).

(invention B)

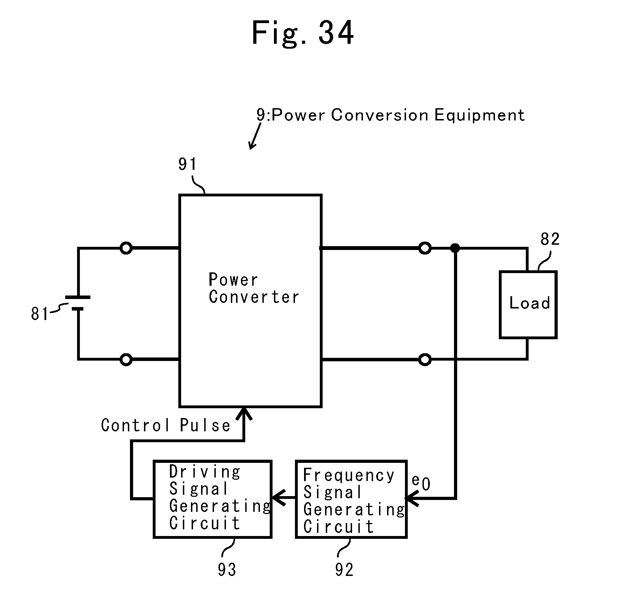

As shown in FIG. 34, the power conversion equipment 9 possesses power converters 91, the periodic signal generation circuit 92 and the driving signal generation circuit 93. The power converters 91 converts direct current power from power supply 81 into AC power or direct current power.
And the converted output (direct current power or AC power) is supplied to load 82 (cf. patent document the third class).
The periodic signal generation circuitry 92 inputs an output signal from power converters 91, and converts this voltage value into a periodic signal.
The driving signal generation circuitry 93 has averaging circuitry.
The averaging circuit counts signal input from periodic signal generation circuitry 92, and.
The averaging circuitry calculates the mean value between the place commuter pass of the output voltage.
Driving signal generation circuitry 93 drives an electric switch of power converters 91 depending on a calculation result of the averaging circuitry.

(invention C)

The delay circuits are usually comprised of a large number of delay elements performed series connection of. The delayed signals are acquired by a tap provided between each elements.

The detecting circuit integrates the input of the rectangular wave.

When capacitor voltage to comprise an integrating circuit reached the threshold, delayed signals occur.

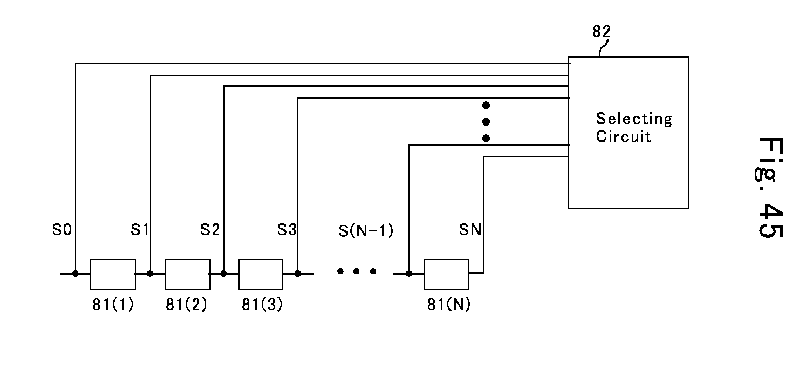

A method to generate delayed signals is shown in FIG. 45.

In FIG. 45, delay circuit 8 is comprised of a plurality of delay formative elements 81 (k) (k=1,2, · · · ,N) .

A plurality of lines (lines 83) are drawn out from selective circuit 82 (cf. patent document 4).

Lines 83:

A line of signal S0 in the input signal path

The line of the output side (signal S2) of line delay formative element 81 (2) of the output side (signal S1) of delay formative element 81 (1)

• • •

The line of the output side (signal SN) of delay formative element 81 (N)

The selective circuit 82 selects one or more lines from a plurality of lines (lines 83). Different signal (original signal S0 delayed signals S 1, S2, ..., either of SN) of the delay time is thereby taken out.

[prior art literature]

[a patent document]

[patent document 1]JP2003-344463
[patent document 2]JP1995-154435
[patent document 3]JP2002-330545
[patent document 4] JP1990-141029

DISCLOSURE OF THE INVENTION

PROBLEM TO BE SOLVED BY THE INVENTION

(invention A)

In each conventional technique, a reference signal generator, a phase detector are necessary.

Thus, there is a problem that overall circuitry is complicated.

(invention B)

As mentioned earlier, using power conversion equipment 9 of FIG. 34, the mean value in scheduled periods such as the voltage can be detected.

However, using power conversion equipment 9, voltage instantaneous value cannot be detected.

It is not illustrated, but, in the power conversion equipment of the current control type, current value is converted into a voltage value, and this voltage value is converted into a periodic signal.

Using this periodic signal, a current peak is detected, and the current of power converters is controlled.

In this case, the current peak is supposed from the mean of current value converted into a voltage signal.

That is, by the conventional control (control of the voltage-controlled power conversion equipment and control of the current control type power conversion equipment), instantaneous value of the voltage and instantaneous value of the current peak cannot be detected.

Thus, highly precise control was not able to be simplified.

(invention C)

A delay formative element must be used more than 1000 to raise resolution with the delay circuit of FIG. 45 (i.e., N is "1000" or more).

In this case, correct delay is not generated when the distances between each delay formative elements are different.

Also, correct delay cannot be generated when the length of each lines from each delay formative element81(x)( x = 1,2,..., N) to selective circuit 82 is different.

As a practical matter, the distance between the delay formative element is different from selective circuit 82.

Also, the length of each lines from each delay formative element to selective circuit 82 cannot be equated.

In reality, it is not easy to set delay time minutely (e.g., setting a large number of delay every several nanoseconds).

In the manufacturing process of the integrated circuit, delay formative elements 81(1) ... 81 (N) 1,000 or more must be made on semiconductor substrate as described above. The distance between each delay formative elements must be the same as possible as described above, besides.

Also, the length of each lines from each delay formative element to selective circuit 82 must be made the same as much as possible as described above.

Thus, the pattern design of the integrated circuit is extremely difficult.

(an object of "invention A"):

The object of "invention A" (a frequency detection apparatus and frequency detection methods) compares the second periodic signal (the signal which retarded measuring signal for predetermined time) with the first periodic signal (measuring signal), and it is to judge that frequency rose to the place set price of the high pass side.

The object of "invention A" (a frequency detection apparatus and frequency detection methods) compares the second periodic signal (the signal which retarded measuring signal for predetermined time) with the first periodic signal (measuring signal), and it is to judge that frequency dropped to a place set price of the low level side.

(an object of "invention B"):

An object of "invention B" is that the change (frequency of the measuring signal having risen to the place set price of the high pass side) of the control parameter can be determined by simple structure and highly precise control provides the power conversion equipment which it is possible for.

Other objects of "invention B" are to provide a control method of the power conversion equipment.

Other objects of "invention B" are that the change (frequency of the measuring signal having fallen to place set price of the drop direction side) of the control parameter can be judged to be by simple structure and highly precise control provides the power conversion equipment which it is possible for.

Other objects of "invention B" are to provide a control method of the power conversion equipment.

(an object of "invention C"):

The object of "invention C" is resolution can generate minute delay and to provide the delay circuit that a circuit design is easy and a delay circuit system.

(invention A) :

(1)

A number detection apparatus comprising from the delayed signals output circuit and the judgment circuitry, wherein,

the requency supplies a signal to the delayed signals output circuit two periods that retarded a time changing first periodic signal for predetermined time,

the judgment circuitry inputs the first periodic signal and the second periodic signal, the judgment circuitry detects whether the first period included period of a signal for period of a signal in the second period, and judgment signal is output, and/or,

the judgment circuitry detects whether the second period included period of a signal for period of a signal in the first period, and judgment signal is output.

The delayed signals output circuit can be comprised by an analog circuit.

Also, the delayed signals output circuit can be comprised by a digital circuit.

In delay time, it can be set appropriately.

The first periodic signal (measuring signal) is typically a narrow width pulse string, a rectangular wave, a serrulation wave, a triangular wave, a sine wave.

A pulse interval changes when the first periodic signal is a narrow width pulse string.

When the narrow width pulse string of the first periodic signal is an original or negative pulse, the judgment circuitry detects whether the narrow width pulse of the first periodic signal and the narrow width pulse of the second periodic signal are input alternately.

And the judgment circuitry is judged to be whether period of a signal is included in the second period for period of a signal in the first period.

Alternatively, the judgment circuitry is judged whether period of a signal is included in the first period for period of a signal in the second period.

For example, the judgment circuitry detects only a positive pulse or a negative pulse as the first periodic signal, and a positive pulse and the case including two pulses of the negative pulse can output judgment signal to one period a narrow width pulse string.

The judgment circuitry can be judged when the first periodic signal is squarewave whether the first period includes period of a signal by an edge (a positive going edge or a negative-going edge) in the second period for period of a signal.

Alternatively, the judgment circuitry can be judged whether period of a signal is included by the edge in the first period for period of a signal in the second period.

The judgment circuitry can be judged when the first periodic signal is serrulation wave whether the first period includes period of a signal by an edge (or a maximum of the serrulation amplitude of wave) in the second period for period of a signal. Alternatively, the judgment circuitry can be judged whether the period of the first pulse is included for period of a signal in the second period.

When the first periodic signal is a triangular wave and a sine wave, the judgment circuitry can be judged whether period of a signal is included by a peak (a maximum and a minimum) in the second period for period of a signal in the first period.

Also, the judgment circuitry can be judged whether the first period includes period of a signal by a zero point in the second period for period of a signal.

The judgment circuitry can be judged whether period of a signal is included by a zero point in the first period for period of a signal in the second period.

In "invention A", it can be determined to have changed into a predetermined level of the high pass side by frequency.

In "invention A", it can be determined to have reached the set value of the rise direction side by frequency.

The frequency at that time is reciprocal of the delay time.

Thus, when delay time is determined by at least one detection level, that frequency changes in a predetermined level of the high pass side or frequency changed into a predetermined level of the low level side can be detected.

(2)

The frequency detection apparatus as claimed in (1), wherein,

the judgment circuitry detects time when the first period included period of a signal for period of a signal in the second period, thereby,

judges that the frequency of the first periodic signal changed in a predetermined level of the high pass side or that it rose to the predetermined value,

and/or,

the judgment circuitry detects time when the second period included period of a signal for period of a signal in the first period, thereby,

judges that the frequency of the first periodic signal changed in a predetermined level of the low level side or that it dropped in predetermined value,

A frequency detection apparatus.

In the frequency detection apparatus of "invention A", time $\Delta$ tau can delay the first periodic signal by delayed signals output circuit.

And, as for the spacing of the narrow width pulse (or edges) of the first periodic signal, it is with $\Delta\tau/i$(an integer positive in i = 1,2,..., J, J) when period of a signal was included in the second period for period of a signal in the first period.

And, as for the spacing such as the narrow width pulse of the second periodic signal, the edge, it is with $j\Delta\tau$(an integer positive in j = 1/I, ..., one-third, half, 1, I) when period of a signal was included in the first period for period of a signal in the second period.

When the frequency of the first periodic signal changed in a predetermined level of the high pass side, the first period includes period of a signal in the second period for period of a signal.

Alternatively, period of a signal is included in the second period for period of a signal in the first period when the frequency of the first periodic signal reached place set price of the rise direction side.

When the frequency of the first periodic signal changed in a predetermined level of the low level side, the second period includes period of a signal in the first period for period of a signal.

Alternatively, the second period includes period of a signal in the first period for period of a signal when the frequency of the first periodic signal reached the place set price of the drop direction side.

Thus, in "invention A", the frequency of the first periodic signal dropped, and the lower limit was reached, or it is distinguished, and it can be determined whether frequency rises, and the upper limit was reached.

In "invention A", as for the judgment circuitry, the first periodic signal is a narrow width pulse string.

This narrow width pulse string includes a positive pulse and two pulses of the negative pulse in period.

When the distance of the pulse of these pluses and minus is 180 degrees, or, when the duty of the first periodic signal is 50%, it can be detected whether the half period of the first periodic signal was included for the half period of the second periodic signal. Alternatively, it can be detected whether in this case the half period of the second periodic signal was included for the half period of the first periodic signal.

For example, it is supposed that the first periodic signal (measuring signal) is supposed to be a narrow width pulse string, and this narrow width pulse string also includes a positive pulse and two pulses of the negative pulse in frequency, and, even more particularly, it is supposed that the spacing of the pulse of these pluses and minus is 180 degrees.

In this case, the judgment circuitry can determine both positive pulse and negative pulses as a pulse (an equivalent pulse) of the same property.

The judgment circuitry outputs the judgment signal which responded to a judgement result.

Also, the judgment circuitry can detect both positive going edge and negative-going edges as an edge (an equivalent edge) of the same property when the first periodic signal is squarewave, and a duty is 50%.

Even more particularly, the judgment circuitry can detect the both sides of a positive pulse and the negative pulse as a pulse (an equivalent pulse) of the same property when the first periodic signal is a triangular wave and a sine wave, and the spacing of a maximum of the magnitude and the minimum is 180 degrees.

A frequency detection apparatus as claimed in (2), wherein the judgment circuitry,

when that period of a signal was included for period of a signal in the second period in the first period was detected,

That the frequency of the first periodic signal changes into a predetermined level of the high pass side depending on the detected number of times or it rose to the predetermined value is judged.

When period of a signal detected that it was included for period of a signal in the second period in the first period, the judgment circuitry performs the judgment that responded to the number of times.

By the first detection, the period is delay time $\Delta\tau/1$,

By the second detection, period is delay time $\Delta\tau/2$,

• • •

By the detection of a thing of a beginning, period is delay time $\Delta\tau/I$

It is thereby judged the frequency of the first periodic signal changes into a predetermined level of the high pass side or to have reached the place set price of the rise direction side.


(4)

When, as for the judgment circuitry, $\Delta\tau$ meets a lower formula,

$$T1+T2+ \text{ ... } TJ <= \Delta \tau <T1+T2+ \text{ ... } TJ+TJ+1$$

(an integer positive in Tk (k = J, k-th pulse of the first periodic signal as for ...,3,2,1), J) In である case,

When period of a signal detected that it was included for period of a signal in the first period in the second period, at the period is delay time $\Delta\tau(1/j)$ (j = J, ...,3,2,1), the frequency of the first periodic signal changes in a predetermined level of the high pass side or it is judged predetermined value to have risen.

The specific handling of judgment circuitry is as follows.

As for the judgment circuitry, period judges that the frequency of the first above periodic signal changed into a predetermined level of the high pass side by a certain delay time $\Delta\tau/J$ in the first detection.

Alternatively, the judgment circuitry judges that period reached the value with the frequency of the first above periodic signal by the delay time $\Delta\tau/J$ that there is in the first detection.

The judgment circuitry judges that the frequency of the first periodic signal changed into a predetermined level of the high pass side by delay time $\Delta\tau/(J-1)$ with the period (or having reached the place set price of the rise direction side) in the second detection. The judgment circuitry judges that the frequency of the first periodic signal changed into a predetermined level of the high pass side by delay time $\Delta\tau$ with the period (or having reached the place set price of the rise direction side) in the detection of the J joint likewise.

(5)

A frequency detection apparatus as claimed in (1),
wherein the delay circuit inputs the first periodic signal, and the second periodic signal is output, is initialized.

(6)

(1) A frequency detection apparatus to assume a frequency detection apparatus as claimed in (5) either hot 1 unit, wherein,
the R units (the first - the Rth) are connected in parallel, in which the first periodic signal is common,
a delay time $\Delta\tau1$ to the first periodic signal of the second periodic signal in the first unit, a delay time $\Delta\tau1$ to the first periodic signal of the second periodic signal in the second unit,
• • •
a delay time $\Delta\tau1$ to the first periodic signal of the second periodic signal in the R-th unit, are different each other.

(7)

A frequency detecting device that the frequency detecting apparatus discribed in either of (1)-(5) is defind as one unit, wherein,
the 1st-Rth units are connected to in parallel,
A delay time $\Delta\tau$ to the first periodic signal of the second periodic signal in each unit is the same,
The phase of each first periodic signal in the 1st-Rth unit is different by $2\pi/R$.

(8)

The first periodic signal is performed voltage - frequency conversion of.
A frequency detection apparatus as claimed in claim 1, wherein,
the first periodic signal is performed voltage-frequency conversion of.

(9)

A requency detection methods
that the second periodic signal delaying to the first periodic signal from the first periodic signal that frequency changes at time for predetermined time is generated, and this is output,
Frequency detection methods
The frequency detection methods including judging that the frequency of the above first periodic signal changes into a predetermined level of the low level side by detecting time when that the frequency of the above first periodic signal changes into a predetermined level of the high pass side by detecting time when the first period included period of a signal for period of a signal in the second period or it rose to the predetermined value is judged and/or period of a signal was included for period of a signal in above first period in above second period or it dropped in predetermined value.

(10)

When that period of a signal was included for period of a signal in the second period in the first period was detected, depending on the number of times, period is $\Delta\tau/i$ by the detection of i turn eyes the frequency of the first above periodic signal in delay time (an integer positive in i = 1,2,..., I, I)
Well, the frequency detection methods as claimed in (9) including judging that frequency of the first periodic signal F1 changes in a predetermined level of the high pass side or the place set price of the rise direction side was reached.

(11)

In a case of T1+T2+ ... TJ $\le \Delta\tau <$ T1+T2+ ... TJ+TJ+1,
Including judging that the frequency of the first above periodic signal changes in a predetermined level of the high pass side by delay time or period reached the place set price of the rise direction side in j-th detection when that the second period included period of a signal for period of a signal in the first period was detected or it is frequency detection methods as claimed in (10) (9).

(12)

Whenever the first periodic signal is input, and the second periodic signal is output,
A frequency detection methods as claimed in either of (9)-(11) including the deference of the second periodic signal being initialized.

(13)

A frequency detection method as claimed in either of (9)-(12) including the first periodic signal being performed voltage-frequency conversion of.

(invention B):

(1)

The electric circuit controller comprising driving signal generation circuitry, periodic signal generation circuitry and the frequency detecting circuit, wherein the driving signal generation circuitry drives at least one electric switch included in the electric circuit,
the periodic signal generation circuitry detects an electric information (voltage/ current/ electric power/ phase) changing than the electric switch being driven more than one or one, and a periodic signal is generated from at least one electric information chosen by these detecting signals, and this is output as the first periodic signal,
the delayed signals generation circuitry outputs the second periodic signal which retarded the first periodic signal for predetermined time,
the judgment circuitry detects whether the first periodic signal and the second periodic signal are input, and period of a signal was included for period of a signal in above second period in above first period and/or whether period of a signal was included for period of a signal in above first period in above second period, and judgment signal is output.
The periodic signal generation circuitry can detect the following quantity of electricity as "current flowing or the voltage in the appointed part or voltage drop in an appointed part".
Input current, input voltage, output current, output voltage, electric reactor voltage, electric reactor current, electric switch voltage, electric switch current, diode voltage, diode current.
The electric circuit controller of "invention B" may be the voltage-controlled, and even current control type is preferable.
The electric switch comprising a power circuit is semiconductor switch such as a bipolar transistor, the FET transistor.
The periodic signal which periodic signal generation circuitry produces is typically a narrow width pulse string, a rectangular wave, serrulation wave, a triangular wave, a sine wave.
Delayed signals generation circuitry may be an analog circuit, and it may be a digital circuit.
In delay time, it is set appropriately.
The spacing of the pulse changes when the first periodic signal which periodic signal generation circuitry produces is a narrow width pulse string.
When the narrow width pulse string of the first periodic signal is an original or negative pulse, the judgment circuitry monitors whether the narrow width pulse of the first periodic signal and the narrow width pulse of the second periodic signal are input alternately.
And the judgment circuitry can be judged whether period of a signal is included in the second period for period of a signal in the first period.
Alternatively, the judgment circuitry can be judged whether period of a signal is included in the first period for period of a signal in the second period.
For example, the judgment circuitry detects only a positive pulse in a positive pulse and the case including two pulses of the negative pulse as the first periodic signal, and a narrow width pulse string can output judgment signal in one period.
The judgment circuitry can monitor an edge (a positive going edge and a negative-going edge) when the first periodic signal is squarewave.
The judgment circuitry can be judged whether period of a signal is included in the second period for period of a signal or whether the first period includes period of a signal in the first period for period of a signal in second period.
The judgment circuitry monitors an edge (a positive going edge and a negative-going edge) when the first periodic signal is serrulation wave or a maximum of the serrulation amplitude of wave can be watched.
The judgment circuitry can be judged whether period of a signal is included in the second period for period of a signal or whether the first period includes the period of the first pulse for period of a signal in second period.

The judgment circuitry can monitor, for example, a peak (a maximum and a minimum) and a zero point when the first periodic signal is a triangular wave and a sine wave.

The judgment circuitry can be judged whether period of a signal is included in the second period for period of a signal or whether the first period includes period of a signal in the first period for period of a signal in second period.

In "invention B", it can be determined to have reached the predetermined value by frequency.

The frequency at that time is reciprocal of the delay time.

Thus, in a certain control system, delay time can detect the frequency when frequency reached the predetermined value when it is determined by at least one detection value. That is, in this case current corresponding to the frequency and value (peak (maximum and minimum)) of the voltage can be detected.

(2)

An electric circuit controller as claimed in (1), wherein,
the electric signal are selected from below group.
The input voltage of the electric circuit,
The input voltage of the electric circuit,
Voltage emerging to an element comprising the electric circuit or equipment, the element or above equipment current flowing,
The output voltage of the electric circuit,
The output current of the electric circuit.

(3)

The electric circuit controller which was described in (1) or (2), wherein,
It is retarded without being based on the change of the electric information or the delayed signals generation circuitry retards the first periodic signal based on at least one of the above electric information, and an above second periodic signal is output.

(4)

An electric circuit controller as claimed in (1), wherein,
that the frequency of the above first periodic signal dropped in predetermined value because the frequency detecting circuit judges that the frequency of the above first periodic signal rose to the predetermined value because the judgment circuitry detects time when period of a signal was included for period of a signal in above second period in the first period and/or above judgment circuitry detects time when period of a signal was included for period of a signal in above first period in above second period is judged.

In "invention B", the frequency detecting circuit can delay a periodic signal by delayed signals generation circuitry only at a certain time $\Delta \tau$.

In this case, the first period includes period of a signal in the second period for period of a signal when the spacing of the edge of the periodic signal is $\Delta \tau$.

Alternatively, period of a signal is included in the first period for period of a signal in this sometimes second period.

When when period of a signal was included in the second period for period of a signal in the first period, the frequency of the first periodic signal rose to the predetermined value.

When when period of a signal was included in the first period for period of a signal in the second period, the frequency of the first periodic signal dropped to a place set price of the drop direction side.

Thus, as for the frequency detecting circuit, the frequency of the first periodic signal rose, and the above place set price was reached, or it can draw a sharp line whether it drops, and the above place set price was reached.

Note that the spacing of a narrow width pulse and the edge of the first periodic signal is as follows when period of a signal was included in the second period for period of a signal in the first period.

$$\Delta \tau / i \ (i = 1, 2, ..., J, \ J \text{ is an integer})$$

Also, the spacing of a narrow width pulse and the edge of the second periodic signal is as follows when period of a signal was included in the first period for period of a signal in the second period.

$$j\Delta\tau\ (j = 1/I,\ ...,\ 1/3,\ 1/2,\ 1,\ I\ is\ ingeger)$$

The first periodic signal is a narrow width pulse string.
This narrow width pulse string may include a positive pulse and a negative pulse of the 180 degrees spacing in one period. Also, the duty of the first periodic signal may be 50%.
In these cases, the judgment circuitry can be detected whether the half period of the first periodic signal was included for the half period of the second periodic signal and/or whether the half period of the second periodic signal was included for the half period of the first periodic signal.

For example, the judgment circuitry can judge the both sides of a positive pulse and the negative pulse as a pulse (an equivalent pulse) of the same property in a positive pulse of the 180 degrees spacing and the case including the negative pulse in one period a narrow width pulse string.

Also, both positive going edge and negative-going edges is done with the edge (an equivalent edge) of the same property, and the judgment circuitry can be judged when the duty of the first periodic signal is 50%.
Even more particularly, the judgment circuitry can judge the both sides of a positive pulse and the negative pulse as a pulse (an equivalent pulse) of the same property when the first periodic signal is a triangular wave and a sine wave, and the spacing of a maximum of the magnitude and the minimum is 180 degrees.

(5)

An electric circuit controller as claimed in (1)-(2), wherin,
the judgment circuitry,
When that the first period included period of a signal for period of a signal in the second period was detected, that the frequency of the first periodic signal changes in a predetermined level of the high pass side by the i-th detection by delay time with the period or the frequency of the above first periodic signal reached the place set price of the rise direction side depending on the number of times is judged.
the delay time $\Delta\tau$/i (an integer positive in i = 1,2,..., I, I):

(6)

An electric circuit controller as claimed in either from (1) to (5) including the judgment circuitry judging that the frequency of the above first periodic signal changes in a predetermined level of the high pass side in $\Delta\tau$ (j = J, ...,3,2,1) (1/j) in delay time or period reached the place set price of the rise direction side in j-th detection when that period of a signal was included for period of a signal in above first period in the second period was detected in a case of T1+T2+ ... +TJ <= $\Delta\tau$<T1+T2+ ... +TJ+TJ+1 (an integer positive in J).

(7)

Whenever the delay circuit inputs the first periodic signal, and the second periodic signal is output, an electric circuit controller as claimed in either from (1) from to (7) including what is initialized.

(8)

A frequency detecting circuit comprising an electric circuit controller as claimed in either of hot is done with 1 unit, and it is the electric circuit controller comprising the frequency detecting circuit that it is made a common use of in an above first periodic signal, and R unit is connected from the first unit in parallel, and it is, and in the delay time to the first periodic signal of the second periodic signal in the first unit in the delay time to the first periodic signal of the second periodic signal in $\Delta\tau$ 1 and the second unit $\Delta\tau$ 2,
• • •
An electric circuit controller of the description including $\Delta\tau$R being different in the delay time to the first periodic signal of the second periodic signal in the R unit.

(9)

A frequency detecting circuit comprising an electric circuit controller as claimed in (1)-(7) is done with 1 unit, and it is the electric circuit controller comprising the frequency detecting circuit that it is made a common use of in an above first periodic signal, and R unit is connected from the first unit in parallel, and it is, and in the delay time to the first periodic signal of the second periodic signal in the first unit in the delay time to the first periodic signal of the second periodic signal in $\Delta \tau 1$ and the second unit $\Delta \tau 2$,

• • •

an electric circuit controller of the description including $\Delta\tau R$ being different in the delay time to the first periodic signal of the second periodic signal in the R unit.

(10)

Because the electric circuit is AC/DC power inverter circuit of current control type or the voltage-controlled or DC/DC power inverter circuit, and the electric information is characterized by being chosen voltage appearing to the input voltage of the electric circuit, the input voltage of the above electric circuit, an element comprising an above electric circuit or the equipment, an above element or above equipment by current flowing, the output voltage of the above electric circuit, the group of the output current of the above electric circuit, an electric circuit controller as claimed in either from (1) to (9).

(11)

A periodic signal is generated from an electric information of at least one that an electric information (voltage / current / electric power / a phase) changing by the drive of the electric switch of at least one included in the electric circuit is detected more than one or one, and was chosen by these measuring signal, and it is a method to control an electric circuit by detecting the frequency of the note periodic signal, and in detection of the above frequency, The electric circuit control method including it is detected whether the second periodic signal which retarded the first periodic signal for predetermined time is generated, and the first periodic signal and above second periodic signal are input, and period of a signal was included for period of a signal in above second period in above first period and/or whether period of a signal was included for period of a signal in above first period in above second period, and judgment signal is output, and driving an above electric switch depending on the judgement result.

(12)

The electric circuit control method as claimed in (11) including being chosen voltage appearing to the input voltage of the electric circuit, the input voltage of the electric circuit, an element comprising an above electric circuit or the equipment, an above element or above equipment as the electric information by current flowing, the output voltage of the above electric circuit, the group of the output current of the above electric circuit.

(13)

Including it is retarded without being based on the change of the electric information or the first periodic signal is retarded based on at least one of the above electric information, and outputting an above second periodic signal or it is an electric circuit control method as claimed in (12) (11).

(14)

An electric circuit control method as claimed in either from (11) to (13) including judging that the frequency of the above first periodic signal changes in a predetermined level of the low level side because the frequency of the above first periodic signal detects time when that it changes or the place set price of the rise direction side was reached is judged and/or a predetermined level of the high pass side included period of a signal for period of a signal in above first period in above second period by detecting time when the first period included period of a signal for period of a signal in the second period or the place set price of the drop direction side was reached.

(15)

An electric circuit control method as claimed in either from (11) to (14) including the frequency of the above first periodic signal judging that the frequency of the first periodic signal changes in a predetermined level of the high pass side in $\Delta\tau/i$ (an integer positive in i = 1,2,..., I, I) in delay time or period reached the place set price of the rise direction side by the i-th detection depending on the number of times when that the first period included period of a signal for period of a signal in the second period was detected.

(16)

The first period period of a signal,

$$T1+T2+ \dots +TJ <= \Delta\tau < T1+T2+ \dots +TJ+TJ+1 \text{ (an integer positive in J)}$$

An electric circuit control method as claimed in either from (11) to (15) including judging that the frequency of the above first periodic signal changes in a predetermined level of the high pass side in $\Delta\tau$ (j = J, ...,3,2,1) (1/j) in delay time or period reached the place set price of the rise direction side in j-th detection when that the second period included period of a signal for period of a signal in the first period was detected in Ⓓ case.

(invention C):

(1)

The delay circuit including the delay time when an above detecting circuit generates by one end is connected to the input signal path of the detecting circuit, and other end is a delay circuit having an impedance circuit connected to a gland, and a plurality of electric switches to change the overall impedance of the above impedance circuit into when an on control signal or an off control signal was input, respectively, be included in an above impedance circuit, and changing the impedance of the above impedance circuit by the combination of the ON state of the electric switch of plural above or the off state changing.

(2)

The delay circuit as claimed in (2) including the thing including impedance (a resistance ingredient, a capacity ingredient, an inductance ingredient) that the electric switch of plural at least above has the impedance circuit and/or the impedance due to the electric wiring.

(3)

The impedance circuit including the thing including a resistance element, a capacitative element, one of the inductance elements or combinations thereof or it is a delay circuit as claimed in (2) (1).

(4)

A delay circuit as claimed in either from (2) to (3) including the electric switch being a gate electric switch (the buffer with the control terminal).

(5)

(1)

The delay circuit system including the thing comprising the delay control circuit which sends out an ON-OFF control signal to a delay circuit as claimed in (4) either hot and each electric switch.

(6)

The delay circuit including the delay time when an above detecting circuit generates by one end is connected to the input signal path of the detecting circuit, and other end is a delay circuit having a plurality of impedance circuit element connected to a gland, and open position is formed between an above input signal path and an above gland when an on control signal was input, and the electric switch which forms impedance between an above input signal path and an above gland when an off control signal was input be included in each impedance circuit element, respectively, and changing the impedance of the above impedance circuit by the combination of the ON state of each electric switch or the off state changing.

(7)

The delay circuit as claimed in (6) including the thing including impedance (a resistance ingredient, a capacity ingredient, an inductance ingredient) that at least electric switch has the impedance circuit element and/or the impedance due to the electric wiring.

(8)

The impedance circuit element including the thing including a resistance element, a capacitative element, one of the inductance elements or combinations thereof or it is a delay circuit as claimed in (7) (6).

(9)

A delay circuit as claimed in either from (6) including impedance is P unit comprised delay circuit in Z (1), Z (2), ..., impedance circuit element of Z (N), respectively, and being represented unit lag time as $\tau$ zero in Tk (Z (k)) = (P+ 1) k-1$\tau$0 (k = 1,2,...., N) Tk in delay time by each impedance circuit element to (8).

(10)

A delay circuit as claimed in either from (6) to (10) including the electric switch being a gate electric switch (the buffer with the control terminal).

(11)

A delay circuit as claimed in either from (6) to (10) including the impedance circuit element includes a buffer, and the gland side being provided with the buffer than the electric switch.

(12)

The detecting circuit is a delay circuit as claimed in either from (6) to (11) including the thing including the CR integrating circuit comprising capacitive elements and a resistance element, capacitive elements and resistance elements.

(13)

(6) The delay circuit system including the thing comprising the delay control circuit which sends out an ON-OFF control signal to a delay circuit as claimed in (12) either hot and each electric switch.
When frequency conversion is made, and voltage and the current of all parts are detected in an AC/DC converter, DC/DC converter, boost chopper, depression chopper, and (output current, output voltage, output power, input current, output voltage, input power) to control listing and input is controlled, the delay circuit system of "invention C" is particularly effective.
An effect of the invention

(invention A):

By "invention A" configuration simple (a frequency detection apparatus and frequency detection methods), the second periodic signal (the signal which retarded measuring signal for predetermined time) can be compared with the measuring signal (the first periodic signal).
That frequency rose to predetermined value is thereby determined.
Also, that frequency dropped to predetermined value is determined.

(invention B):

The input current in the electric circuits such as power inverter circuits electric by simple structure, input voltage, output current, output voltage, voltage appearing to the electric reactor, an above electric reactor current flowing, voltage appearing to the above electric switch, an above electric switch current flowing, voltage appearing to the diode (a commutation diode, a rectifier diode), an above diode changes (that the frequency of the periodic signal rose to the predetermined level is detected with high accuracy.) such as the current flowing

Also, that frequency of the measuring signal dropped to a predetermined price is detected.

(invention C):

According to "invention C", setting of the delay time is enabled with high accuracy.
Because it is not necessary, as for the delay circuit of "invention C", the selective circuit (multiplexer) to select the signal which delayed appropriately from in delayed signals a lot (more than 1,000) does not have to keep a fixed lines length from each delay formative element to selective circuit 82.
Also, the limit of the design is relaxed without serially-connecting a large number of delay circuit elements.
Also, simplification of the circuitry can be planned.
After, in "invention C", having considered floating resistance such as the circuit wiring, floating capacitance, value of the floating inductance, it becomes easy to determine delay time (i.e., a circuit design becomes easy).
Because the production by the semiconductor process is easy, and the third state buffer of the same specifications also has little variation of the input impedance, it is preferable in "invention C".
A resistance element, a capacitative element, one or combinations of the inductance element thereof can be connected to these third state buffers.

Brief description of drawings

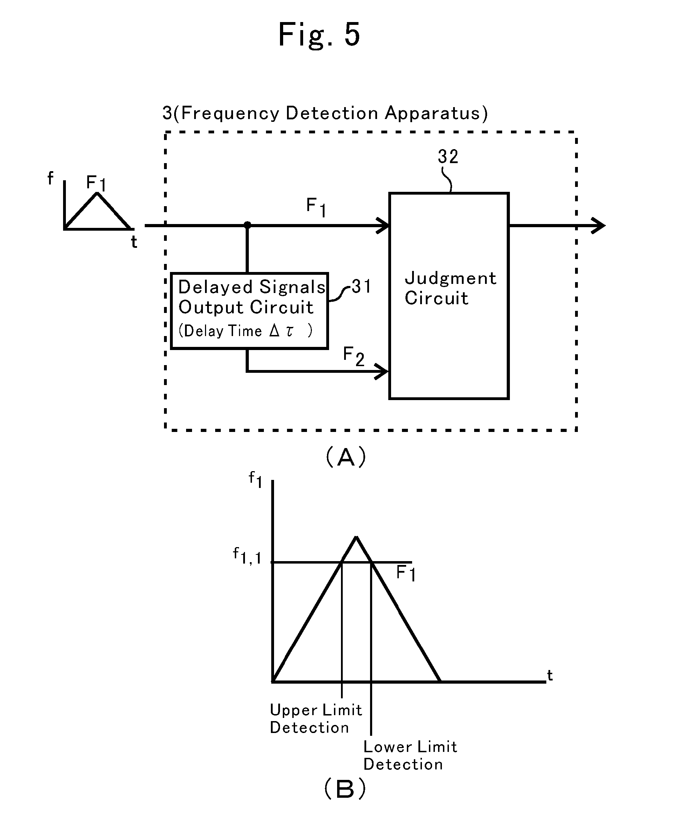

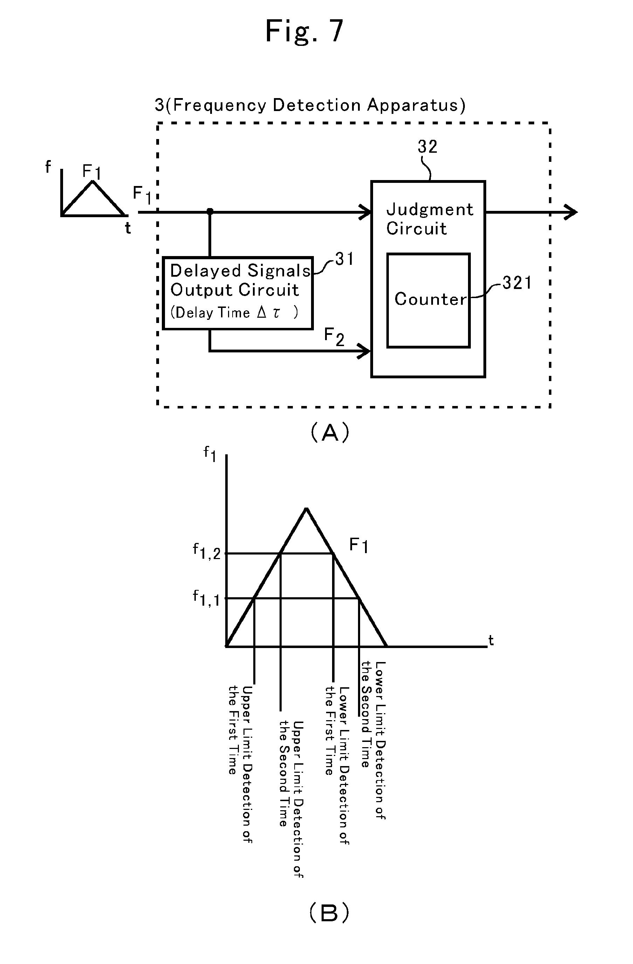

[FIG. 1]

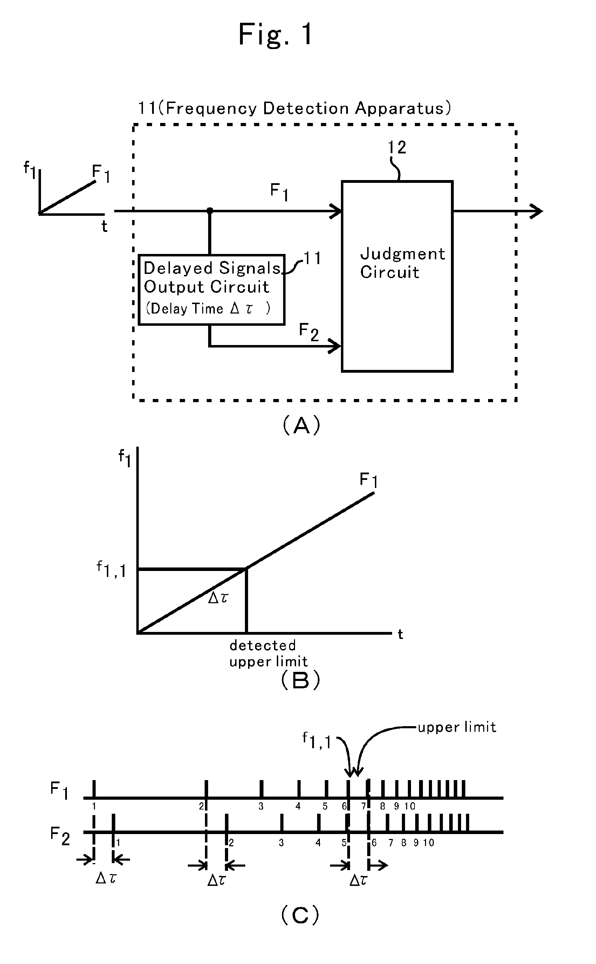

FIG. 1 is an illustration showing the first embodiment of "invention A", and (A) is an illustration of the frequency that figure showing the configuration of the frequency detection apparatus, (B) change into detection frequency and figure showing relations with the time, (C).
[FIG. 2]

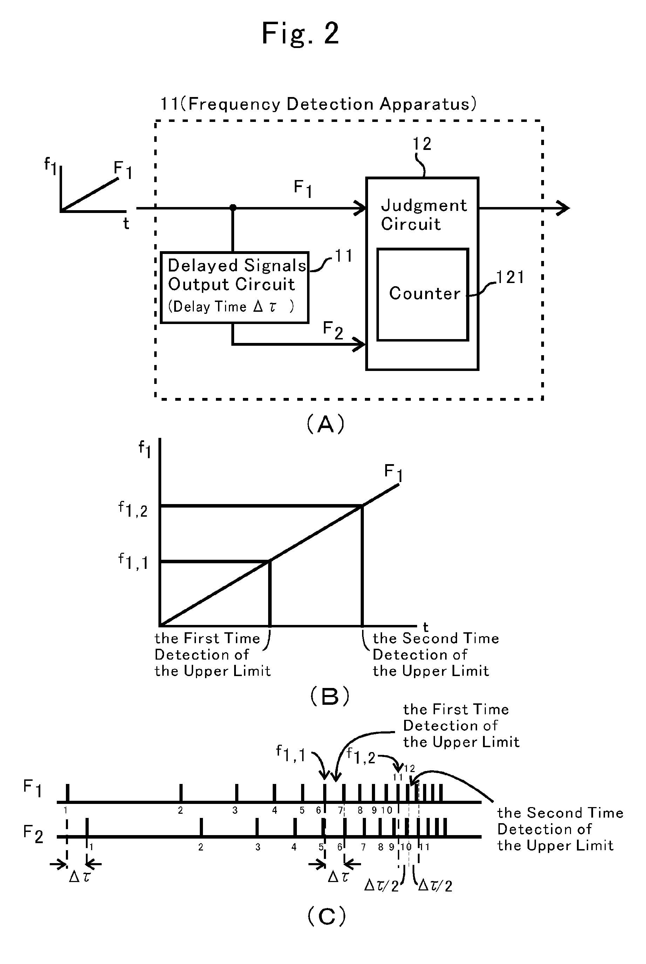

FIG. 2 is an illustration showing the variations of the first embodiment of "invention A", and (A) is an illustration of the frequency that figure showing the configuration of the frequency detection apparatus, (B) change into detection frequency and figure showing relations with the time, (C).
[FIG. 3]

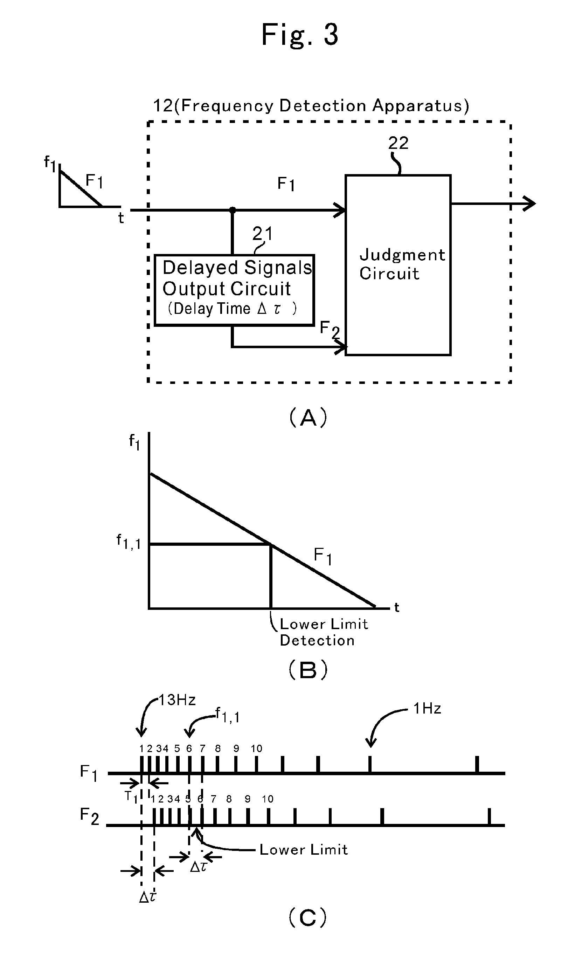

FIG. 3 is an illustration showing the second embodiment of "invention A", and (A) is an illustration of the frequency that figure showing the configuration of the frequency detection apparatus, (B) change into detection frequency and figure showing relations with the time, (C).
[FIG. 4]

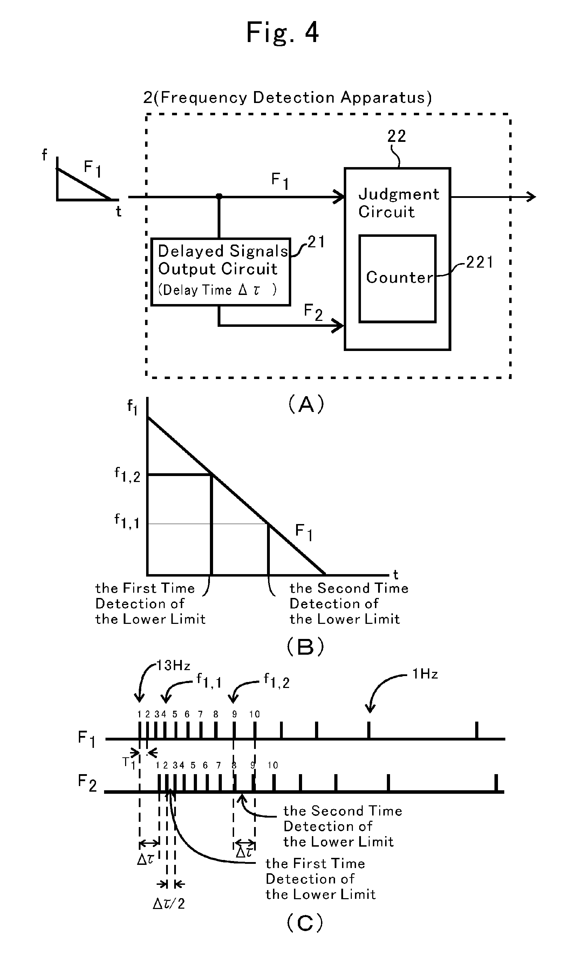

FIG. 4 is an illustration showing the variations of the second embodiment of "invention A", and (A) is an illustration of the frequency that figure showing the configuration of the frequency detection apparatus, (B) change into detection frequency and figure showing relations with the time, (C).
[FIG. 5]
It is an illustration showing the third embodiment (a frequency detection apparatus to have an upper bound and a lower limit of the frequency one by one) of "invention A", and, as for FIG. 5, in (A), figure showing the configuration of the frequency detection apparatus, (B) are detection frequency and figures showing relations with the time.
[FIG. 6]

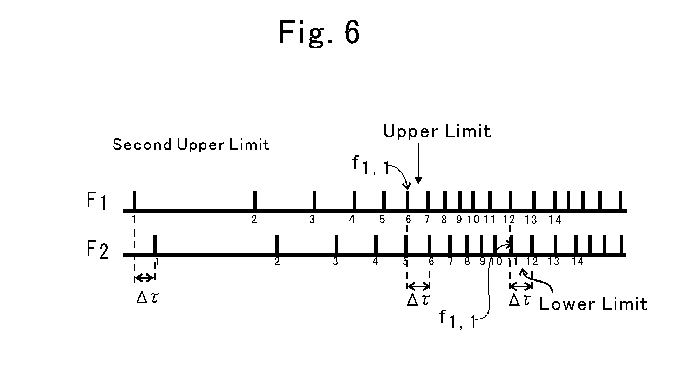

FIG. 6 is an illustration of changing frequency to kick in a frequency detection apparatus of FIG. 5.
[FIG. 7]
It is an illustration showing the third embodiment (the frequency detection apparatus that a plural number has an upper bound and a lower limit of the frequency, respectively) of "invention A", and, as for FIG. 7, in (A), figure showing the configuration of the frequency detection apparatus, (B) are detection frequency and figures showing relations with the time.
[FIG. 8]

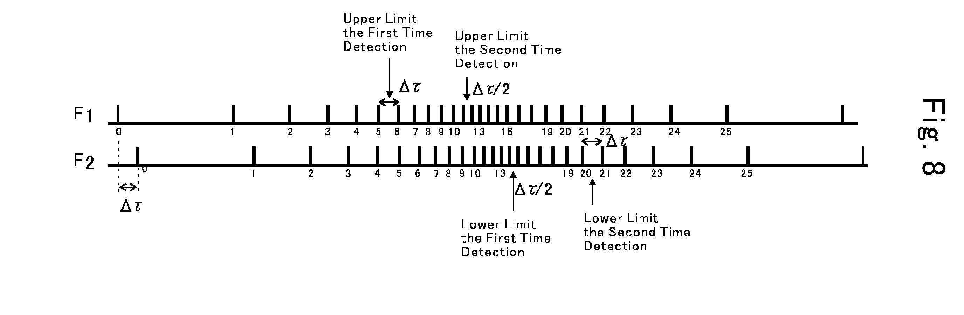

FIG. 8 is an illustration of changing frequency to kick in a frequency detection apparatus of FIG. 5.
[FIG. 9]

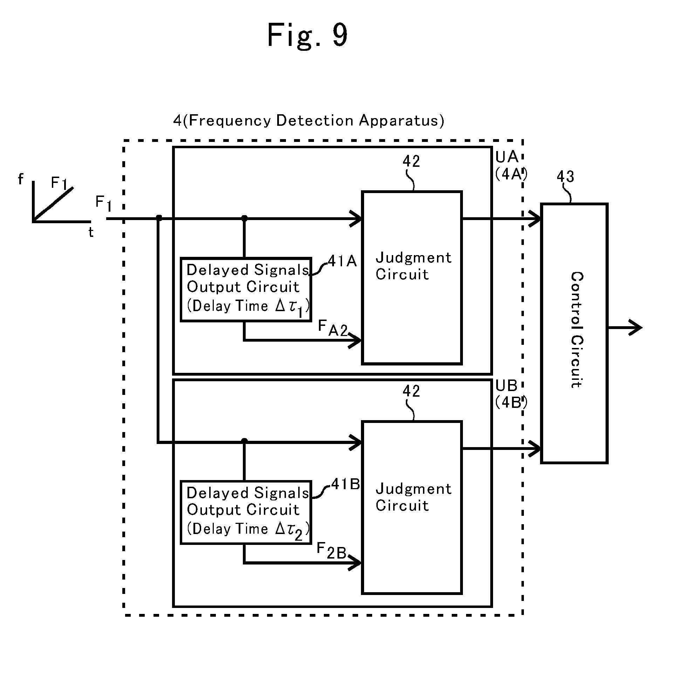

FIG.9 is a figure of configuration which shows the frequency detection apparatus that 1 unit did a frequency detection apparatus of FIG. 1 (A), and it was made a common use of, and a plurality of (two) first periodic signals were connected to.
[FIG. 10]

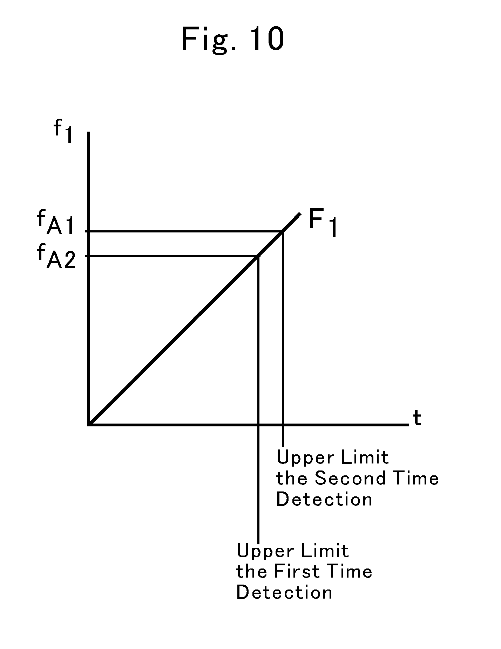

FIG.10 is a figure which shows the detection frequency in the frequency detection apparatus of FIG. 9 and relations with the time.
[FIG. 11]

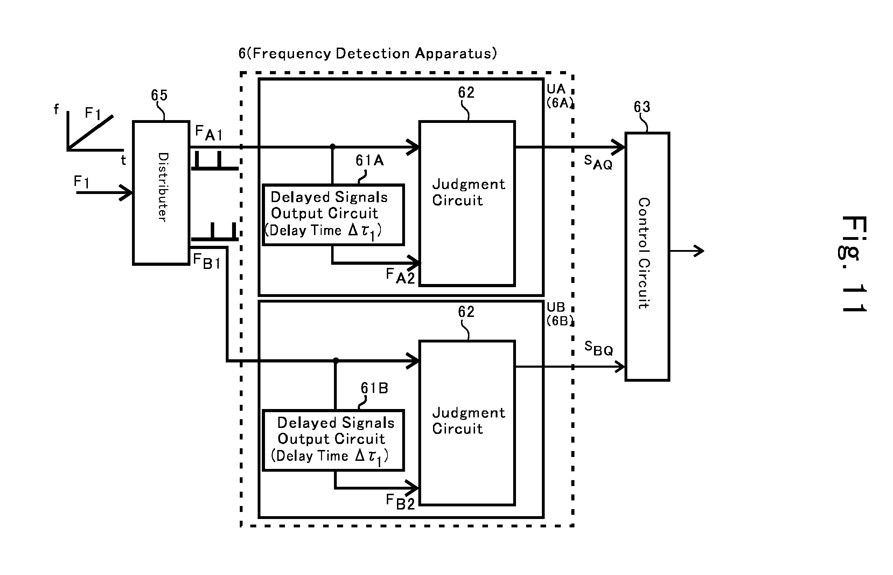

FIG.11 is a figure of configuration which shows the frequency detection apparatus that 1 unit did a frequency detection apparatus of FIG. 1 (A), and raised a plurality of (two) resolution.

[FIG. 12]

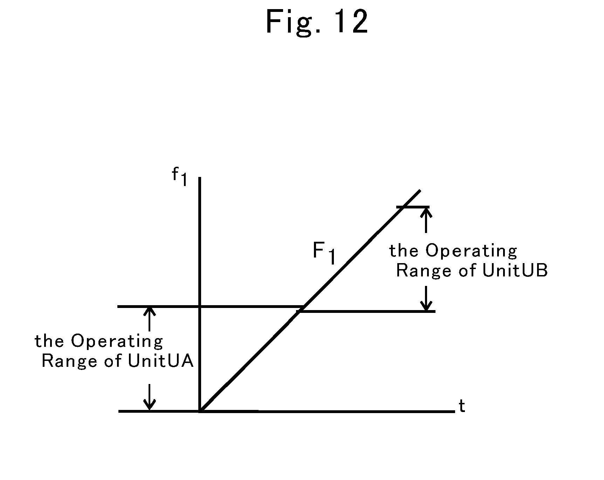

FIG. 12 is an actuating illustration of the frequency detection apparatus of FIG. 11.

[FIG. 13]

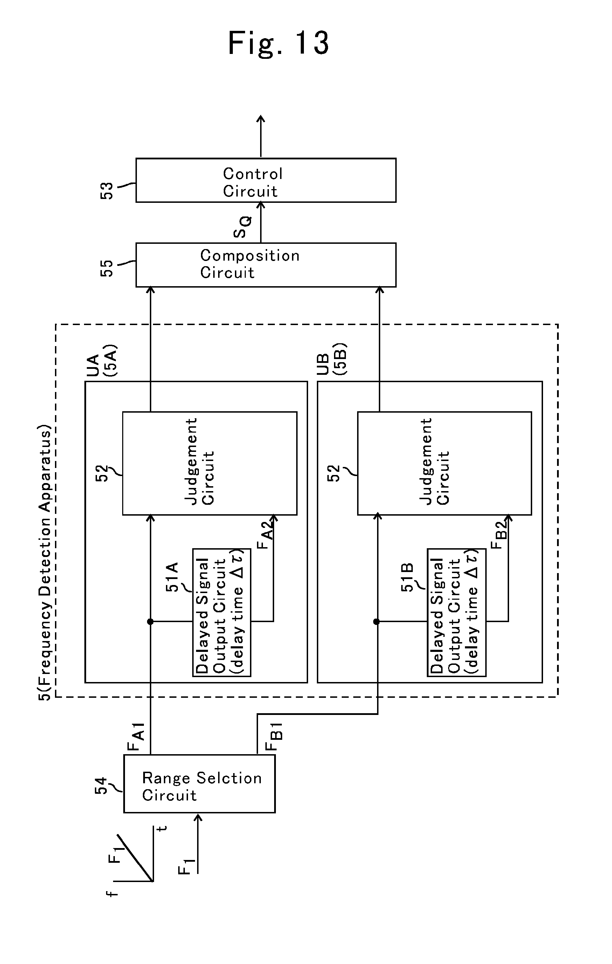

FIG. 13 is a figure of configuration which shows the frequency detection apparatus that 1 unit did a frequency detection apparatus of FIG. 1 (A), and it was wide, and did a plurality of (two) actuating ranges.

[FIG. 14]

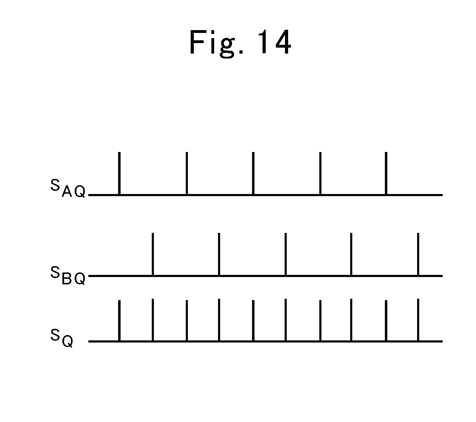

FIG. 14 is an actuating illustration of the frequency detection apparatus of FIG. 12.

[FIG. 15]

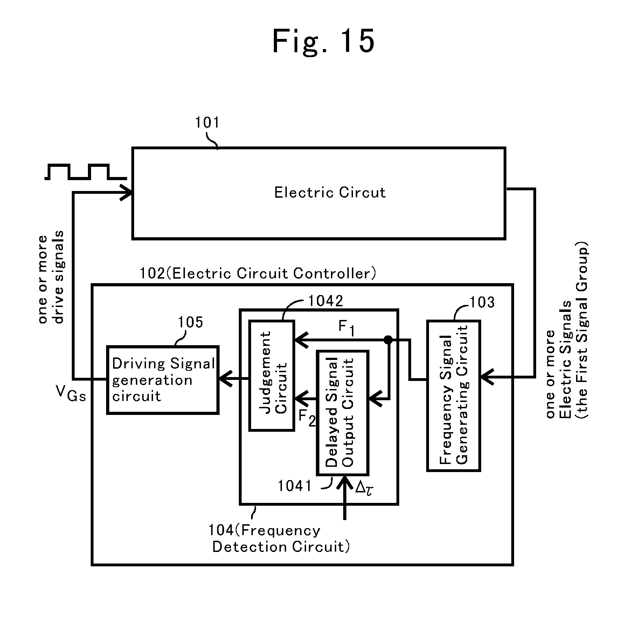

FIG.15 is a figure which shows the controller which it is the figure showing the basic structure of "invention B", and does not have a delay control circuit.

[FIG. 16]

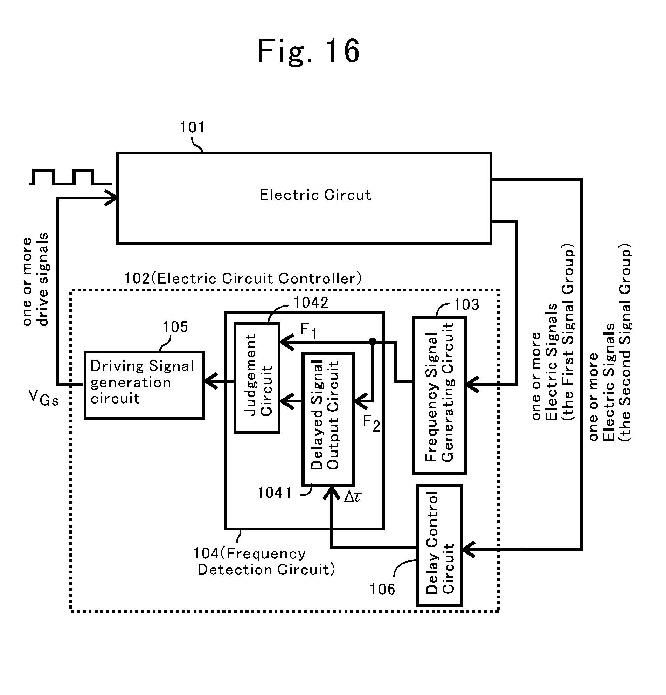

FIG.16 is a figure which shows the controller which it is the figure showing the basic structure of "invention B", and has a delay control circuit.

[FIG. 17]

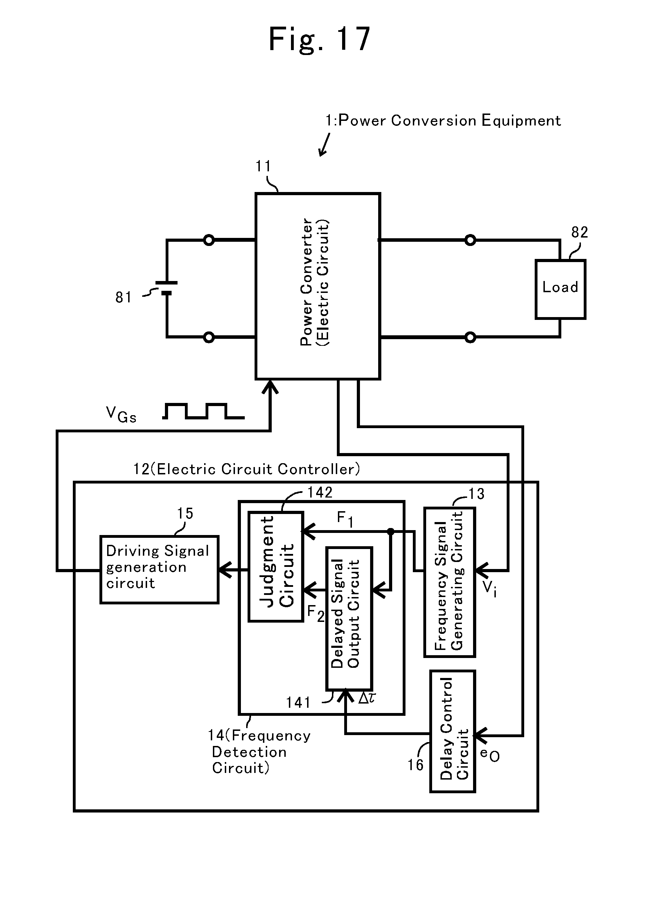

FIG.17 is an illustration which shows the first embodiment of the control method of power conversion equipment of "invention B" and the power conversion equipment.

[FIG. 18]

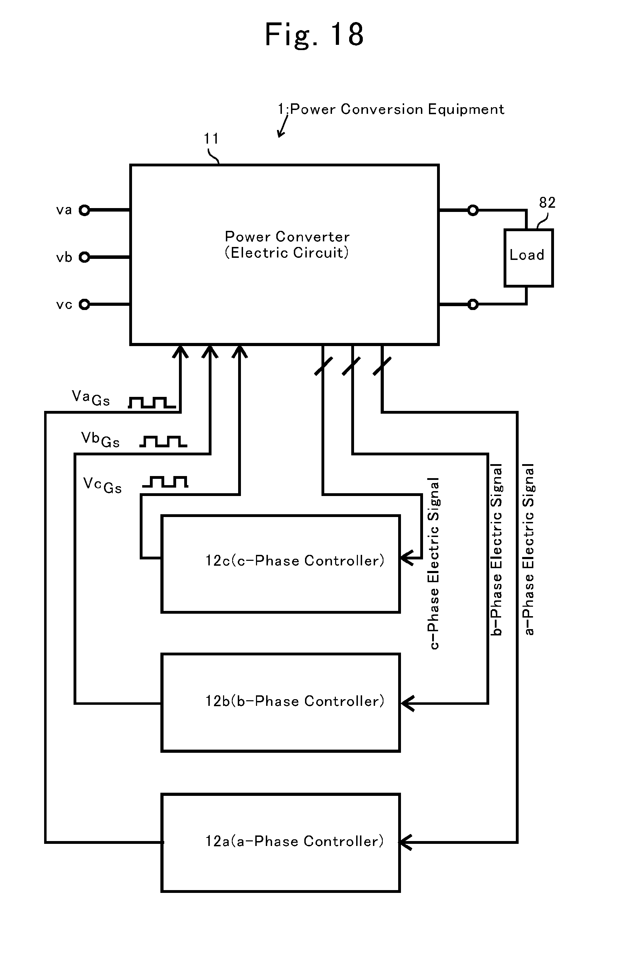

FIG. 18 is an illustration shown in the elaboration by a control method of triphasic power conversion equipment and the power conversion equipment more.

[FIG. 19]

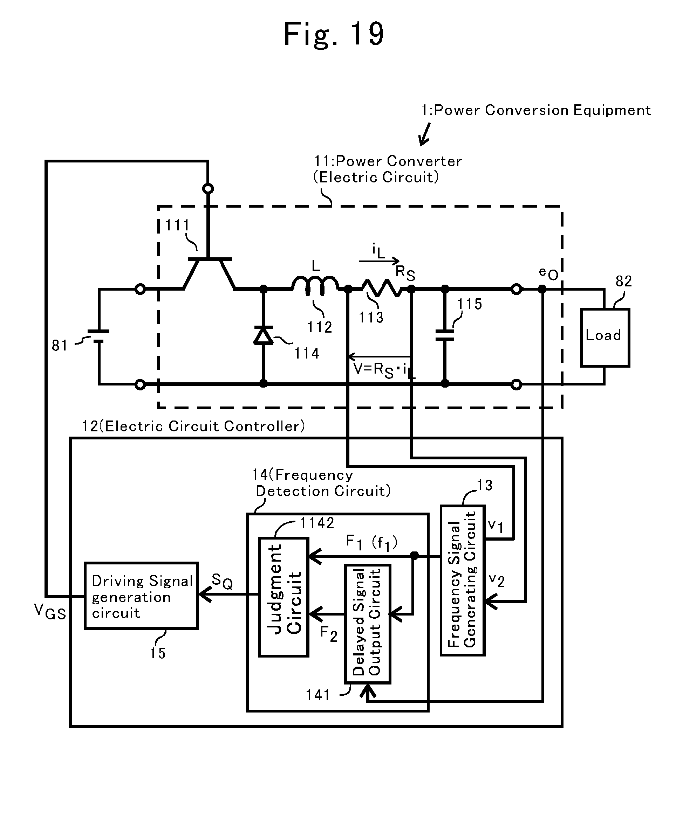

FIG.19 is a figure which shows an embodiment of the electric power strange container equipment of the current control type.

[FIG. 20]

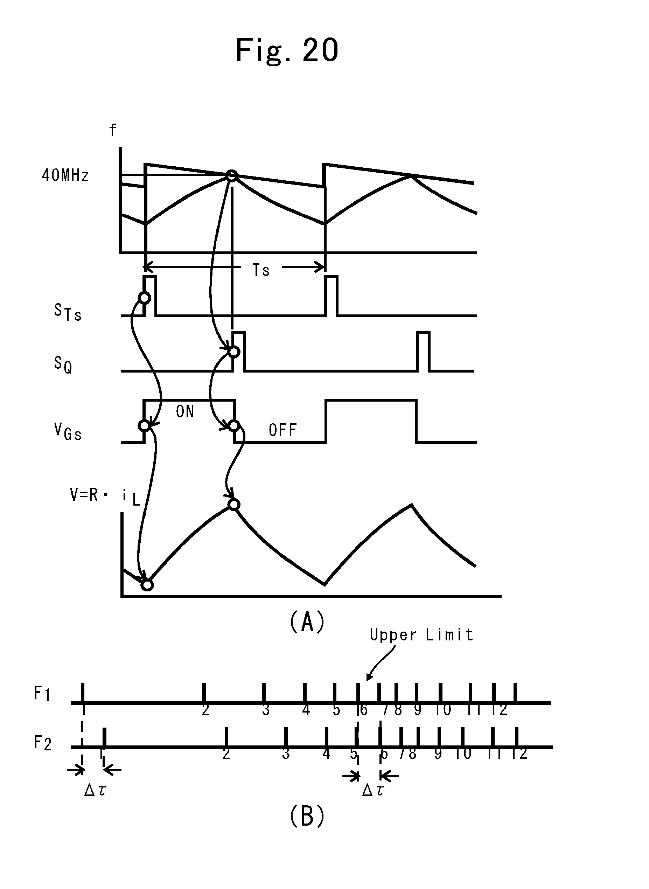

As for FIG. 20, in (A), figure showing the time change state in all parts of the power conversion equipment, (B) are figures showing the change state at the first periodic signal F1, time of second periodic signal F2.

[FIG. 21]

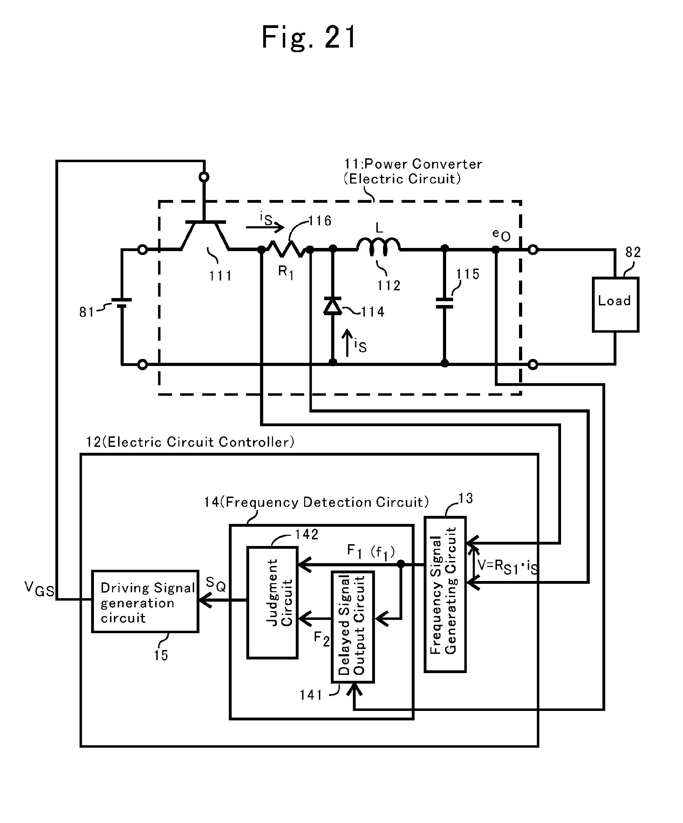

FIG.21 is a figure which shows the example that a period signal generator assumed current flowing current flowing to an electric switch.

[FIG.22]

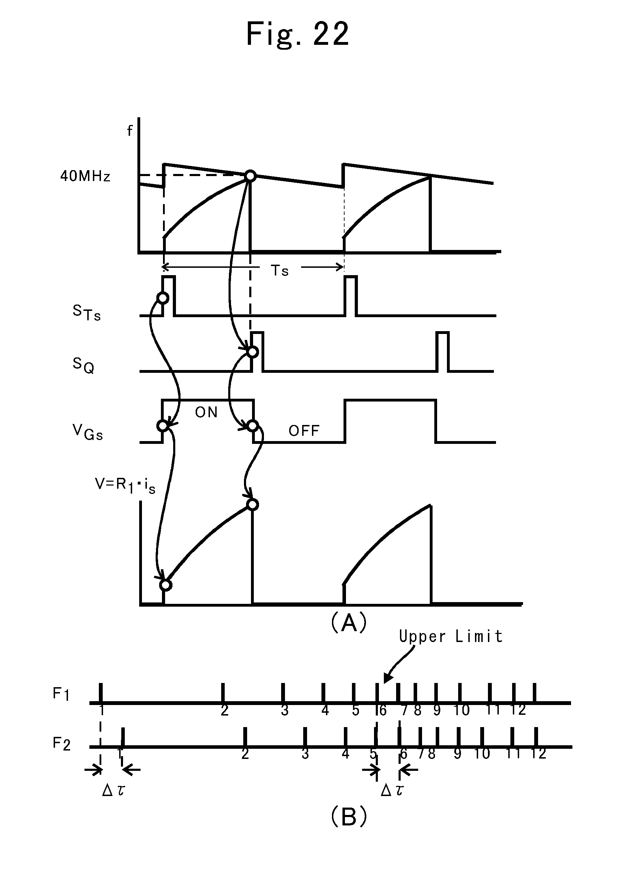

As for FIG. 22, in (A), figure showing the time change state in all parts of the power conversion equipment, (B) are figures showing the change state at the first periodic signal F1, time of second periodic signal F2.

[FIG. 23]

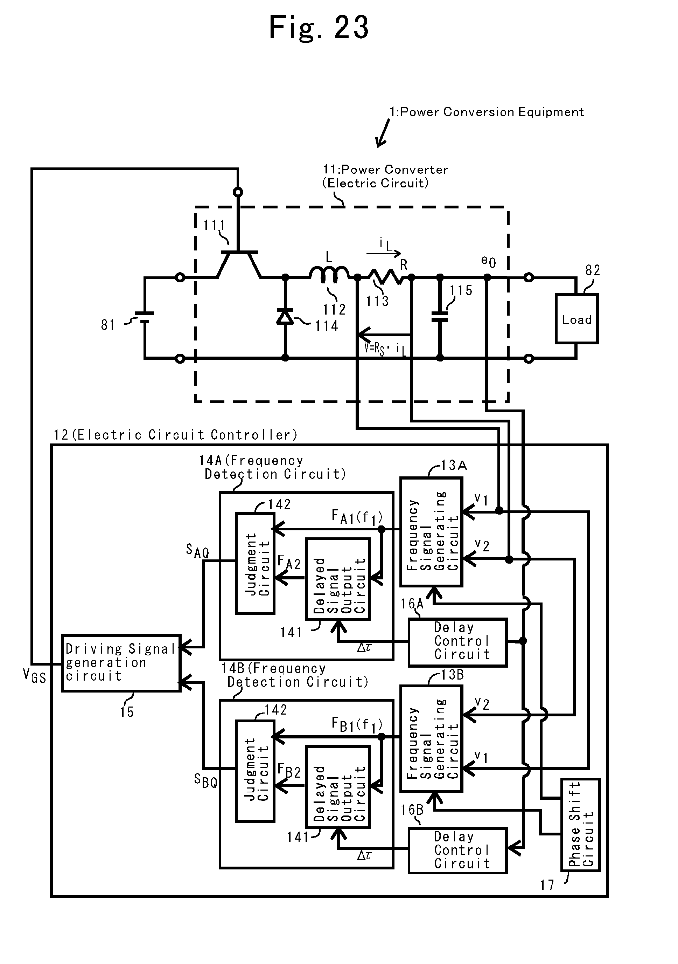

FIG.23 is a figure of which shows power conversion equipment raising appearance resolution (judgment accuracy) that these two units are connected in parallel as 1 unit, and comprised a frequency detecting circuit.

[FIG. 24]

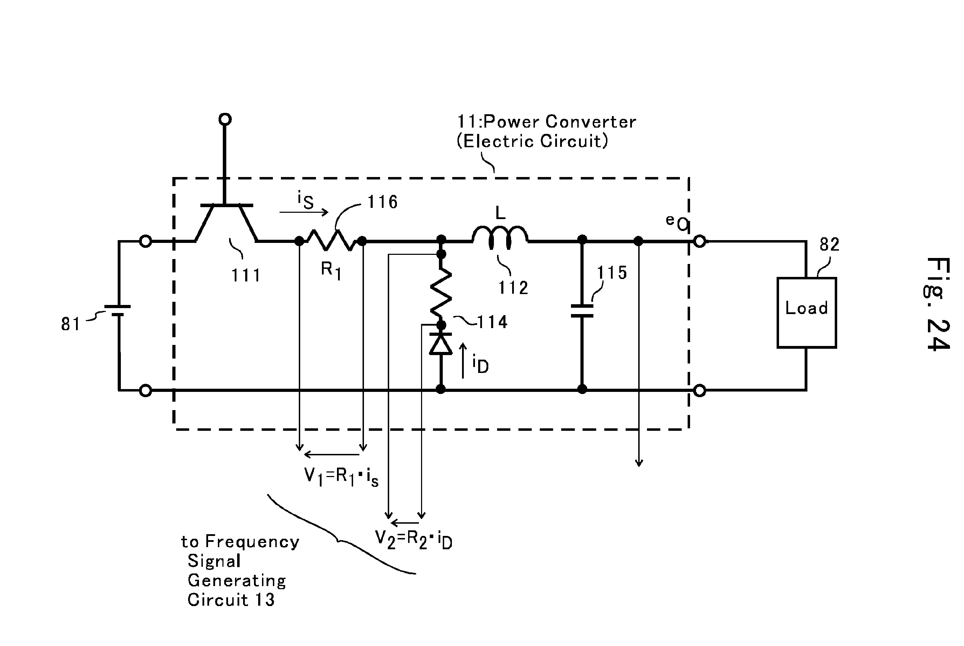

FIG.24 is a figure of which shows the state that the phase difference of the first periodic signal and the second periodic signal was n, and detection resolution (judgment accuracy) increased twice as much in power conversion equipment of FIG. 19.

[FIG. 25]

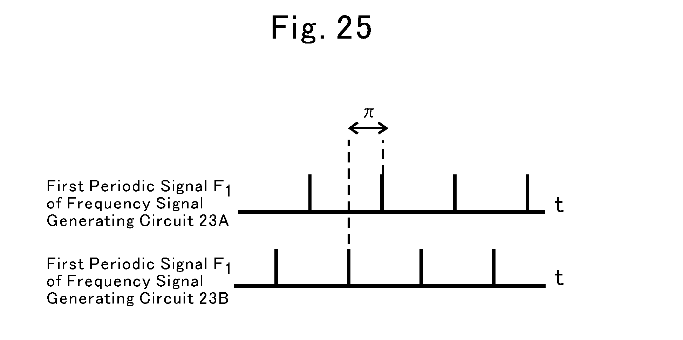

FIG.25 is a figure which shows the example that a period signal generator takes current flowing in an electric switch as a circuit current.

[FIG. 26]

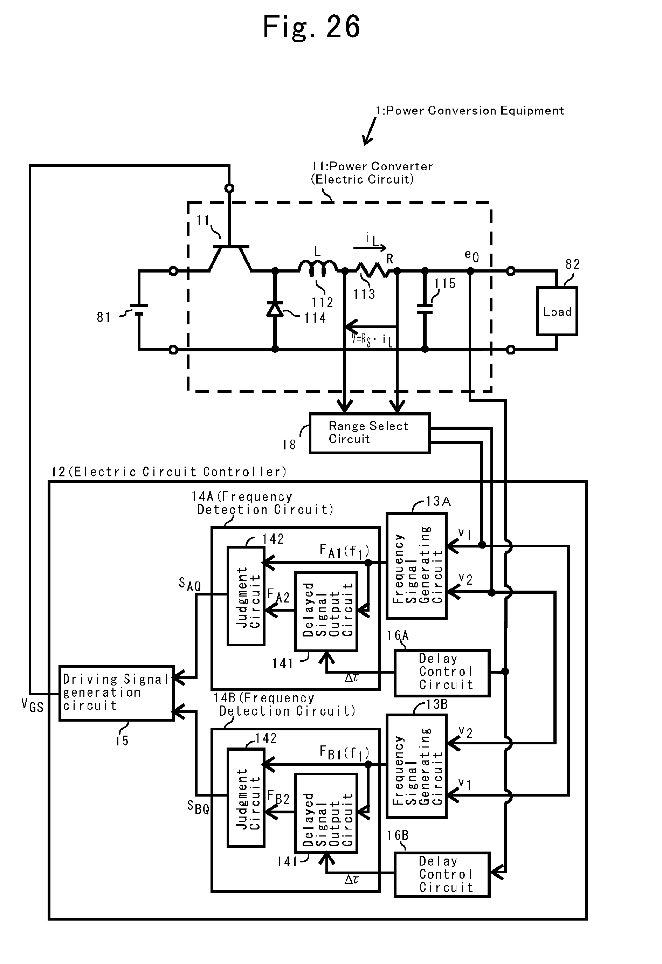

FIG.26 is a figure of which shows power converters divided frequency processing in two depending on dimension of voltage input into a range selective circuit by the first unit or a second unit.

[FIG. 27]

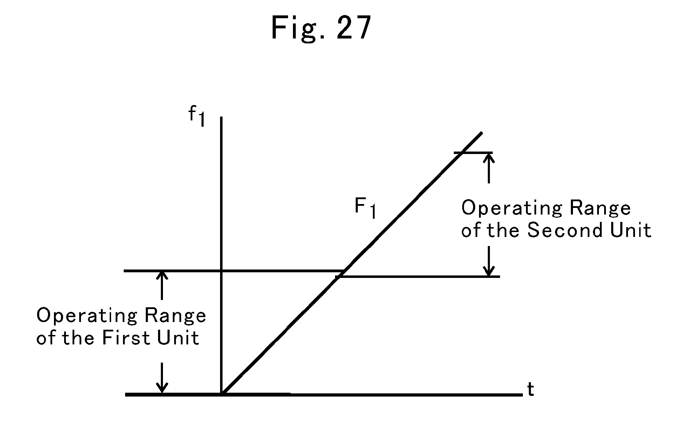

FIG.27 is a figure of which shows a state divided frequency processing in two depending on dimension of voltage input into a range selective circuit in power conversion equipment of FIG. 25 by the first unit or a second unit.

[FIG. 28]

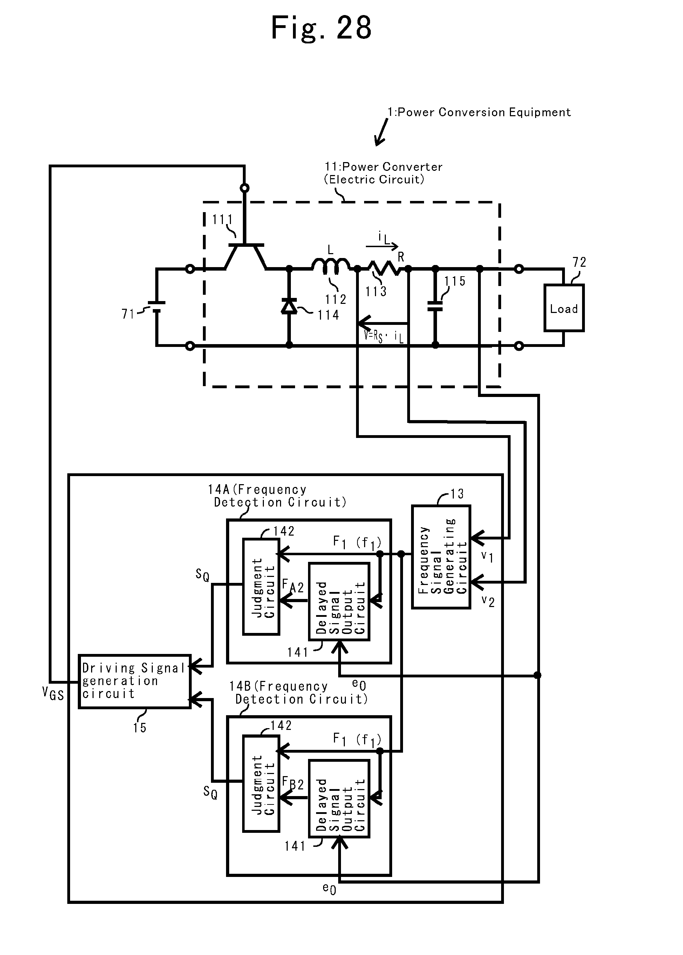

FIG.28 is a figure which shows power conversion equipment operating a circuit current between an upper bound and an upper bound.

[FIG. 29]

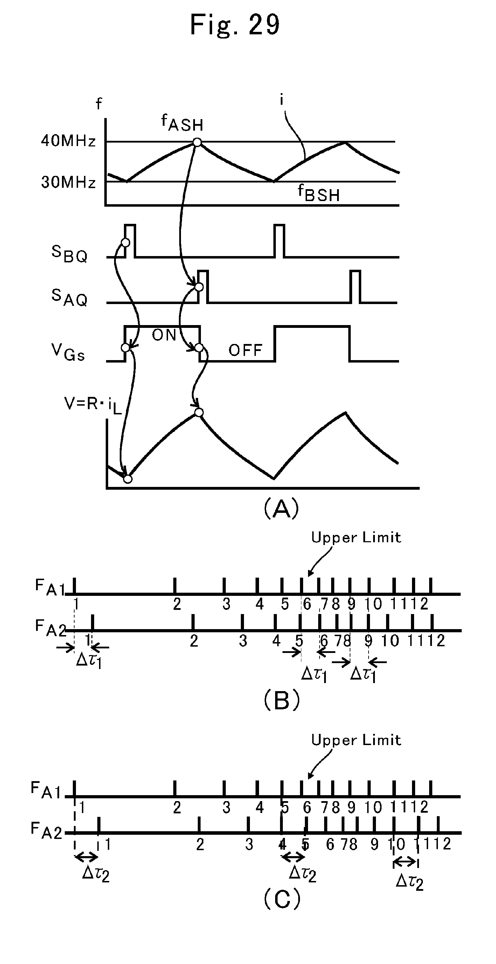

FIG. 29 is a figure as shown in the pulse string with a state the first periodic signal and a second periodic signal are proportional to figure as shown in the pulse string, (C) with a state the first periodic signal and a second periodic signal are proportional to figure showing the signal state of all parts of the power conversion equipment, (B) in (A) at time, and to fluctuate at time, and to fluctuate.

[FIG. 30]

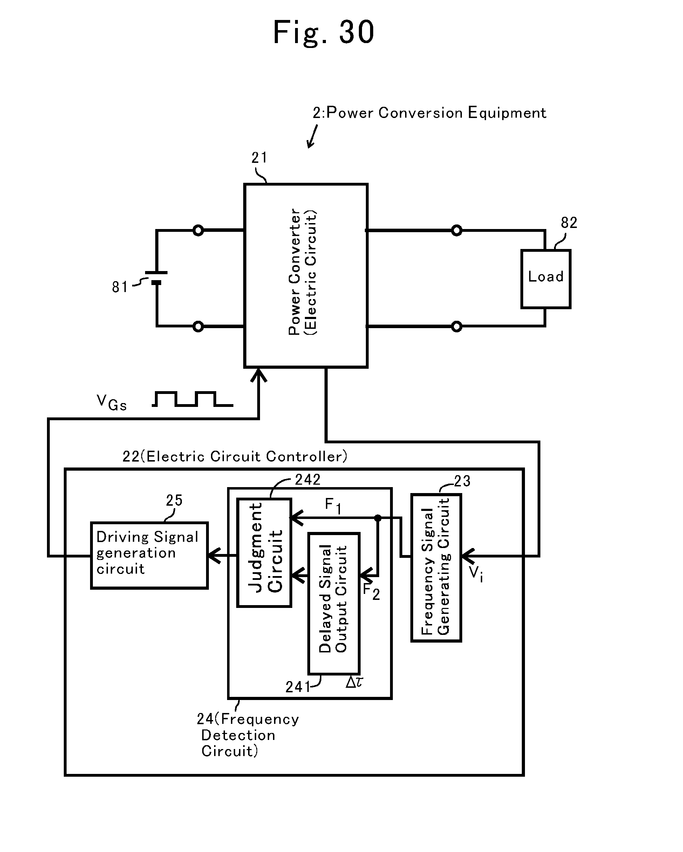

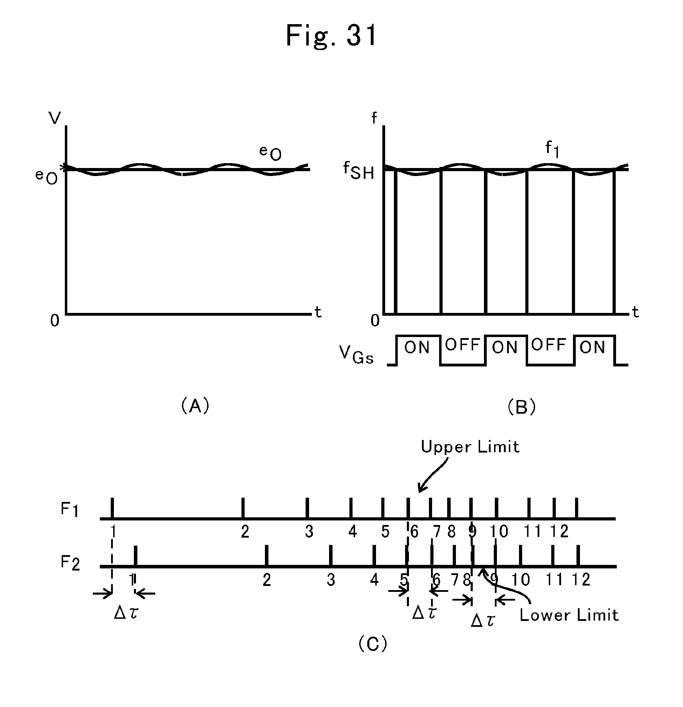

FIG.30 is an illustration which shows the second embodiment of the power conversion equipment of "invention B".
[FIG. 31]
It is an actuating illustration of the power conversion equipment of FIG. 30, and, as for FIG. 31, in (A), figure showing the change at time of the output voltage of power converters, (B) are figures as shown in the pulse string with a state the first periodic signal is proportional to figure showing the output frequency of the periodic signal generation circuitry, (C) at time, and to fluctuate.
[FIG. 32]

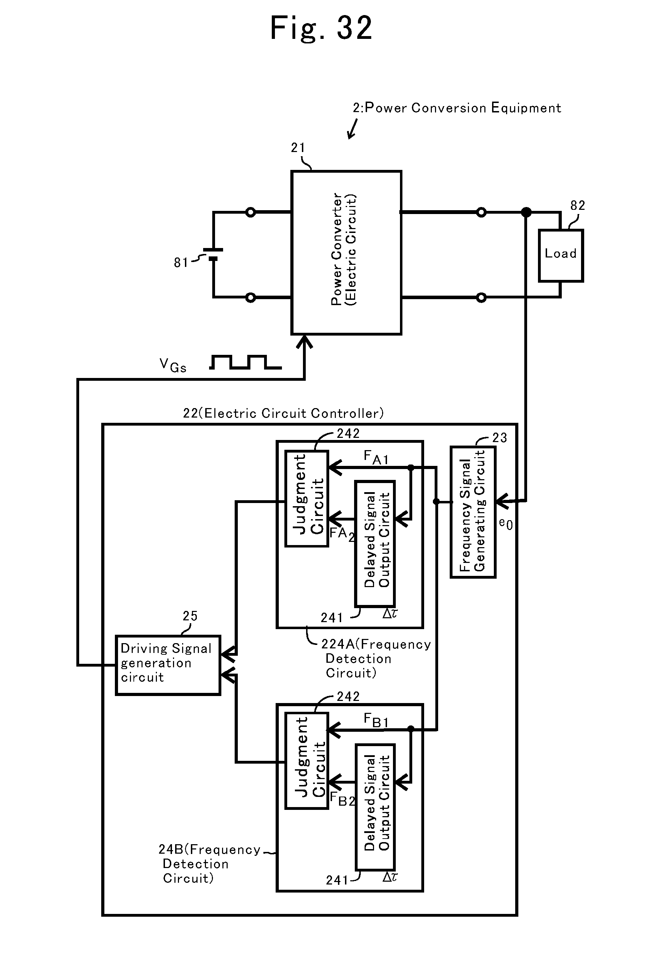

FIG. 32 comprises 2 units with a frequency detecting circuit in power conversion equipment of FIG. 30, and it is an illustration when it has an upper bound and the threshold of the lower limit.
[FIG. 33]

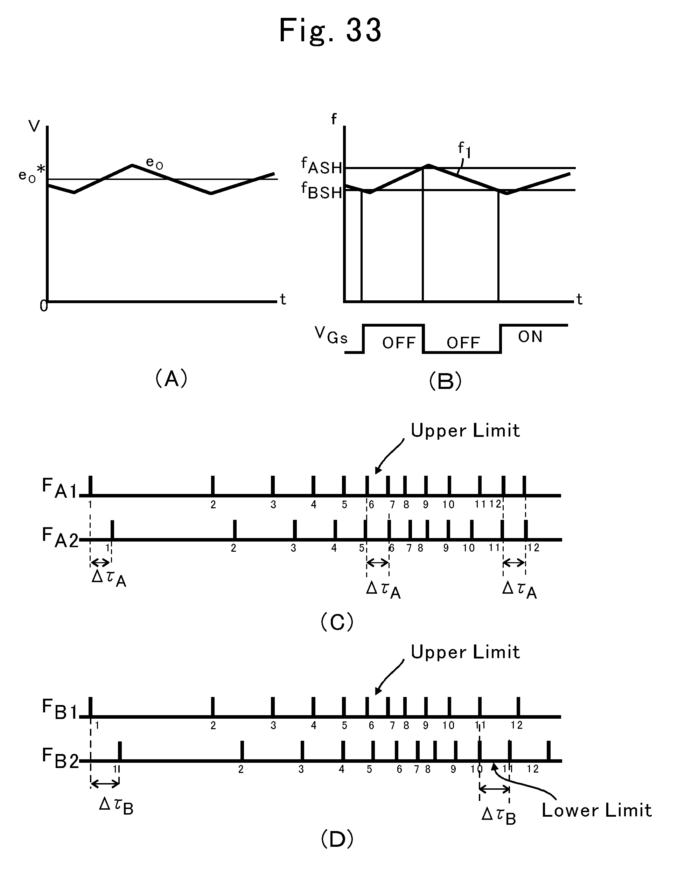

FIG. 33 is a figure as shown in the pulse string with a state the first periodic signal and a second periodic signal are proportional to figure as shown in the pulse string, (D) in the other unit with a state the first periodic signal and a second periodic signal are proportional to figure showing the processing by the judgment circuitry, (C) in one unit in figure showing the change, (B) in (A) at time at time of the output voltage of the power conversion equipment, and to fluctuate at time, and to fluctuate.
[FIG. 34]
FIG. 34 is an illustration of the conventional power conversion equipment.
[FIG. 35]

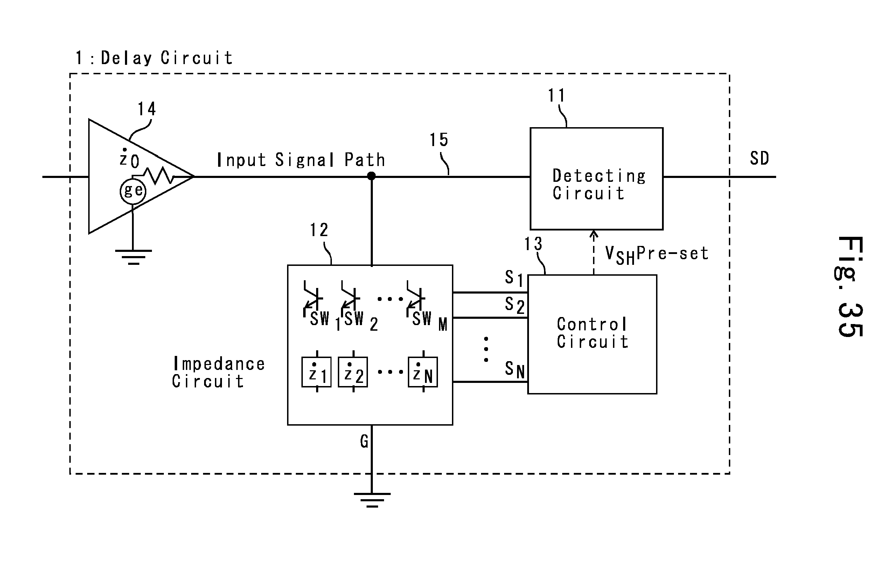

FIG.35 is an illustration which shows the embodiment of a delay circuit of "invention C" and the delay circuit system.
[FIG. 36]

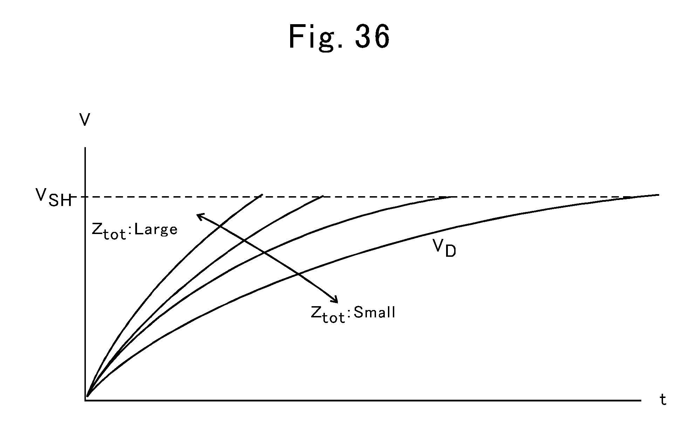

FIG.36 is a graph which shows a time change of voltage occurring in the detecting circuit.
[FIG. 37]

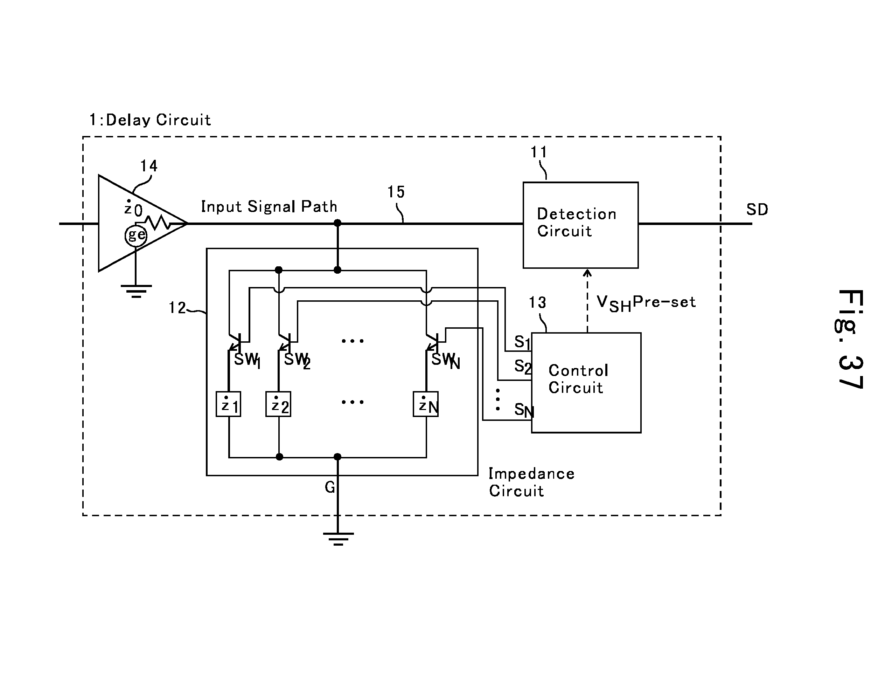

FIG.37 is an illustration which shows the other embodiments of a delay circuit of "invention C" and the delay circuit system.
[FIG. 38]

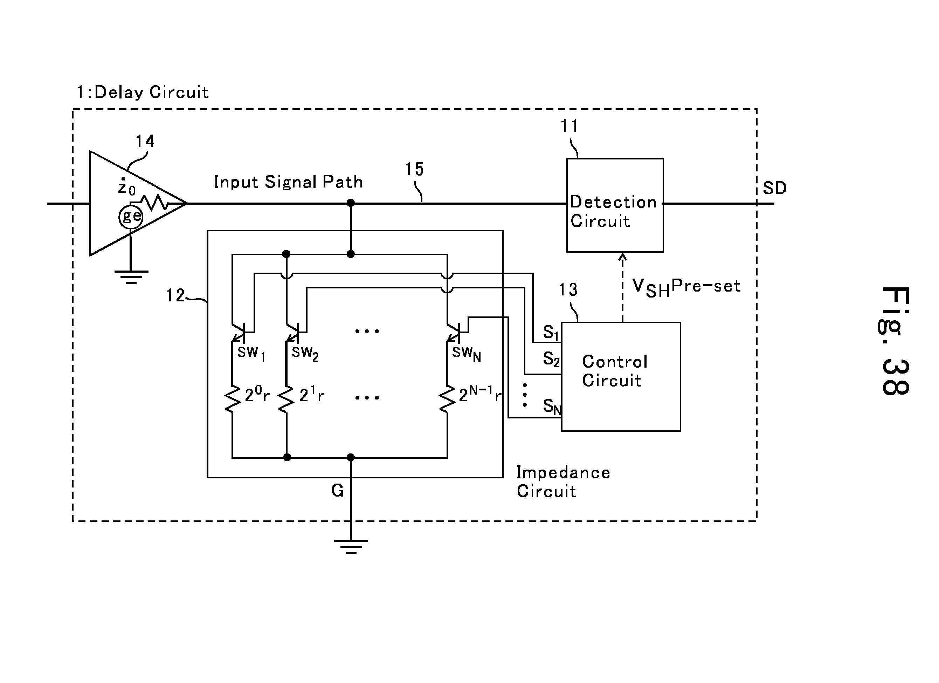

FIG.38 is an embodiment which shows the delay circuit system using delay circuit to do disintegration spacing of the delay time equally and this.
[FIG. 39]

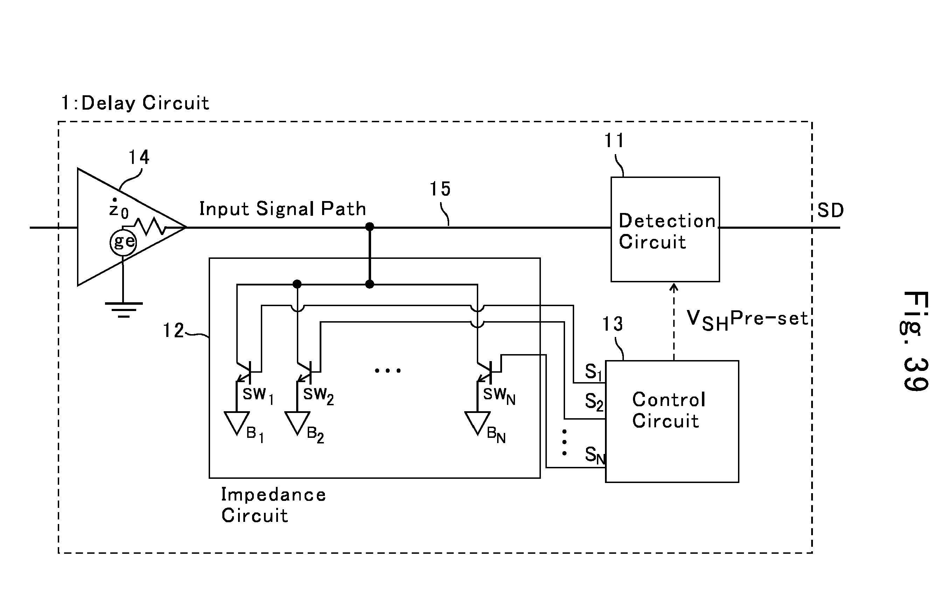

FIG. 39 is an illustration of the delay circuit system using delay circuit which replaced impedance circuit element of FIG. 37 with a buffer and this.
[FIG. 40]

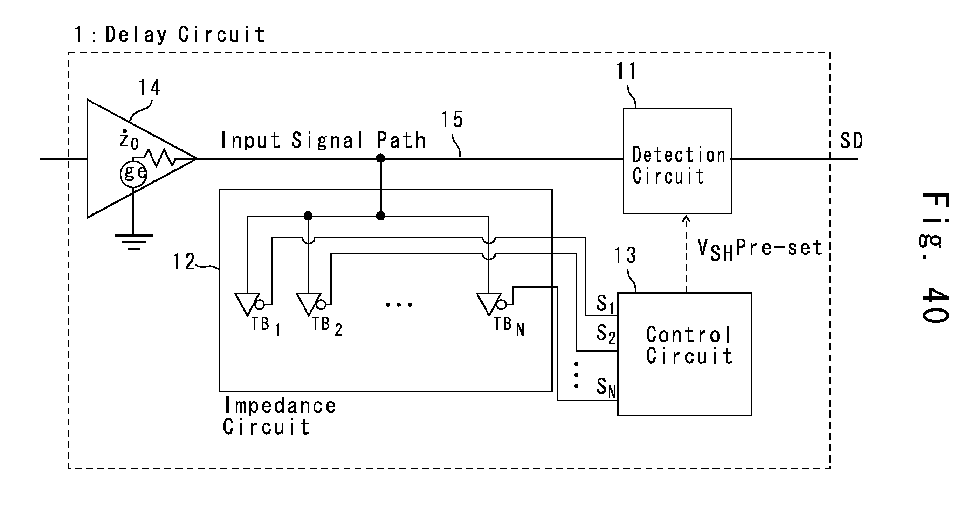

FIG. 40 is an illustration of the delay circuit system using delay circuit that impedance circuit element is the third state buffer and this.
[FIG. 41]

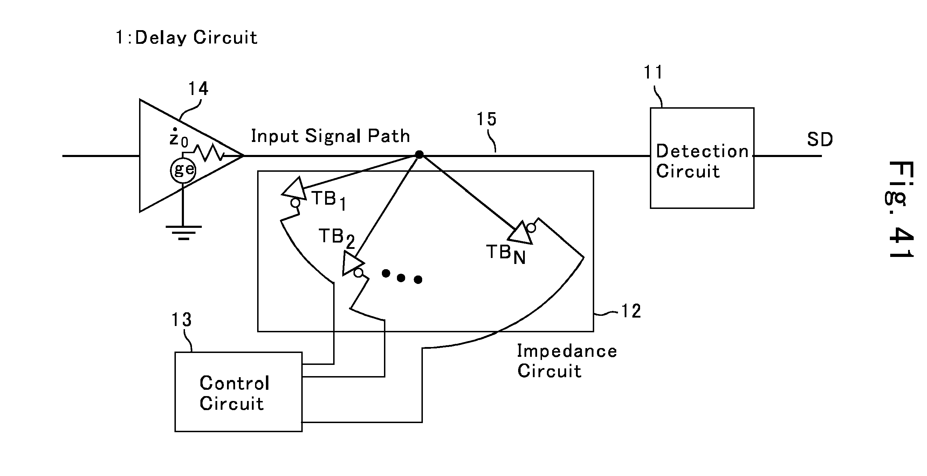

FIG.41 is an illustration which shows the electric wiring form of a delay circuit shown in FIG. 38.
[FIG. 42]

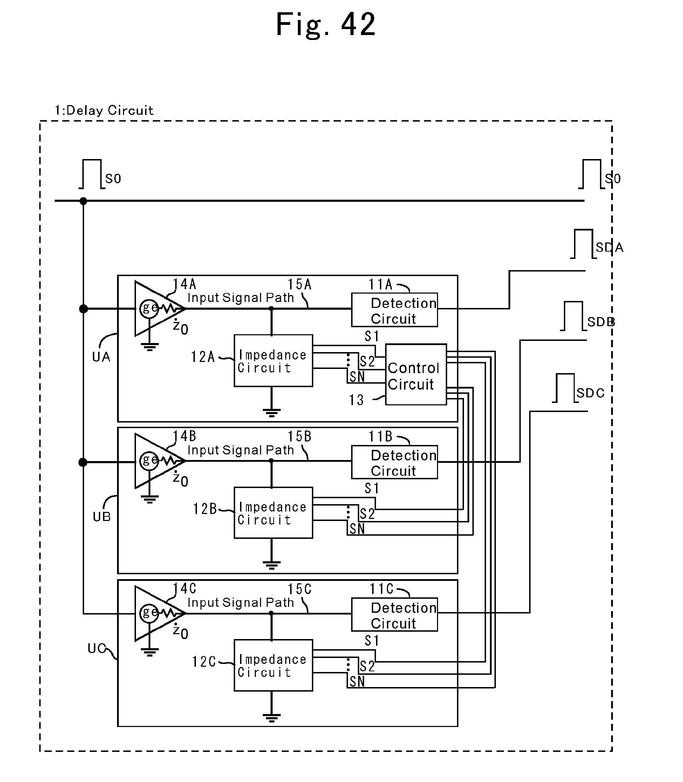

FIG.42 is a figure of which shows the example which it is an illustration showing the application of the delay circuit, and increases input clocks to 4 times by three delay circuit units.
[FIG. 43]

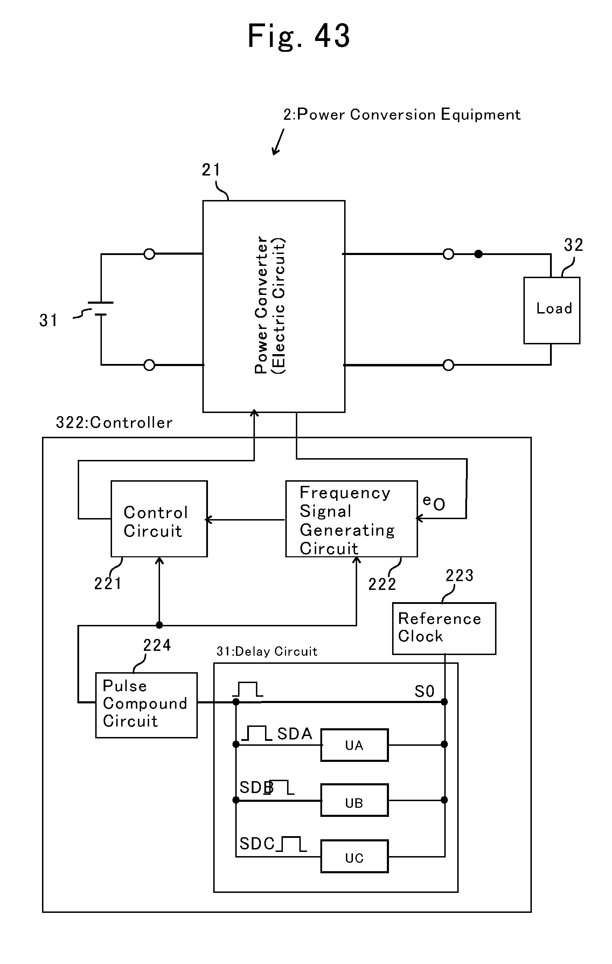

FIG.43 is an illustration which shows the embodiment that applied a delay circuit of "invention C" and a delay circuit system to power conversion equipment.
[FIG. 44]

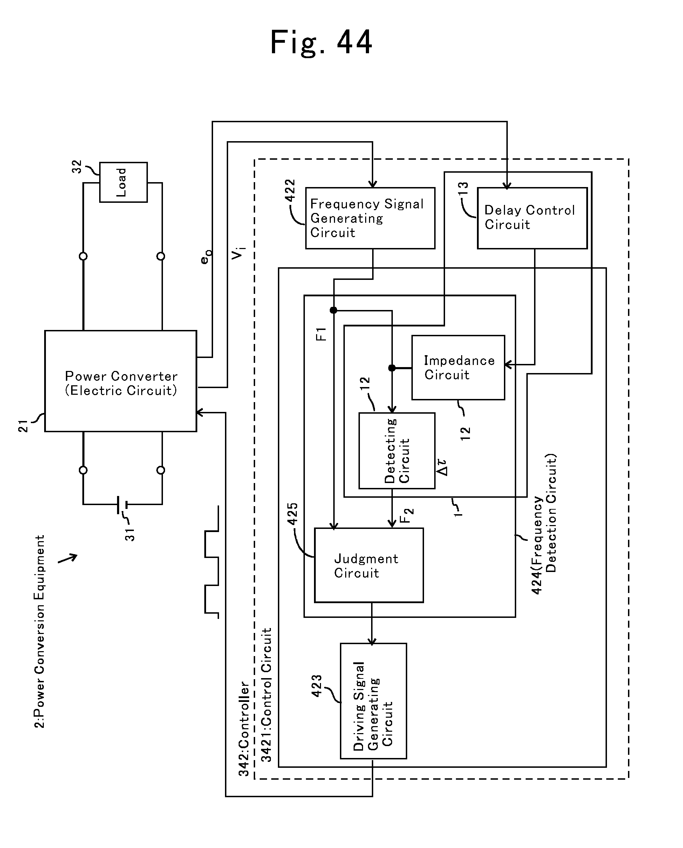

FIG.44 is an illustration which shows the other embodiments that applied a delay circuit of "invention C" and a delay circuit system to power conversion equipment.
[FIG. 45]
FIG. 45 is an illustration of the conventional delay circuit.

Explanations of the letters of numerals

It is one or two, three or four, five or six frequency detection apparatuses (invention A)
11, 21, 31, 41A, 41B, 51A, 51B, 61A, 61B delayed signals output circuit
12, 22, 32, 42, 52, 62 judgment circuitry
121,321 counters
43, 53, 63 control circuits
54 distributing circuits
65 range selective circuits
UA, UB frequency detection apparatus unit

(invention B):

One or two power conversion equipment
11, 21 power converters
12, 22 control circuits
13, 13A, 13B, 23 periodic signal generation circuitry
14, 24 frequency detecting circuits
15, 25 driving signal generation circuitry
16, 16A, 16B delay control circuit
17 phase shift circuitry
17 range selective circuits
111 electric switches
112 electric reactors
113 current detecting resistance
114 commutation diodes
115 capacitors
141,241 delayed signals generation circuitry
142,241 judgment circuitry
81 power supplies
82 loads

(invention C):

1 delay circuit
11 detecting circuits
12 impedance circuits
13 control circuits
14 input buffers
15 input signal paths
SWk electric switch
Z (k) impedance
Bk buffer
r resistance
TBk third state buffer

The best mode for carrying out the invention

(invention A):

A frequency detection apparatus of "invention A" and the embodiment of frequency detection methods are described below.
FIG. 1 is an illustration showing the 1st embodiment of "invention A".
In FIG. 1 (A), frequency detection apparatus 1 possesses delayed signals output circuit 11 and judgment circuitry 12.
The delayed signals output circuit 11 inputs the 1st periodic signal F1 that frequency changes at time (frequency increases at time).
The delayed signals output circuit 11 outputs 2nd periodic signal F2 where only $\Delta\tau$ (shorter than initial period of the 1st periodic signal F1) retarded this 1st periodic signal F1 for predetermined time.
The frequency of the 1st periodic signal F1 is proportional at time, and it rises, and, in the 1st embodiment, it shortens according to a harmonic progression as shown in FIG. 1 (C) in period.
Also, the 1st periodic signal F1 is a narrow width pulse string (thus, 2nd periodic signal F2 is a narrow width pulse string, too).
It is referred 1,2,3,... number to the sequence of the narrow width pulse of 1st periodic signal F1 and 2nd periodic signal F2 depending on progress at time to make explanation plain in FIG. 1 (C), respectively.
First periodic signal F1 and 2nd periodic signal F2 are set, as depicted above, so that period shortens according to a harmonic progression.
The interval between the narrow width pulses of the 1st and the 2nd: 1 sec

The interval between the narrow width pulses of the 2nd and the 3rd: 1/2 sec

• • •

The interval between the narrow width pulses of the 3rd and the 4th: 1/3 sec

The judgment circuitry 12 inputs 1st periodic signal F1 and 2nd periodic signal F2.

Judgment circuitry 12 detects whether period of the 1st periodic signal F1 was included in period of 2nd periodic signal F2, and a detection result is output as judgment signal. "Period of the 1st periodic signal F1 is included in period of 2nd periodic signal F2" and "Two consecutive narrow width pulses of the 1st periodic signal F1 are located between two consecutive narrow width pulses of 2nd periodic signal F2" are equivalent.

A former pulse may be piled up in the former narrow width pulse among two narrow width pulses to continue of 2nd periodic signal F2 among two consecutive narrow width pulses of the 1st periodic signal F1.

In this case, period of the 1st periodic signal F1 is included in period of 2nd periodic signal F2. Also, period of the 1st periodic signal F1 may not be included in period of 2nd periodic signal F2.

Also, a later narrow width pulse may be piled up in the later narrow width pulse among two narrow width pulses to continue of 2nd periodic signal F2 among two consecutive narrow width pulses of the 1st periodic signal F1.

In this case, period of the 1st periodic signal F1 may be included in period of 2nd periodic signal F2. Also, it may not be included.

It can be monitored whether a narrow width pulse of the 1st periodic signal F1 and a narrow width pulse of 2nd periodic signal F2 are detected in the 1st embodiment alternately.

And it can be detected whether period of the 1st periodic signal F1 was included in period of 2nd periodic signal F2.

That is, in FIG. 1 (C), judgment circuitry 12 detects a narrow width pulse of the 1st periodic signal F1 and a narrow width pulse of 2nd periodic signal F2 alternately.

In the 1st embodiment, frequency f1 of the 1st periodic signal F1 is proportional as shown in FIG. 1 (B) at time, and it rises.

It thereby shortens in a harmonic progression according to progress at time in period of the 1st periodic signal F1.

In this case, it is determined that there are alternating characteristics about the following by judgment circuitry 12.

"The 1st narrow width pulse of the 1st periodic signal F1 ",

"The 1st narrow width pulse of 2nd periodic signal F2 ",

"The 2nd narrow width pulse of the 1st periodic signal F2 ",

"The 2nd narrow width pulse of 2nd periodic signal F2 ",

"The 3nd narrow width pulse of the 1st periodic signal F1",

"The 3nd narrow width pulse of 2nd periodic signal F2",

"The 4th narrow width pulse of the 1st periodic signal F1",

"The 4th narrow width pulse of 2nd periodic signal F2",

"The 5th narrow width pulse of the 1st periodic signal F1",

"The 5th narrow width pulse of 2nd periodic signal F2",

"The 6th narrow width pulse of the 1st periodic signal F1",

But, after the 6th narrow width pulse "of the" 1st periodic signal F1, the 7th narrow width pulse "of the" 1st periodic signal F1 is detected.

Thus, judgment circuitry 12 judges alternating characteristics that there is not at this time ("upper bound detection" of FIG. 1 (B), "upper bound" reference of (C)).

That is, when, in a time of day when alternating characteristics with narrow width pulse "of narrow width pulse" and "2nd periodic signal F2 of the" 1st periodic signal F1 disappeared, the 7th narrow width pulse "of the" 1st periodic signal F1 was input into judgment circuitry 12 in FIG. 1 (C).

Because it was it, judgment circuitry 12 may detect (a time of day when a narrow width pulse of the 6th or the 7th was input) in a time of day when (the period that is longer than $\Delta\tau$) shortened than $\Delta\tau$ in period with the 1st periodic signal F1.

In other words, in FIG. 1 (C), as for the 6th narrow width pulse "of" 2nd periodic signal F2, only $\Delta\tau$ is late for the time that there is to the 6th narrow width pulse "of the" 1st periodic signal F1.

Narrow width pulse "of the 6th narrow width pulse" and "the 7th of the" 1st periodic signal F1 will be thereby included between narrow width pulse "of the 5th narrow width pulse" and "the 6th of" 2nd periodic signal F2.

Thus, judgment circuitry 12 may detect (a time of day when a narrow width pulse of the 6th or the 7th was input) in a time of day when "shortened than $\Delta\tau$ in period of the" 1st periodic signal F1.

Note that the spacing of narrow width pulse "of the 5th narrow width pulse" and "the 6th of" 2nd periodic signal F2 has a long than $\Delta\tau$ and the spacing of the 6th narrow width pulse "of the 6th narrow width pulse" and "2nd periodic signal F2 of the" 1st periodic signal F1 is $\Delta\tau$.

There is the 7th narrow width pulse "of the" 1st periodic signal F1 to the left by all means than the 6th narrow width pulse "of" 2nd periodic signal F2.

From this, it is clear that judgment circuitry 12 can detect a time of day when period of the 1st periodic signal F1 shortened than $\Delta\tau$.

As mentioned earlier, in the 1st embodiment, frequency of "1st periodic signal F1" rises according to a harmonic progression.

The frequency of "2nd periodic signal F2" becomes similarly higher, too.

The case that frequency of "1st periodic signal F1" rose to as follows was described to make plain in the 1st embodiment (FIG. 1 (B), cf. (C)).

"1Hz, 1/2Hz, 1/3Hz, ..."

However, the frequency of the 1st periodic signal F1 may really rise as follows.

"25*106Hz (25*106+1) Hz (25*106+2) Hz, ..."

Also, for example, the frequency of the 1st periodic signal F1 may rise as follows. "25*106Hz (25*106+10) Hz (25*106+20) Hz, ..." [0099]

As described earlier, in the 1st embodiment, only $\Delta \tau$ can delay 2nd periodic signal F2 to the 1st periodic signal F1. That a narrow width pulse interval of the 1st periodic signal F1 became shorter than $\Delta \tau$ (in in a time of day when the period that was longer than $\Delta \tau$ shortened that $\Delta \tau$ namely a time of day when a narrow width pulse of the 6th or the 7th was input) can be thereby detected.

Note that the 1st periodic signal F1 can generate the periodic signal of the arbitrary waveform by passing a waveform shaping circuit.

In the example above, a time of day when period of the 1st periodic signal F1 was included in period of 2nd periodic signal F2 can be detected.

That is, judgment circuitry 12 can detect "as" in a time of day when frequency of 1 "periodic signal F1 rose to the predetermined value in a time of day when period of the" 1st periodic signal F1 shortened than $\Delta \tau$.

In the example above, the detection (a judgment) by judgment circuitry 12 showed the case that was once. However, detection by judgment circuitry 12 can do a judgment (the judgment of the time of day when it was shorter period) like the above by multiple times or the 2nd, the 3nd, ..., detection of the I joint in "invention A".

That is, judgment circuitry 12 can detect what included period of the 1st periodic signal F1 in period of 2nd periodic signal F2.

And that frequency of the 1st periodic signal F1 reached the predetermined value can be judged what joint the detection is.

In this case, as shown in FIG. 2 (A), judgment circuitry 12 includes counter 121, and counter 121 can store number of times of the detection.

And judgment circuitry 12 judges that frequency of the 1st periodic signal F1 reached the predetermined value by detection of the 2nd, and that frequency of the 1st periodic signal F1 further reached the place set price of a thing of others by the 3nd detection is judged,

• • •

Frequency of the 1st periodic signal F1 further changes in a predetermined level of the high pass side by the detection of the 1st joint or a place set price of the rise direction side can further judge that it was reached.

In FIG. 2 (C), two times of judgments by judgment circuitry 12 show a case to be carried out.

That is, it is shown (upper bound the 2nd) when the period of "the 6th narrow width pulse of the 1st periodic signal F1" shortens than $\Delta \tau$ (upper bound the 1st) and when the period of "the eleventh narrow width pulse of the 1st periodic signal F1" shortens more from $\Delta\tau/2$.

In FIG. 2 (B), (C), the frequency which detection of upper bound the 1st was made is shown with f1, 1, and it is shown the frequency that detection of upper bound the 2nd was done with f1, 2.

In FIG. 2 (B), it is shown a time of day of this time in the 1st "upper bound detection" and the 2nd "upper bound detection".

Note that only detection of the 1st is performed unless shortest period "of the" 1st periodic signal F1 becomes lower than half of longest period "of the" 1st periodic signal F1 (unless maximum frequency "of the" 1st periodic signal F1 is as above 2 times of smallest frequency "of the" 1st periodic signal F1).

When a change of the frequency is small, the detection after the 2nd by judgment circuitry 12 does not have to consider. For example, the detection after the 2nd joint is not done when frequency of the 1st periodic signal F1 changes in the range of 40MHz from 25MHz.

FIG. 3 is an illustration showing the 2nd embodiment of "invention A".

In FIG. 3 (A), frequency detection apparatus 2 possesses delayed signals output circuit 21 and judgment circuitry 22.

Delayed signals output circuit 21 inputs the 1st periodic signal F1 that frequency changes at time (it goes low).

And this 1st periodic signal F1 predetermined time $\Delta\tau(\Delta\tau:)$

Second periodic signal F2 which only) retarded in the time that is longer than initial period for 1st periodic signal F1 is output.

In the 2nd embodiment, as for judgment circuitry 22, $\Delta \tau$ has following relation in during starting (at the time of detection processing initiation) of frequency detection apparatus 2 as indicated in FIG. 3 (C) in delay time.

$$T1 \leqq \Delta \tau < T1 + T2$$

Also, it is set the frequency of the 1st periodic signal F1 is proportional from frequency 13Hz at time, and to go low, and period gets longer according to a harmonic progression. Also, it is set the frequency of the 1st periodic signal F1 is proportional from frequency 13Hz at time, and to go low, and period gets longer according to a harmonic progression. Also, as shown in FIG. 3 (C), the 1st periodic signal F1 is a narrow width pulse string like the 1st embodiment (thus, 2nd periodic signal F2 is a narrow width pulse string, too).

It is referred 1,2,3,... number to a narrow width pulse string of the 1st periodic signal F1 and a narrow width pulse string of 2nd periodic signal F2 depending on progress at time to make explanation plain in FIG. 3 (C), respectively.

First periodic signal F1 and 2nd periodic signal F2 are as follows, as depicted above, because it is set so that period gets longer in a harmonic progression from frequency 13Hz.

the interval between the narrow width pulses of the 1st and the 2nd: 1/13 sec

The interval between the narrow width pulses of the 2nd and the 3rd: 1/12 sec

The interval between the narrow width pulses of the 3rd and the 4th: 1/11 sec

・・・

Judgment circuitry 22 inputs 1st periodic signal F1 and 2nd periodic signal F2. Judgment circuitry 22 detects whether period of 2nd periodic signal F2 was included in period of the 1st periodic signal F1, and judgment signal is output. "Period of 2nd periodic signal F2 is included in period of the 1st periodic signal F1" and "Two consecutive narrow width pulses of 2nd periodic signal F2 are located between two consecutive narrow width pulses of 1st periodic signal F2" are equivalent.

A former narrow width pulse may be piled up in the former narrow width pulse among two narrow width pulses to continue of the 1st periodic signal F1 among two consecutive narrow width pulses of 2nd periodic signal F2.

Also, a later narrow width pulse may be piled up in the later narrow width pulse among two narrow width pulses to continue of the 1st periodic signal F1 among two consecutive narrow width pulses of 2nd periodic signal F2.

These are permitted in a judgment whether or not period of 2nd periodic signal F2 was included in period of the 1st periodic signal F1.

In this embodiment, it is monitored whether a narrow width pulse of the 1st periodic signal F1 and a narrow width pulse of 2nd periodic signal F2 are detected alternately. It is thereby detected whether period of the 1st periodic signal F1 was included in period of 2nd periodic signal F2.

That is, as shown in FIG. 3 (C), judgment circuitry 22 detects a narrow width pulse of the 1st periodic signal F1 and a narrow width pulse of 2nd periodic signal F2 alternately.

In this embodiment, frequency f1 of the 1st periodic signal F1 is proportional at time, and, as shown in FIG. 3 (B), it goes low.

It thereby gets longer in a harmonic progression according to progress at time in period of the 1st periodic signal F1.

"The 1st narrow width pulse of the 1st periodic signal F1",

"the 2nd narrow width pulse of the 1st periodic signal F1",

"the 1st narrow width pulse of 2nd periodic signal F2",

"the 3nd narrow width pulse of the 1st periodic signal F1",

"the 2nd narrow width pulse of 2nd periodic signal F2",

"the 4th narrow width pulse of the 1st periodic signal F1", "the 3nd narrow width pulse of 2nd periodic signal F2", "the 5th narrow width pulse of the 1st periodic signal F1",

"the 4th narrow width pulse of 2nd periodic signal F2",

"the 6th narrow width pulse of the 1st periodic signal F1",

"the 5th narrow width pulse of 2nd periodic signal F2."

However, judgment circuitry 22 determines that there are not alternating characteristics when the 6th narrow width pulse of ," 2nd periodic signal F2 was detected ("lower limit detection" of FIG. 3 (B), "lower limit" reference of (C)).

However, the alternating characteristics with the 1st and the 2nd of the 1st periodic signal F1 are ignored.

That is, when, in a time of day when alternating characteristics with a narrow width pulse of the 1st periodic signal F1 and the narrow width pulse of 2nd periodic signal F2 disappeared, the 6th narrow width pulse of 2nd periodic signal F2 was input into judgment circuitry 22 in FIG. 3 (C).

Judgment circuitry 22 may detect a time of day when (the period when it is shorter than $\Delta \tau$) was for longer than $\Delta \tau$ in period of 2nd periodic signal F2.

This time of day is in a time of day when the narrow width pulse of 5-6 joints of 2nd periodic signal F2 was input or a time of day when the narrow width pulse of 6-7 joints of the 1st periodic signal F1 was input.

In other words, in FIG. 3 (C), as for the 6th narrow width pulse of 2nd periodic signal F2, only $\Delta \tau$ is late for time to the 6th narrow width pulse of the 1st periodic signal F1.

"The 5th narrow width pulse of 2nd periodic signal F2" and "the 6th narrow width pulse" are thereby included between "the 6th narrow width pulse of the 1st periodic signal F1" and the 7th narrow width pulses.

Thus, judgment circuitry 22 can detect a time of day when period of 2nd periodic signal F2 became for longer than $\Delta\tau$.

This time of day "is in "a time of day when period of the 1st periodic signal F1 was for longer than $\Delta \tau$" or a time of day when a narrow width pulse of the 6th to the 7th of the 1st periodic signal F1 was input".

As mentioned earlier, in the 2nd embodiment, frequency of the 1st periodic signal F1 depends on the harmonic progression, and it goes low.

Thus, the frequency of 2nd periodic signal F2 goes low in a harmonic progression, too. Frequency of the 1st periodic signal F1 described a case to go low like "1/13Hz, 1/12Hz, 1/11Hz, ..." to make plain in the 2nd embodiment (FIG. 3 (B), cf. (C)).

As a practical matter, "Hz may become low in the frequency of the 1st periodic signal F1 like Hz, ... 25*106Hz (25*106-2)" (25*106-1).

Also, for example, "Hz may become low in the frequency of the 1st periodic signal F1 like Hz, ... 25*106Hz (25*106-20)" (25*106-10).

As described earlier, in "invention A", only $\Delta \tau$ delays 2nd periodic signal F2 to the 1st periodic signal F1.

That a narrow width pulse interval of the 1st periodic signal F1 was delay time for longer than $\Delta \tau$ can be thereby detected.

In other words, a time of day when a narrow width pulse interval of the 1st periodic signal F1 was for longer than $\Delta \tau$ in delay time can be detected.

Note that the 1st periodic signal F2 comprising narrow width pulses can generate the periodic signal of the arbitrary waveform by passing a waveform shaping circuit.

In the example above, a time of day when period of 2nd periodic signal F2 was included in period of the 1st periodic signal F1 was detected.

That is, by a time of day when it was for longer than $\Delta \tau$ period of the 1st periodic signal F1 which judgment circuitry 22 had a shorter than $\Delta \tau$ in during starting (at the time of detection processing initiation) of frequency detection apparatus 2, predetermined value can judge that it dropped frequency of the 1st periodic signal F1.

That is, in the 2nd embodiment, $\Delta \tau$ has next relation in during starting of frequency detection apparatus 2 as indicated in FIG. 3 (C) in delay time.

$$T1 <= \Delta \tau < T1+T2 \ (1)$$

When what included period of 2nd periodic signal F2 in period of the 1st periodic signal F1 was detected, period of the 1st periodic signal F1 becomes higher than $\Delta \tau$.

That frequency of the 1st periodic signal F1 changes in a predetermined level of the low level side or the place set price of the drop direction side was reached is judged.

The detection (a judgment) by judgment circuitry 22 of this case is once.

In the 2nd embodiment, detection by judgment circuitry 22 can do a judgment (the judgment of the time of day when it was shorter period) like the above by multiple times or the 2nd, the 3nd, ..., detection of the J joint.

That is, in during starting (at the time of detection processing initiation) of frequency detection apparatus 2, $\Delta \tau$ may be T1+T2+ ... TJ <= $\Delta r$ <T1+T2+ ... TJ+TJ+1 (2) in delay time (in the case of (1) expression at the time of J = 2).

Here, in Tk (k = 1,2,..., J, J+1), k-th pulse of the 1st periodic signal, J are positive integers.

For example, in the case of J = 3, as for judgment circuitry 22, frequency of the 1st periodic signal F1 judges that frequency dropped in predetermined value by the detection (a time of day when the period when it was shorter than $\Delta r/2$ was for longer than $\Delta \tau/2$) of the 1st joint.

Also, as for judgment circuitry 22, frequency of the 1st periodic signal F1 judges that frequency dropped in predetermined value by the detection (a time of day when the period when it was shorter than $\Delta \tau$ was for longer than $\Delta \tau$) of the 2nd joint.

In FIG. 4 (C), "the 2nd narrow area pulse of 2nd periodic signal F2" and "the 3nd narrow area pulse" are included between "the 4th narrow area pulse of the 1st periodic signal F1" and "the 5th narrow area pulse" (upper bound the 1st).

And "the 8th narrow area pulse of 2nd periodic signal F2" and "the 9th narrow area pulse" are included between "the 9th narrow area pulse of the 1st periodic signal F1" and "the 10th narrow area pulse" (upper bound the 2nd).

In FIG. 4 (B), (C), the frequency which detection of upper bound the 1st was made is shown with f1, 2 (the frequency of a high side), and it is shown the frequency that detection of upper bound the 2nd was done with f1, 1 (the frequency of a low side).

In FIG. 4 (B), it is shown a time of day of this time by "the 1st lower limit detection" and "the 2nd lower limit detection".

Judgment circuitry 22 detects that the 8th narrow area pulse and the 9th narrow area pulse of 2nd periodic signal F2 are included between the 9th narrow area pulse and the 10th narrow area pulse of the 1st periodic signal F1.

That is, that frequency of the 1st periodic signal F1 changes in a predetermined level of the low level side by the detection of the 2nd joint more or the place set price of the drop direction side was further reached is judged.

The period when the detection of the 2nd joint was shorter than $\Delta \tau$ is a time of day when it was for longer than $\Delta \tau$.

Note that, in the 2nd embodiment, only the detection of the 1st joint is performed like the 1st embodiment unless the shortest period of the 1st periodic signal F1 becomes lower than half of the longest period (unless the smallest frequency of the 1st periodic signal F1 is as above 2 times of maximum frequency).

When a change of the frequency is small because it is it, the detection after the 2nd joint by judgment circuitry 22 does not have to consider.

For example, the detection after the 2nd joint is not done when frequency of the 1st periodic signal F1 changes in the range of 26MHz from 25MHz.

FIG. 5 (A), (B), FIG. 6 are illustrations showing the 3nd embodiment of "invention A". This frequency detection apparatus 3 has a function of frequency detection apparatus 1 of FIG. 1 (A) and a function of frequency detection apparatus 2 of FIG. 3 (A).

In FIG. 5 (A), frequency detection apparatus 3 possesses delayed signals output circuit 31 and judgment circuitry 32.

The 1st periodic signal F1 that frequency changes at time (it gets longer dynamically or it shortens) is input, and delayed signals output circuit 31 outputs 2nd periodic signal F2 where only $\Delta \tau$ retarded this 1st periodic signal F1 for predetermined time.

In this embodiment, as shown in FIG. 6, the frequency of the 1st periodic signal F1 is set to change dynamically. It increases to 9Hz in a harmonic progression from frequency 1Hz, and the frequency of the 1st periodic signal F1 is set to go low in a harmonic progression from frequency 9Hz after this.

Also, as shown in FIG. 6, the 1st periodic signal F1 is a narrow width pulse string. Thus, 2nd periodic signal F2 is a narrow width pulse string, too.

It is referred 1,2,3,... number to "a narrow width pulse string of the 1st periodic signal F1" and "a narrow width pulse string of 2nd periodic signal F2" depending on progress at time to make explanation plain in FIG. 6, respectively.

When the period of "the 6th narrow width pulse of the 1st periodic signal F1" shortens than $\Delta\tau$ by the process that frequency increases, it is shown (an upper bound).

Also, it is shown (a lower limit) when the period of "the eleventh narrow width pulse of the 1st periodic signal F1" becomes for longer than $\Delta \tau$ by the process when frequency decreases.

In FIG. 7 (B), (C), it is shown the frequency which the detection of the upper bound and lower limit detection were made with f1, 1.

In FIG. 7 (B), it is shown a time of day of this time by "upper bound detection" and "lower limit detection".

FIG. 7 (A), (B), FIG. 8 are illustrations of a frequency detection apparatus having "a function of frequency detection apparatus 1 of FIG. 2" (A) and "a function of frequency detection apparatus 2 of FIG. 4" (A).

In FIG. 7 (A), frequency detection apparatus 3 consists of delayed signals output circuit 31 and judgment circuitry 32 comprising counter 321.

The frequency of the 1st periodic signal F1 changes dynamically.

The 1st periodic signal F1 that frequency changes at time is input, and delayed signals output circuit 31 outputs 2nd periodic signal F2 where only $\Delta \tau$ retarded this 1st periodic signal F1 for predetermined time.

Counter 321 inputs 1st periodic signal F1 and 2nd periodic signal F2, and a record (an increment) does the number of times that period of the 1st periodic signal F1 was included in period of 2nd periodic signal F2.

With this, a record (a decrement) does what included period of 2nd periodic signal F2 in period of the 1st periodic signal F1.

In this embodiment, as shown in FIG. 8, the frequency of the 1st periodic signal F1 is set to change dynamically. It increases to 13Hz in a harmonic progression from frequency 1Hz, and the frequency of the 1st periodic signal F1 is set to go low in a harmonic progression from frequency 13Hz after this.

Also, as shown in FIG. 8, the 1st periodic signal F1 is a narrow width pulse string, and it wants to be done, and 2nd periodic signal F2 is a narrow width pulse string, too.

It is referred 1,2,3,... number to "a narrow width pulse string of the 1st periodic signal F1" and "a narrow width pulse string of 2nd periodic signal F2" depending on progress at time to make explanation plain in FIG. 8, respectively.

In FIG. 8, as for the judgment by judgment circuitry 32, frequency is performed twice twice by a decreasing process by the process that frequency increases, respectively.

When the period of "the 6th narrow width pulse of the 1st periodic signal F1" shortens than $\Delta \tau$ by the process that frequency increases (upper bound the 1st) and when the period of "the eleventh narrow width pulse of the 1st periodic signal F1" shortens more from $\Delta\tau/2$, it is shown (upper bound the 2nd).

When it is for longer than $\Delta\tau/2$ the period of "the narrow width pulse of the 1st periodic signal F1" by the process when frequency also decreases (lower limit the 1st) and when it "is further for longer than $\Delta \tau$ "a narrow width pulse of the 1st periodic signal F1" $^{\oslash}$ period, it is shown" (lower limit the 2nd).

In FIG. 7 (B), (C), the frequency which detection of upper bound the 1st and detection of lower limit the 2nd were made is shown with f1, 1, and it is shown the frequency that detection of upper bound the 2nd and detection of lower limit the 1st were done with f1, 2.

In FIG. 7 (B), it is shown a time of day of this time by "the 1st upper bound detection", "the 2nd lower limit detection", "the 2nd upper bound detection", "the 1st lower limit detection".

As far as, in the 3nd embodiment, the shortest period of the 1st periodic signal F1 does not become lower than half of the longest period like the 1st embodiment (as far as maximum frequency of the 1st periodic signal F1 does not become lower than half of the smallest frequency), only the detection of the 1st joint is performed.

Thus, the detection after the 2nd joint does not have to consider when a change of the frequency is small.

For example, the detection after the 2nd joint by judgment circuitry 22 is not done when frequency of the 1st periodic signal F1 changes in the range of 25-40MHz.

FIG.9 is a figure of which shows the frequency detection apparatus that frequency detection apparatus 1 of FIG. 1 (A) was connected to a plural number as 1 unit, and was comprised.

This frequency detection apparatus has the common 1st periodic signal.

Frequency detection apparatus 4 of FIG. 9 comprises delayed signals output circuit 11 and 1st unit UA comprising judgment circuitry 12 and delayed signals output circuit 11 and 2nd unit UB comprising judgment circuitry 22.

Also, control circuit 43 inputting these listing is connected to a subsequent stage of 1st unit UA and 2nd unit UB.

The 1st periodic signal F1 input into 1st unit UA and 2nd unit UB inputs the common 1st periodic signal F1.

Also, it is different from $\Delta \tau B$ in delay time to the 1st periodic signal F1 of 2nd periodic signal F2B in $\Delta \tau A$ and 2nd unit UB in delay time to the 1st periodic signal F1 of 2nd periodic signal FA2 in 1st unit UA.

However, it is $\Delta \tau A < \Delta \tau B$.

With frequency detection apparatus 4 of FIG. 9, appropriate upper limited frequency fA1 and lower cut-off frequency frequency fB1 can be set as shown in FIG. 10.

FIG.11 is a figure of which shows frequency detection apparatus 5 that plural units were connected in parallel as 1 unit, and comprised a frequency detecting circuit of power conversion equipment 1 of FIG. 1 (A).

In FIG. 11, a preceding paragraph of 1st unit UA (frequency detecting circuit 5A) and 2nd unit UB (frequency detecting circuit 5B) is provided with distributing circuit 54 which distributes the 1st periodic signal F1 between phase difference n.

Distributing circuit 54 outputs two 1st periodic signal FA1, FB1 in phase difference π. As a practical matter, for example, as F1 = FA1 the FB1 をに F1 vs. it is done, and π can be delayed.

First unit UA (frequency detecting circuit 5A) consists of delayed signals output circuit 51A and judgment circuitry 52.

It is not illustrated, but the delay control circuit can be provided in the preceding paragraph of delayed signals output circuit 51A.

Also, 2nd unit UB (frequency detecting circuit 5B) consists of delayed signals output circuit 51B and judgment circuitry 52.

It is not illustrated, but it is possible to provide the delay control circuit in the preceding paragraph of delayed signals output circuit 51B.

Delay time to the 1st periodic signal F1 of 2nd periodic signal FA2 in 1st unit UA (frequency detecting circuit 5A) is assumed $\Delta \tau A$.

Delay time to the 1st periodic signal F1 of 2nd periodic signal FB2 in 2nd unit UB (frequency detecting circuit 5B) is assumed $\Delta \tau B$.

It is different from $\Delta \tau B$ in $\Delta \tau A$ and delay time by delay time ($\Delta \tau A < \Delta \tau B$).

First unit UA, a subsequent stage of 2nd unit UB are provided with common synthetic circuitry 55.

First unit UA, listing of 2nd unit UB are synthesized.

As for frequency detection apparatus 5 of FIG. 11, substantial resolution doubles as shown in FIG. 13.

As a practical matter, the listing such as SQ of FIG. 12 needs not to be done.

Note that, in FIG. 11, frequency detection apparatus 1 of FIG. 1 (A) was connected to a plural number as 1 unit, and it was comprised.

A plural number can connect frequency detection apparatus 1, FIG. 3 (A) of FIG. 2 (A), frequency detection apparatus 2, FIG. 5 (A) of FIG. 4 (A), frequency detection apparatus 3 of FIG. 7 (A) as 1 unit.

Frequency detection apparatus 1 can be comprised in combination with frequency detection apparatus 4 of FIG. 9.

FIG.13 is a figure of which shows frequency detection apparatus 6 that plural units were connected in parallel as 1 unit, and comprised a frequency detecting circuit of power conversion equipment 1 of FIG. 1 (A).

Here, each frequency detecting circuit has the common 1st periodic signal F1.

This 1st periodic signal F1 is sent to 1st unit UA, either of 2nd unit UB by range selective circuit 65 whether it belongs to a low level whether frequency of the 1st periodic signal F1 belongs to high pass.

In FIG. 13, 1st unit UA (frequency detecting circuit 6A) consists of delayed signals output circuit 61A and judgment circuitry 62.

It is not illustrated, but a preceding paragraph of delayed signals output circuit 61B may be provided with a delay control circuit.

Also, 2nd unit UB (frequency detecting circuit 6B) consists of delayed signals output circuit 61B and judgment circuitry 62.

It is not illustrated, but a preceding paragraph of delayed signals output circuit 61B may be provided with a delay control circuit.

It may be the same as $\Delta \tau B$ in delay time to 1st periodic signal FB1 of $A \tau A$ and 2nd periodic signal FB2 in delay time to 1st periodic signal FA1 of 2nd periodic signal FA2. Also, ∆τB may be different from ∆τA in these delay time.

Frequency detection apparatus 6 of FIG. 13 can divide frequency ranges into the operating range of two units. That is, frequency detection apparatus 6 of FIG. 13 divides "frequency ranges of the 1st periodic signal F1 input into range selective circuit 65" into two operating ranges (an operating range of unit UA and an operating range of unit UB) as shown in FIG. 14.

Note that, in FIG. 13, frequency detection apparatus 1 of FIG. 1 (A) was connected to a plural number as 1 unit, and it was comprised.

A plural number can connect frequency detection apparatus 1, FIG. 3 (A) of FIG. 2 (A), frequency detection apparatus 2, FIG. 5 (A) of FIG. 4 (A), frequency detection apparatus 3 of FIG. 7 (A) as 1 unit.

Also, a frequency detection apparatus of FIG. 13 can be combined with frequency detection apparatus four or five of FIG. 9, FIG. 11.

(invention B)

FIGS. 15 and 16 are illustrations showing the configuration of the electric circuit controller of "invention B".
•
•

In FIG. 15, electric circuit controller 102 has periodic signal generation circuitry 103, frequency detecting circuit 104, driving signal generation circuitry 105 and delay control circuit 106.

Periodic signal generation circuitry 103 detects the voltage which an electric information of electric circuit 101 is equivalent to, and the detection value is converted into the 1st periodic signal F1.

In FIG. 15, "the voltage which an electric information of electric circuit 101 is equivalent" to is one or electric informations two or more (1st signal group).

Frequency detecting circuit 104 consists of delayed signals output circuit 1041 and judgment circuitry 1042.

Periodic signal generation circuitry 103 detects 1st signal group of electric circuit 101 as voltage signal F1, and it is output to judgment circuitry 1042.

∆τ is set to delayed signals output circuit 1041 in delay time, and delayed signals output circuit 1041 outputs the 2nd periodic signal F1 that ∆τ delayed to the 1st voltage signal F1 to judgment circuitry 105.

First periodic signal F3 and 2nd periodic signal F2 are input, and judgment circuitry 105 detects whether period of the 1st periodic signal F1 was included in period of 2nd periodic signal F2.

Also, judgment circuitry 105 detects whether period of 2nd periodic signal F2 was included in period of the 1st periodic signal F1.

Driving signal generation circuitry 105 generates control signal VGs from this judgment circuitry signal, and this is sent out to an electric switch of electric circuit 101.

In FIG. 16, a preceding paragraph of delayed signals output circuit 1041 is provided with delay control circuit 106.

Delay control circuit 106 detects the voltage which an electric information of electric circuit 101 is equivalent to, and a delay control signal is generated.

In FIG. 16, "the voltage which an electric information of electric circuit 101 is equivalent" to is one or electric informations two or more:

It is 1st signal group.

In the 2nd signal group, 1st signal and part may repeat.

Also, the delay control signal may be the fixed number, and it may be changing signal dynamically (including signal changing every constant cycle).

In "invention B" the electric information included in electric circuit 101, for example, input current,

Input voltage,

Output current,

Output voltage,

Voltage emerging to an electric reactor,

The electric reactor current flowing,

Voltage emerging to the electric switch,

The electric switch current flowing,

It is current flowing with voltage emerging to a diode (a commutation diode, a rectifier diode), the diode

である.

These voltage and current can be adopted as electrical signal in FIGS. 15 and 16.

FIG. 17 is a figure showing power conversion equipment 1, and the 1st embodiment that applied electric circuit controller 102 of FIG. 16 to the control of power converters is shown.

Note that electric circuit controller 102 of FIG. 15 can be applied to control of the power conversion equipment (cf. FIG. 16 to be described below).

Power conversion equipment 1 includes power converters 11 and control circuit 12 in FIG. 17.

In the 1st embodiment, power converters 11 is voltage-controlled DC/DC transducer, and DC/DC converts DC voltage of power supply 81, and it is supplied to load 82.

Control circuit 12 has periodic signal generation circuitry 13 and frequency detecting circuit 14 and driving signal generation circuit 15 and delay control circuit 16.

Periodic signal generation circuitry 13 detects voltage Vi corresponding to circuit current i of power converters 11, and a detection level is converted into periodic signal F1.

Periodic signal generation circuitry 13 can be comprised, for example, from an analog voltage controlled oscillator (VCO).

Frequency detecting circuit 14 consists of delayed signals generation circuitry 141 and judgment circuitry 142.

Delay control circuit 16 detects output voltage eO of power converters 11 through analog-to-digital converter 17, and delayed signals generation circuitry 141 can output delay control sincerity DLY (eO).

When delayed signals generation circuitry 141 works by analog input, analog-to-digital converter 17 is unnecessary in FIG. 17.

Delayed signals generation circuitry 141 outputs 2nd periodic signal F2 where only $\Delta \tau$ retarded the 1st periodic signal F1 for predetermined time.

The predetermined time $\Delta$ tau (it is time depending on DLY (eO) and, as for this time, is smaller than initial period of the 1st periodic signal F1.)

Judgment circuitry 142 inputs 1st periodic signal F1 and 2nd periodic signal F2, and it is detected whether period of the 1st periodic signal F1 was included in period of 2nd periodic signal F2, and judgment signal is output.

Also, judgment circuitry 142 detects whether period of 2nd periodic signal F2 was included in period of the 1st periodic signal F1, and judgment signal is output.

As for driving signal generation circuitry 15, the control terminal of an electric switch comprising power converters 11 can output control signal VGs.

The electric circuit controller of "invention B" can apply to three-phase power converter 11 as shown in FIG. 18.

Three phase voltage va, vb, vc are input into power conversion equipment 1 in FIG. 18. a aspect controller 12a, b aspect controller 12b, c aspect controller 12c take electric information group A, electric information group B, electric information group C from power converters 11.

Based on these electric informations group, a control signal is output to the electric switch of each aspect to comprise power conversion equipment 1.

FIG. 19 is an illustration shown in the elaboration with power conversion equipment 1 of FIG. 17 more.

Power conversion equipment 1 includes power converters 11 and control circuit 12 in FIG. 19.

In the 1st embodiment, power converters 11 is current control type DC/DC transducer, and DC/DC converts DC voltage of power supply 81, and it is supplied to load 82.

As for power converters 11, it is electric switch 111 and electric reactor 112 from current detecting resistance 113 and commutation diode 114 and capacitor 115.

Electric switch 11 and electric reactor 112 and current detecting resistance 113 are performed series connection of sequentially by the input side, and commutation diode 114 is connected to a T-head character between electric switch 11 and electric reactor 112, and capacitor 115 is connected to an output side.

Control circuit 12 is the same as electric circuit controller 12 shown in FIG. 17.

That is, periodic signal generation circuitry 13 inputs current detecting both ends voltage v1 of resistance 113, v2, and voltage drop VR = (v1-v2) is detected.

Here, (v1-v2 is the value that converted electric reactor current iL (a circuit current in "invention B") into voltage.

And periodic signal generation circuitry 13 converts a detection level into periodic signal f1, and it is output as the 1st periodic signal F1.

As for frequency detecting circuit 14, delayed signals generation circuitry 141 outputs 2nd periodic signal F2 where only $\Delta\tau$ retarded the 1st periodic signal. F1 for predetermined time from delayed signals generation circuitry 141 and judgment circuitry 142.

Also, judgment circuitry 142 inputs 1st periodic signal F1 and 2nd periodic signal F2, and it is detected whether period of the 1st periodic signal F1 was included in period of 2nd periodic signal F2, and judgment signal is output.

As shown in STs of FIG. 20 (A), driving signal generation circuitry 15 works in clock STs of Ts in period, and control signal VGs to send out to electric switch 111 in height of the rise of clock STs is turned on.

On the other hand, delayed signals generation circuitry 141 inputs voltage VR (v1-v2 as shown in V = R / iL of FIG. 20 (A), and this is converted into periodic signal f1 (cf. frequency characteristic of the halfpace of FIG. 20 (A)).

In FIG. 20 (A), 40MHz includes the frequency in approximately 30MHz, an upper bound with a lower limit.

That is, judgment circuitry 141 outputs judgment signal SQ when frequency f1 of the 1st periodic signal F1 reached predetermined threshold fSH (approximately 40MHz). Here, when $\Delta \tau$ was reached in the period when period of the 1st periodic signal F1 supported when "predetermined threshold fSH (approximately 40MHz) was reached" (it is FIG. 20 (B).) However, the threshold of the figure can give a degree of leaning to keep the stability of the stem to be usually conducted with electric power converters of this method.

When judgment signal SQ is output, driving signal generation circuitry 15 outputs the control signal that an electric switch becomes the OFF to power converters 11.

In FIG. 20 (A), periodic signal generation circuitry 13 of FIG. 19 inputs both ends voltage of current detecting resistance 114 (ohmic value R1), and voltage drop V1 = R1 / iS is detected.

Also, in FIG. 20 (B), periodic signal generation circuitry 13 of FIG. 19 detects value of voltage drop V = R / iS and value of value (ohmic value R2) voltage drop V2 = R2 / iD of the both ends voltage of commutation diode 114.

And periodic signal generation circuitry 13 produces the 1st periodic signal F1 of the adding up level equivalent value of the current.

Electric reactor current iL is adopted as a circuit current of FIG. 17 in FIG. 19, but, as shown in FIG. 21, electric switch 211 can be assumed current flowing iS by a circuit current.

A change state is shown in FIG. 22 (A) at the time in all parts of the power conversion equipment, and a change state is shown in (B) at the 1st periodic signal F1, time of 2nd periodic signal F2.

When commutation diode 114 is off, in the power conversion equipment of FIG. 21, iS becomes the bottom value as shown in FIG. 22 (A) (it refers to the wave form chart showing the characteristic of frequency f and a wave form chart showing voltage V = R1 X is).

However, the listing of the electric circuit controller is the same as listing of electric circuit controller 12 of FIG. 19 (clock STs of FIG. 22, judgment signal SQ, cf. control signal VGs).

FIG.23 is a figure of which shows power conversion equipment 1 which these two units (frequency detecting circuit 14A, 14B) were connected in parallel as 1 unit, and comprised frequency detecting circuit 14 of power conversion equipment 1 of FIG. 19.

Frequency detecting circuit 14A, the configuration of 14B are the same, and, in FIG. 23, delay control circuit 16A, 16B send out signal to control $\Delta \tau$ which is common to delayed signals generation circuitry 141, respectively.

The delay time $\Delta$ tau to be set to しがたって, each delayed signals generation circuitry 141 is the same.

In FIG. 23, delay control circuit 16A, 16B are established in frequency detecting circuit 14A, 14B, respectively.

However, listing of delay control circuit 16A may be sent out to delayed signals generation circuitry 141 of frequency detecting circuit 14A and delayed signals generation circuitry 141 of frequency detecting circuit 14B without, for example, establishing delay control 16B.

Control circuit 12 of FIG. 23 is provided with phase shift circuitry 27.

Phase shift circuitry 27 is connected to periodic signal generation circuitry 13B of periodic signal generation circuitry 13A of the 1st unit (frequency detecting circuit 24A) and the 2nd unit (frequency detecting circuit 24B).

Phase shift circuitry 27 works to be able to give each 1st periodic signal F1 which periodic signal generation circuitry 13A, 13B produce phase difference n.

As shown in FIG. 24, a phase difference is π with the 1st periodic signal F1 which 1st periodic signal F1 which periodic signal generation circuitry 13A outputs and periodic signal generation circuitry 13B output.

Thus, detection resolution (judgment accuracy) doubles.

Note that electric reactor current iL of FIG. 19 power converters 11 cannot be measured. That is, as shown in FIG. 25, it is possible so that periodic signal generation circuitry 13 acquires current flowing with current flowing and commutation diode 114 with electric switch 111.

In FIG. 26, frequency detecting circuit 14 of power conversion equipment 1 of FIG. 19 is assumed 1 unit, and these two units are connected in parallel, and power conversion equipment 1 is comprised.

In FIG. 26, two units are frequency detecting circuit 14A, 14B.

Control circuit 12 of power conversion equipment 1 is provided with range selective circuit 18.

Each frequency detecting circuit 14A, 14B have the common 1st periodic signal F1. This 1st periodic signal F1 is sent to 1st unit, either of the 2nd unit (frequency detecting circuit 14A, 14B) whether it belongs to a low level whether frequency of the 1st periodic signal F1 belongs to high pass.

In FIG. 26, the 1st unit (frequency detecting circuit 14A) consists of delayed signals generation circuitry 141 and judgment circuitry 142.

A preceding paragraph of delayed signals generation circuitry 141 may be provided with delay control circuit 16A.

Also, the 2nd unit (frequency detecting circuit 14B) consists of delayed signals generation circuitry 141 and judgment circuitry 142.

A preceding paragraph of delayed signals generation circuitry 141 is provided with delay control circuit 16B.

$\Delta \tau$ B may be the same in delay time to 1st periodic signal FB1 of $\Delta \tau$A and 2nd periodic signal FB2 in the 2nd unit (frequency detecting circuit 14B) in delay time to 1st periodic signal FA1 of 2nd periodic signal FA2 in the 1st unit (frequency detecting circuit 14A). Also, it may be different.

Converter 1 of FIG. 26 can divide (i.e., depending on the dimension of circuitry current magnitude namely the load), frequency processing in two to the 1st unit (frequency detecting circuit 24A) or a 2nd unit (frequency detecting circuit 24B) depending on dimension of voltage input into range selective circuit 18 as shown in FIG. 27.

Thus, the operating range can be enlarged substantially, too.

Power conversion equipment 1 of FIG. 28 operates a circuit current between an upper bound and an upper bound (i.e., the 1st periodic signal F1 is operated between the upper bound threshold and the lower limit threshold).

In FIG. 28, power conversion equipment 1 which (frequency detecting circuit 14A, 14B) is connected in parallel, and comprised these two units is comprised as 1 unit with frequency detecting circuit 14 of power conversion equipment 1 of FIG. 19.

Here, periodic signal generation circuitry 13 outputs frequency detecting circuit 14A and the 1st periodic signal F1 which are common to frequency detecting circuit 14B. The 1st unit (frequency detecting circuit 14A) consists of delayed signals generation circuitry 141 and judgment circuitry 142.

A preceding paragraph of delayed signals generation circuitry 141 is provided with delay control circuit 16A.

The 2nd unit (frequency detecting circuit 14B) consists of delayed signals generation circuitry 141 and judgment circuitry 142.

A preceding paragraph of delayed signals generation circuitry 141 is provided with delay control circuit 16B.

In FIG. 28, it is different from $\Delta\tau B$ as shown in FIG. 29 (A), (B), (C) in $\Delta\tau A$ and delay time in delay time to the 1st periodic signal F1 ($\Delta\tau A<\Delta\tau B$).

It is different from $\Delta\tau B$ in delay time to the 1st periodic signal F1 of $\Delta\tau A$ and 2nd periodic signal FB2 in the 2nd unit (frequency detecting circuit 24B) in delay time to the 1st periodic signal F1 of 2nd periodic signal FA2 in the 1st unit (frequency detecting circuit 14A) ($\Delta\tau A <\Delta\tau B$).

With power conversion equipment 1 of FIG. 28, upper limited frequency fSHA and lower cut-off frequency fSHB become the threshold, and frequency of the 1st periodic signal F1 is controlled (i.e., electric reactor current iL is controlled).

The signal state of all parts of power conversion equipment 1 is shown, and a state 1st periodic signal F1 and 2nd periodic signal FA2 are proportional to FIG. 29 (B) at time, and to fluctuate is shown in FIG. 29 (A) with a pulse string.

A state 1st periodic signal F1 and 2nd periodic signal FB2 are proportional to FIG. 29 (C) at time, and to fluctuate is shown with a pulse string.

It is different from $\Delta\tau B$ in delay time to the 1st periodic signal F1 of 2nd periodic signal F2 in $\Delta\tau A$ and frequency detecting circuit 14B in delay time to 1st periodic signal FA1 of 2nd periodic signal FA2 in frequency detecting circuit 14A, and it is $\Delta\tau B> \Delta\tau A$.

When period shrank than $\Delta\tau A$ when period is smaller greatly from $\Delta\tau A$ than $\Delta\tau B$, as for driving signal generation circuitry 15, an electric switch outputs OFF and the control signal that it is to power converters 11.

When when "period is smaller greatly from $\Delta\tau A$ than $\Delta\tau B$", frequency factory automation corresponding to $\Delta\tau A$ is higher than frequency fB corresponding to $\Delta\tau B$. When "period shrank than $\Delta\tau A$", it is time beyond the frequency factory automation corresponding to $\Delta\tau A$.

And, as for (when it fell from frequency fB), driving signal generation circuitry 15 outputs the control signal that an electric switch becomes the ON to power conversion 11 when period grew big than $\Delta\tau B$ (cf. VGs of FIG. 29 (A)).

Judgment circuitry 142 detects with power conversion equipment 1 of FIG. 28 whether one period of 1st periodic signal FA1 included one period of 2nd periodic signal FA2, and judgment circuitry 142 detects whether one period of 2nd periodic signal FA2 included one period of 1st periodic signal FB1.

When driving signal generation circuitry 15 controls PID control, the FIR control IIR control, delayed signals generation circuitry 141 of delay control circuit 16A, a delay characteristic of delayed signals generation circuitry 141 of delay control circuit 16B can be changed.

For example, delay control circuit 16A, 16B change $\Delta\tau A$, $\Delta\tau B$ so that listing of control circuit 12 has a characteristic of the A (eO-Er) - EB. $\Delta\tau A$, $\Delta\tau B$ are set to delay control circuit 16A, each delayed signals generation circuitry 141 of 16B. In A, in transmission coefficient, eO, as for the output voltage of power converters 11, the Er, reference voltage, Er are bias voltage. By the change of this delay characteristic, the frequency threshold when it changes changes, for example, into the side that is smaller than $\Delta\tau A$ as shown in a figure of of circuit current i of FIG. 29 (B) frequency change, a figure of narrow width pulse of FIG. 29 (B) from the side where period of the 1st periodic signal F1 is bigger than $\Delta\tau A$.

Also, as shown in a figure of of circuit current i of FIG. 29 (B) frequency change, a figure of narrow width pulse of FIG. 29 (C), the frequency threshold when it changes changes into the side that is bigger than $\Delta\tau B$ from the side where period of the 1st periodic signal F1 is smaller than $\Delta\tau B$.

Circuit current i of FIG. 29 (B) is the 1st periodic signal F1.

"The frequency threshold when period of the 1st periodic signal F1 changes in the side that is smaller than $\Delta\tau A$ from the side that is bigger than $\Delta\tau A$" is upper bound threshold fASH of the figure of frequency change of FIG. 29 (B).

Circuit current i of FIG. 29 (B) is the 1st periodic signal F1.

"The frequency threshold when period of the 1st periodic signal F1 changes in the side that is bigger than $\Delta\tau B$ from the

side that is smaller than ΔτB" is lower limit threshold fBSH of the figure of frequency change of FIG. 29 (C).

That is, with power conversion equipment 1 of FIG. 28, that period of the 1st periodic signal F1 having changed in the side that is smaller than ΔτA from the side that is bigger than ΔτA, period of the 1st periodic signal F1 changed in the side that is bigger than ΔτB from the side that is smaller than ΔτB is detected as shown in FIG. 29 (A), (B), (C).

It is the same as "frequency f1 of the 1st periodic signal F1 having reached the upper limit of the predetermined characteristic" that "period of the 1st periodic signal F1 changed in the side that is smaller than ΔτA from the side that is bigger than ΔτA".

As for "period of the 1st periodic signal F1 having changed in the side that is bigger than ΔτB from the side that is smaller than ΔτB", it is the same that "frequency f1 of the 1st periodic signal F1 reached the lower limit of the predetermined characteristic".

When frequency f1 of the 1st periodic signal F1 reached upper bound threshold fASH, as for driving signal generation circuitry 15, an electric switch outputs OFF and the control signal that it is to power converters 11.

When frequency f1 of the 1st periodic signal F1 fell to lower limit threshold fBSH, the control signal that an electric switch becomes the ON to power converters 11 is output (cf. VGs of FIG. 29 (A)).

FIG. 30 is an illustration showing the 2nd embodiment of the power conversion equipment of "invention B".

Power conversion equipment 2 includes power converters 21 and control circuit 22 in FIG. 30.

In the 2nd embodiment, power converters 21 is voltage-controlled DC/DC transducer, and DC/DC converts DC voltage of power supply 81, and it is supplied to load 82.

Control circuit 22 has periodic signal generation circuitry 23 and frequency detecting circuit 24 and driving signal generation circuit 25.

Periodic signal generation circuitry 23 detects output voltage eO of power converters 21, and a detection level is converted into periodic signal F1.

Frequency detecting circuit 24 consists of delayed signals generation circuitry 241 and judgment circuitry 242.

Delayed signals generation circuitry 241 outputs 2nd periodic signal F2 where only Δτ (smaller than initial period of the 1st periodic signal F1) retarded the 1st periodic signal F1 for predetermined time.

Judgment circuitry 242 inputs 1st periodic signal F1 and 2nd periodic signal F2, and it is detected whether period of the 1st periodic signal F1 was included in period of 2nd periodic signal F2, and judgment signal is output.

Also, judgment circuitry 242 detects whether period of 2nd periodic signal F2 was included in period of the 1st periodic signal F1, and judgment signal is output.

As for driving signal generation circuitry 25, the control terminal of an electric switch comprising power converters 21 can output a control signal.

FIG. 31 (A), (B), (C) are operation illustrations of frequency detecting circuit 2 of FIG. 30.

FIG. 31 (A) is a figure showing the changes of t at time of output voltage eO of power converters 21 (among the figures above with a command of output voltage eO as shown in eO *). FIG. 31 (B) is a figure showing output frequency (frequency corresponding to output voltage eO) f of periodic signal generation circuitry 23.

It is the figure as shown in the pulse string with a state the 1st periodic signal F1 is proportional to FIG. 31 (C) at time, and to fluctuate.

It is referred 1,2,3,... number to a narrow width pulse string of 1st periodic signal F1 and 2nd periodic signal F2 depending on progress at time to make explanation plain in FIG. 31 (C), respectively.

Also, the 1st periodic signal F1 is set as follows period decreases in a harmonic progression from frequency 1Hz, and to increase.

The interval between the narrow width pulses of the 1st and the 2nd:

The interval between the narrow width pulses of 1.2 2nds joint and the 3nd:

The interval between the narrow width pulses of half 2nd the 3nd and the 4th:

The interval between the narrow width pulses of one-3nd 2nd the 4th and the 5th:

The interval between the narrow width pulses of quarter 2nd the 5th and the 6th:

The interval between the narrow width pulses of 1/5 2nd the 6th and the 7th:

The interval between the narrow width pulses of 1/6 2nd the 7th and the 8th:

The interval between the narrow width pulses of 1/7 2nd the 8th and the 9th:

The interval between the narrow width pulses of 1/6 2nd the 9th and the 10th:

The interval between the narrow width pulses of 1/5 2nd the 10th and the eleventh:

The interval between the narrow width pulses of quarter 2nd the eleventh and the twelfth:

A one-3nd 2nd [0183]

It is equivalent with including period of the 1st periodic signal F1 in period of 2nd periodic signal F2 and two narrow width pulses to continue of the 1st periodic signal F1 being located between two narrow width pulses to continue of 2nd periodic signal F2. Also, it is equivalent with including period of the 2nd periodic signal F1 in period of the 1st periodic signal F1 and two narrow width pulses to continue of 2nd periodic signal F2 being located between two narrow width pulses to continue of the 1st periodic signal F1. In a judgment whether or not period of the 1st periodic signal F1 was included in period of 2nd periodic signal F2, a former narrow width pulse may be piled up in the former narrow width pulse among two narrow width pulses to continue of 2nd periodic signal F2 among two narrow width pulses to continue of the 1st periodic signal F1.

Also, a later narrow width pulse may be piled up in the later narrow width pulse among two narrow width pulses to continue of 2nd periodic signal F2 among two consecutive narrow width pulses of the 1st periodic signal F1.

In a judgment whether or not period of 2nd periodic signal F2 was included in period of the 1st periodic signal F1, a former narrow width pulse may be piled up in the former narrow width pulse among two narrow width pulses to continue of the 1st periodic signal F1 among two narrow width pulses to continue of 2nd periodic signal F2.

Also, a later narrow width pulse may be piled up in the later narrow width pulse among two narrow width pulses to continue of the 1st periodic signal F1 among two consecutive narrow width pulses of 2nd periodic signal F2.

In this embodiment, it can be detected whether a narrow width pulse of the 1st periodic signal F1 and a narrow width pulse of 2nd periodic signal F2 are detected alternately whether period of the 1st periodic signal F1 was included in period of 2nd periodic signal F2.

Also, it can be detected whether period of 2nd periodic signal F2 was included in period of the 1st periodic signal F1.

That is, in FIG. 31 (C), judgment circuitry 242 detects signal of signal of the periodic signal F1 and periodic signal F2 in alternating characteristics.

In the 2nd embodiment, frequency f1 of the 1st periodic signal F1 is proportional at time, and it becomes higher or it goes low.

It shortens in a harmonic progression according to progress at time in period of the 1st periodic signal F1 or, as shown in FIG. 31 (C), it thereby gets longer.

In this case, judgment circuitry 242 is judged to have an alternating characteristics to the next narrow width pulse.

"The 1st narrow width pulse of the 1st periodic signal F1 ,"

"The 1st narrow width pulse of 2nd periodic signal F2,"

"The 2nd narrow width pulse of the 1st periodic signal F1,"

*

• • ,

"The 5th narrow width pulse of 2nd periodic signal F2 ,"

"The 6th narrow width pulse of the 1st periodic signal F1,"

However, after "the 6th narrow width pulse of the 1st periodic signal F1", "the 7th narrow width pulse of the 1st periodic signal F1" is detected.

Thus, judgment circuitry 242 judges alternating characteristics that there is not at this time ("upper bound" reference of FIG. 31 (C)).

That is, when, in the 1st time of day when alternating characteristics with a narrow width pulse of the 1st periodic signal F1 and the narrow width pulse of 2nd periodic signal F2 disappeared, the 7th narrow width pulse of the 1st periodic signal F1 was input into judgment circuitry 242 in FIG. 31 (C).

Judgment circuitry 242 may detect a time of day when (the period when it is bigger than $\Delta\tau$) shrank than $\Delta\tau$ in period of the 1st periodic signal F1.

"A time of day when it shrank than $\Delta\tau$" is a time of day when a narrow width pulse of the 6th to the 7th of the 1st periodic signal F1 was input.

Note that there is "the 7th narrow width pulse of the 1st periodic signal F1" by all means than "the 6th narrow width pulse of 2nd periodic signal F2" to the left because the spacing of "the 6th narrow width pulse of the 1st periodic signal F1" and "the 7th narrow width pulse" is smaller than $\Delta\tau$ and the spacing of "the 6th narrow width pulse of the 1st periodic signal F1" and "the 6th narrow width pulse of 2nd periodic signal F2" is $\Delta\tau$.

From this, that judgment circuitry 242 can detect a time of day when period of the 1st periodic signal F1 shrank than $\Delta\tau$ is understood.

Then, when, in the 2nd time of day when alternating characteristics with a narrow width pulse of the 1st periodic signal F1 and the narrow width pulse of 2nd periodic signal F2 disappeared, the 9th narrow width pulse of 2nd periodic signal F2 was input into judgment circuitry 242 in FIG. 31 (C).

Judgment circuitry 242 judges alternating characteristics that there is not at this time ("lower limit" reference of FIG. 31 (C)).

Judgment circuitry 242 can detect a time of day when (the period when it is smaller than $\Delta\tau$) grew big thank $\Delta\tau$ in period of the 1st periodic signal F1 in this way.

"A time of day when it grew big than $\Delta\tau$" is a time of day when the 8th narrow width pulse of the 1st periodic signal F1 was input.

In other words, in FIG. 31 (C), the 6th narrow width pulse of 2nd periodic signal F2 is late for time of $\Delta\tau$ to the 6th narrow width pulse of the 1st periodic signal F1.

It thereby resembles the 9th narrow width pulse of the 1st periodic signal F1 to include the 8th narrow width pulse of

2nd periodic signal F2 and the 9th narrow width pulse between the 10th narrow width pulse.

Thus, judgment circuitry 142 may detect (a time of day when narrow area pulse of the 9th to the 10th of the 1st periodic signal F1 was input) in a time of day when period of 2nd periodic signal F2 grew big than $\Delta\tau$.

As mentioned earlier, in the 2nd embodiment, frequency (frequency of, thus, 2nd periodic signal F2) of the 1st periodic signal F1 rises in a harmonic progression.

In this embodiment, frequency of the 1st periodic signal F1 described a case to fluctuate like 1Hz, 2Hz, ...,5Hz, 6Hz, 7Hz, ...,6Hz, 5Hz, ... to make plain (cf. FIG. 31 (C)).

As a practical matter, the frequency of the 1st periodic signal F1 is made, for example, to fluctuate to the vicinities of 25* 106Hz - 50*106Hz.

As described earlier, frequency detecting circuit 24 can detect a time of day when it grew big than $\Delta\tau$ in a time of day when a narrow width pulse interval of the 1st periodic signal F1 shrank than $\Delta\tau$ because $\Delta\tau$ delays 2nd periodic signal F2 to the 1st periodic signal F1.

When period of the 1st periodic signal F1 is longer than $\Delta\tau$, as for driving signal generation circuitry 25, as for (when value of voltage eO is small), in drive signal generator 15, an electric switch outputs a control signal becoming the ON to power converters 21 (cf. VGs of FIG. 31 (B)).

When period of the 1st periodic signal F1 changed in the side that is smaller than $\Delta\tau$ from the side that is bigger than $\Delta\tau$, as for driving signal generation circuitry 25, an electric switch outputs OFF and the control signal that it is to power converters 21. When when period of the 1st periodic signal F1 reached $\Delta\tau$ from the side that was bigger than $\Delta\tau$ when "period of the 1st periodic signal F1 changed in the side that was smaller than $\Delta\tau$ from the side that was bigger than $\Delta\tau$", in other words, eO increased.

FIG. 32 is a figure showing power conversion equipment 2 comprising 2 units with frequency detecting circuit 24 of FIG. 30.

It is done, and it is made a common use of with the 1st periodic signal F1, and, in power conversion equipment 2 of FIG. 32, it is connected the 1st unit (frequency detecting circuit 24A) and a 2nd unit (frequency detecting circuit 4B) to 2 units (as shown in frequency detecting circuit 24A, 24B) with a frequency detecting circuit shown in FIG. 28 in parallel.

Frequency detecting circuit 24A and a subsequent stage with frequency detecting circuit 24B are provided with driving signal generation circuitry 25.

Note that $\Delta\tau A$ is set to delayed signals generation circuitry 241 of frequency detecting circuit 24A, and $\Delta\tau B$ is set to delayed signals generation circuitry 241 of frequency detecting circuit 24B.

FIG. 33 (A) shows a change at time of output voltage eO of power conversion equipment 2.

Among the figures above, it is j as shown in eO * with a command of output voltage eO.

FIG. 33 (B) shows processing by judgment circuitry 242.

A state 1st periodic signal F1 and 2nd periodic signal FA2 are proportional to FIG. 33 (C) at time, and to fluctuate is shown with a pulse string.

A state 1st periodic signal F1 and 2nd periodic signal FB2 are proportional to FIG. 33 (D) at time, and to fluctuate is shown with a pulse string.

It is different from $\Delta\tau B$ in delay time to the 1st periodic signal F1 of 2nd periodic signal F2 in $\Delta\tau A$ and frequency detecting circuit 24B in delay time to 1st periodic signal FA1 of 2nd periodic signal FA2 in frequency detecting circuit 24A. That is, it is $\Delta\tau B > \Delta\tau A$.

When period shrank than $\Delta\tau A$ when period is smaller greatly from $\Delta\tau A$ than $\Delta\tau B$, as for driving signal generation circuitry 25, as for driving signal generation circuitry 25, an electric switch outputs OFF and the control signal that it is to power converters 21.

When when "period is smaller greatly from $\Delta\tau A$ than $\Delta\tau B$", frequency factory automation corresponding to $\Delta\tau A$ is higher than frequency fB corresponding to $\Delta\tau B$. When "period shrinks than $\Delta\tau A$", it is time beyond the frequency factory automation corresponding to $\Delta\tau A$.

And, as for (when it fell from frequency fB), driving signal generation circuitry 25 outputs the control signal that an electric switch becomes the ON to power converters 21 when period grew big than $\Delta\tau B$ (cf. VGs of FIG. 33 (B)).

Judgment circuitry 242A detects with power conversion equipment 2 of FIG. 32 as shown in FIG. 33 (C), (D) whether one period of 1st periodic signal FA1 included one period of 2nd periodic signal FA2.

And judgment circuitry 242B detects whether one period of 1st periodic signal FB1 was included in one period of 2nd periodic signal FA2.

When frequency f1 of the 1st periodic signal F1 reached upper bound threshold fASH, as for driving signal generation circuitry 25, an electric switch outputs OFF and the control signal that it is to power converters 21.

And, as for driving signal generation circuitry 25, an electric switch outputs OFF and the control signal that it is to power converters 21 when frequency f1 of the 1st periodic signal F1 fell to lower limit threshold fBSH (cf. VGs of FIG. 33 (B)).

(invention C)

FIG. 35 is an illustration showing the embodiments of a delay circuit of "invention C" and the delay circuit system. In FIG. 35, delay circuit 1 consists of detecting circuit 11 and impedance circuit 11 and control circuit 13 and input buffer 14.

In impedance circuit 12, one end is connected to input signal path 15, and other end is connected to grand G. Impedance circuit 12 includes a plurality of electric switches (SW1 - SWM) to change the overall impedance of the impedance circuit into when an on control signal or an off control signal was input, respectively.

In impedance circuit 12, impedance components (a resistance element, a capacitative element, reactive element at least one or combinations thereof) are usually provided other than electric switch SW1 - SWM.

All impedance in impedance circuit 12 was able to include the impedance that electric switch SW1 - SWM had, impedance of the electric wiring, but when delay to be described below only in the impedance that electric switch SW1 - SWM has, impedance of the electric wiring can be formed, impedance circuit 12 does not need to have an impedance component.

It should be the configuration that can detect the threshold, and detecting circuit 11 can compare the both ends voltage of a resistance element formed on thing voltage at the end of input signal path 15 is spread, and to compare with the value, input signal path 15 with the threshold.

Also, the voltage drop to occur because of a resistance ingredient included in input signal path 15 in itself can be compared with the threshold.

Input buffer 14 is connected to the beginning edge of input signal path 15 in FIG. 35.

When output impedance (in FIG. 35 as shown in Z0 of input buffer 14 cannot be ignored, impedance circuit 12 considers Z0, and an impedance value is set substantially. Note that it is shown a power supply included in input buffer 14 in ge.

FIG.36 is a graph which shows a time change of voltage VD occurring to detecting circuit 11.

When voltage VD lays detecting circuit 11, and value VSH was reached, delayed signals SD is output.

Threshold VSH is set to detecting circuit 11 appropriately.

In FIG. 35, threshold VSH is set from controller 13.

This controller 13 can be used, for example, as a controller of the power conversion equipment (cf. FIGS. 43 and 44 to be described below).

Control circuit 13 can change (delay time signal DS) in the delay time when detecting circuit 11 generates detecting circuit 11 by this which can change impedance of detecting circuit 11 by the combination of an ON state of the electric switch SW1 - SM or the off state.

In FIG. 35, it is shown a control signal of electric switch SW1 - SWM in S1 - SM.

FIG. 37 is an illustration showing the other embodiments of a delay circuit of "invention C" and the delay circuit system.

In FIG. 37, delay circuit 1 consists of impedance circuit 12 and detecting circuit 11 and control circuit 13 and input buffer 14. Impedance circuit 12 is comprised of 12 (1) a plurality of impedance element - 12 (N).

Detecting circuit 11 is connected to the termination of input signal path 15, and group S of 12 (k) impedance circuit element (k = 1,2,3,..., N) is connected on input signal path 15. As for each impedance circuit element 12 (k), one end is connected to input signal path 15, and other end is connected to grand G.

In this embodiment, each impedance circuit element 12 (k) includes electric switch SW (k), respectively.

When on control signal SON was input, this electric switch electric switch SW (k) forms open position between input signal path 15 and gland G, and impedance Z (k) (or admittance lateral (k) = 1/Z (k)) is formed between input signal path 15 and gland G when off control signal SOFF was input.

Electric switch SW (k) is a transistor, and, in FIG. 37, impedance Z (k) includes element resistance r (k), element capacity C (k) and floating impedance Zf (floating resistance radio frequency, floating capacitance Cf and floating inductance Lf), respectively.

In this embodiment, the untied impedance of the ON is ZallON, and all electric switches of detecting circuit 11 are represented by an ON-OFF combination of electric switch SW (k).

1/ZallONt = Σ (however, a (k) / (Z (k)) is the coefficient that a (k) becomes " 1 " at the time of " 0 " , off when an electric switch is on.)

Σ is the totals from 1 to N.

Note that all admittance YZallON is represented in YZallON = Σa (k) lateral (k) when it is represented in an admittance.

FIG.38 is an embodiment which shows the delay circuit system using delay circuit to do disintegration spacing of the delay time equally and this.

In this embodiment, as for delay circuit 1, impedance possesses Z (1), Z (2), ..., impedance circuit elements of Z (N) one, respectively, (when a circuitry number of element was assumed P P = N), in delay time by each impedance circuit element Tk (k = 1,2,...., N) unit lag time as τ zero T1 (Z (1)) = τ zero

2 T2 (Z (2)) = τ0

22 T3 (Z (3)) = τ 0

• • •

$T k (Z (k)) = 2k-1\tau0$

• • •

$T N (Z (N)) = 2N-1\tau0$

It is represented $\mathbb{C}$ .

It is thereby possible for detecting circuit 13 to make spacing of the listing (lag time) equal spacing (with disintegration spacing of the delay time as equality).

FIG. 39 is an illustration of the delay circuit system using delay circuit 1 which replaced 12 (k) impedance circuit element (k = 1,2,3,..., N) of FIG. 37 with buffering B (k) (k = 1,2,3,..., N) and this.

In FIG. 39, it is made input impedance Z (k) = 20r of the buffering Bk the same as FIG. 38.

FIG. 40 is an illustration of the delay circuit system using delay circuit 1 that 12 (k) impedance circuit element (k = 1,2,3,..., N) is 3nd state buffer TBk and this.

In FIG. 40, input port of 3nd state buffer TBk is connected to input signal path 15, and control signal S (an on control signal or an off control signal) is input into a control terminal of 3nd state buffer TBk.

As for the listing, it is with high impedance without control signal S depending on state of things of the input at the time of (S = 0) at the time of OFF in 3nd state buffer TBk, and input just appears for the listing at the time of (S = 1) at the time of ON control signal S.

In FIG. 40, resistive elements shown in impedance and FIG. 38 shown in FIG. 37 are not connected, but such impedance and resistive elements can be connected to a preceding paragraph of 3nd state buffer TBk.

FIG.41 is an illustration which shows an electric wiring form of delay circuit 1 shown in FIG. 38.

In FIG. 41, lease Tate buffer TBk (k = 1,2,3,..., N) is placed in the concentric diameter orientation.

A circuit design becomes thereby easy because the electric wiring except the control signal line equals with each impedance circuit element 12.

FIG.42 is an illustration which shows application of delay circuit 1.

In FIG. 42, input clocks are increased to 4 times by three delay circuit unit UA, UB, UC. In this embodiment, configuration is the same as impedance circuit element 12A of unit UA and impedance circuit element 12C of impedance circuit element 12B of unit UA and unit UA.

Unit A is provided with control circuit 13, but unit B and unit C are not provided with the control circuit, and, with impedance circuit element 12B and impedance circuit element 12C, is controlled by control circuit 13 of unit UA.

Because late delay is produced by one period of quarter of input signal S0 in unit UA, unit UB, unit UC, as for delay circuit 1 of FIG. 42, control circuit 13 works as substantial clock 4 times circuitry.

FIG. 43 is an illustration showing the embodiments that applied a delay circuit of "invention C" and a delay circuit system to power conversion equipment 2.

FIG. 43 uses clock 4 times circuitry of FIG. 42 to the clock of the control signal.

In FIG. 43, it is from power converters 21 which power conversion equipment 2 inputs electric power from direct current power supply 31, and supply electric power to load 32 and controller 22.

As for controller 22, it is from signal generator 222 and reference clock generator circuit 223 and pulse compound circuit 224 and delay circuit 1 of FIG. 42 in control circuit 221 and period.

Control circuit 221 converts voltage corresponding to output voltage eo from signal generator 222 into a periodic signal in period, and PWM control can be performed by well-known technique.

With power conversion equipment 2 of FIG. 43, in reference pulse S0 which reference clock generator circuit 223 produces, a phase is converted into three different pulse SDA, SDB, SDC by 90. by unit A, unit B, unit C.

These pulses are sent out to signal generator (V-F translate circuit) 222 by pulse compound circuitry 224 in control circuit 221 and period.

Thus, the available clock of signal generator 222 can do reference clock generator circuit 223 with 4 times of the pulse to occur in control circuit 221 and period.

It is the illustration showing the embodiment that FIG. 44 wears a delay circuit of FIG. 42 of "invention C", and applied a delay circuit system to power conversion equipment 4. In FIG. 44, it is from power converters 41 which power conversion equipment 4 inputs electric power from direct current power supply 31, and supply electric power to load 32 and controller 42.

Controller 42 possesses control circuit 421 and periodic signal generation circuitry 422, and controller 42 has driving signal generation circuitry 423 and frequency detecting circuit 424.

Also, frequency detecting circuit 424 comprises delay circuit 1 described in FIG. 41 from judgment circuitry 425 and FIGS. 35 and 37.

Periodic signal generation circuitry 422 detects current flowing (circuit current equivalency voltage Vi) with output voltage eO of electric power strange replacement device 41 and the electric reactor which is not illustrated or a control switch, and the detection value is converted into the 1st periodic signal F1.

Frequency detecting circuit 424 consists of delay circuit 1 and judgment circuitry 425. Periodic signal generation circuitry 423 detects output voltage eO and circuit current equivalency voltage Vi as voltage signal F1, and it is output to judgment circuitry 425. Delay control turn (from FIG. 35, FIG. 36 a control circuit in FIG. 41) of delay circuit 1 13 sets $\Delta\tau$ in impedance circuit 12 in delay time, and, as for delay circuit 1, $\Delta\tau$ outputs 2nd periodic signal F2 which delayed to judgment circuitry 425 to the 1st voltage signal F1.

Judgment circuitry 425 detects whether 1st periodic signal F1 and 2nd periodic signal F2 are input, and period of the 1st periodic signal F1 was included in period of the 2nd periodic signal F1 and/or whether period of 2nd periodic signal F2 was included in period of the 1st periodic signal F1, and judgment signal is output.

Driving signal generation circuitry 423 generates control signal VGs from this judgment circuitry signal, and this is sent out to the electric switch which is not illustrated included in power inverter circuit 21.

In FIG. 44, output voltage voltage and circuit current equivalency voltage Vi of power converters 21 are detected in a control circuit, and a delay control signal is generated.

**Claims**

1. A number detection apparatus comprising from the delayed signals output circuit and the judgment circuitry, wherein,
   the requency supplies a signal to the delayed signals output circuit two periods that retarded a time changing first periodic signal for predetermined time,
   the judgment circuitry inputs the first periodic signal and the second periodic signal,
   the judgment circuitry detects whether the first period included period of a signal for period of a signal in the second period, and judgment signal is output,
   and/or,
   the judgment circuitry detects whether the second period included period of a signal for period of a signal in the first period, and judgment signal is output.

2. The frequency detection apparatus as claimed in (1), wherein,
   the judgment circuitry detects time when the first period included period of a signal for period of a signal in the second period, thereby,
   judges that the frequency of the first periodic signal changed in a predetermined level of the high pass side or that it rose to the predetermined value,
   and/or,
   the judgment circuitry detects time when the second period included period of a signal for period of a signal in the first period, thereby,
   judges that the frequency of the first periodic signal changed in a predetermined level of the low level side or that it dropped in predetermined value.

3. A frequency detection apparatus as claimed in (2), wherein
   the judgment circuitry,
   when that period of a signal was included for period of a signal in the second period in the first period was detected,
   That the frequency of the first periodic signal changes into a predetermined level of the high pass side depending on the detected number of times or it rose to the predetermined value is judged.

4. When, as for the judgment circuitry, $\Delta\tau$ meets a lower formula,

$$\mathrm{T1+T2+\ ...\ TJ} <= \Delta\tau < \mathrm{T1+T2+\ ...\ TJ+TJ+1}$$

   (an integer positive in Tk (k = J, k-th pulse of the first periodic signal as for ...,3,2,1), J),
   when period of a signal detected that it was included for period of a signal in the first period in the second period,
   It is judged that the frequency of the $\Delta\tau$ (j = J, ...,3,2,1) first periodic signal changes into a predetermined level of the high pass side (1/j) in delay time or period rose to the predetermined value.

5. A frequency detection apparatus as claimed in (1),
   wherein the delay circuit inputs the first periodic signal, and the second periodic signal is output, is initialized.

6. A frequency detection apparatus to assume a frequency detection apparatus as claimed in (5) either hot 1 unit, wherein,

the R units (the first - the Rth ) are connected in parallel, in which the first periodic signal is common,
a delay time $\Delta\tau1$ to the first periodic signal of the second periodic signal in the first unit,
a delay time $\Delta\tau1$ to the first periodic signal of the second periodic signal in the second unit,
. . .
a delay time $\Delta\tau1$ to the first periodic signal of the second periodic signal in the R-th unit, are different each other.

7. A frequency detecting device that the frequency detecting apparatus discribed in either of (1)-(5) is defind as one unit, wherein,
the 1st-Rth units are connected to in parallel,
a delay time $\Delta\tau$ to the first periodic signal of the second periodic signal in each unit is the same,
the phase of each first periodic signal in the 1st-Rth unit is different by $2\pi/R$.

8. A frequency detection apparatus as claimed in claim 1, wherein,
the first periodic signal is performed voltage-frequency conversion of.

9. A requency detection methods that the second periodic signal delaying to the first periodic signal from the first periodic signal that frequency changes at time for predetermined time is generated, and this is output,
frequency detection methods
the frequency detection methods including judging that the frequency of the above first periodic signal changes into a predetermined level of the low level side by detecting time when that the frequency of the above first periodic signal changes into a predetermined level of the high pass side by detecting time when the first period included period of a signal for period of a signal in the second period or it rose to the predetermined value is judged and/or period of a signal was included for period of a signal in above first period in above second period or it dropped in predetermined value.

10. When that period of a signal was included for period of a signal in the second period in the first period was detected, depending on the number of times, period is $\Delta\tau/i$ by the detection of i turn eyes the frequency of the first above periodic signal in delay time (an integer positive in i = 1,2,..., I, I)

11. In a case of T1+T2+ ... TJ $\leqq \Delta\tau$ <T1+T2+ ... TJ+TJ+1,
Including judging that the frequency of the first above periodic signal changes in a predetermined level of the high pass side by delay time or period reached the place set price of the rise direction side in j-th detection when that the second period included period of a signal for period of a signal in the first period was detected or it is frequency detection methods as claimed in (10) (9).

12. Whenever the first periodic signal is input, and the second periodic signal is output,
A frequency detection methods as claimed in either of (9)-(11) including the deference of the second periodic signal being initialized.

13. A frequency detection method as claimed in either of (9)-(12) including the first periodic signal being performed voltage-frequency conversion of.

14. The electric circuit controller comprising driving signal generation circuitry, periodic signal generation circuitry and the frequency detecting circuit, wherein
the driving signal generation circuitry drives at least one electric switch included in the electric circuit,
the periodic signal generation circuitry detects an electric information (voltage/ current/ electric power/ phase) changing than the electric switch being driven more than one or
one, and a periodic signal is generated from at least one electric information chosen by these detecting signals, and this is output as the first periodic signal,
the delayed signals generation circuitry outputs the second periodic signal which retarded the first periodic signal for predetermined time,
the judgment circuitry detects whether the first periodic signal and the second periodic signal are input, and period of a signal was included for period of a signal in above second period in above first period and/or whether period of a signal was included for period of a signal in above first period in above second period, and judgment signal is output.

15. An electric circuit controller as claimed in (14), wherein,
the electric signal are selected from below group.
the input voltage of the electric circuit,

the input voltage of the electric circuit,
Voltage emerging to an element comprising the electric circuit or equipment, the element or above equipment current flowing,
the output voltage of the electric circuit,
the output current of the electric circuit.

16. The electric circuit controller which was described in (14) or (15), wherein,
it is retarded without being based on the change of the electric information or the delayed signals generation circuitry retards the first periodic signal based on at least one of the above electric information, and an above second periodic signal is output.

17. An electric circuit controller as claimed in (14)-(16), wherein,
The frequency detecting circuit judges that the frequency of the above first periodic signal dropped in predetermined
value because the frequency of the above first periodic signal judges rise たことを in predetermined value because the judgment circuitry detects time when period of a signal was included for period of a signal in above second period in the first period and/or above judgment circuitry detects time when period of a signal was included for period of a signal in above first period in above second period.

18. An electric circuit controller as claimed in (14)-(17), wherin,
the judgment circuitry,
when that the first period included period of a signal for period of a signal in the second period was detected, that the frequency of the first periodic signal changes in a predetermined level of the high pass side by the i-th detection by delay time with the period or the frequency of the above first periodic signal reached the place set price of the rise direction side depending on the number of times is judged.
the delay time $\Delta\tau/i$ (an integer positive in i = 1,2,..., I, I):

19. An electric circuit controller as claimed in (14)-(18) including the judgment circuitry judging that the frequency of the above first periodic signal changes in a predetermined level of the high pass side in $\Delta\tau$ (j = J, ...,3,2,1) (1/j) in delay time or period reached the place set price of the rise direction side in j-th detection when that period of a signal was included for period of a signal in above first period in the second period was detected in a case of T1+T2+ ... +TJ <= $\Delta\tau$ <T1+T2+ ... +TJ+TJ+1 (an integer positive in J).

20. Whenever the delay circuit inputs the first periodic signal, and the second periodic signal is output, an electric circuit controller as claimed in either from (1) from to (7) including what is initialized.

21. A frequency detecting circuit comprising an electric circuit controller as claimed in either of hot (20) is done with 1 unit, and it is the electric circuit controller comprising the frequency detecting circuit that it is made a common use of in an above first periodic signal, and R unit is connected from the first unit in parallel, and it is, and in the delay time to the first periodic signal of the second periodic signal in the first unit in the delay time to the first periodic signal of the second periodic signal in $\Delta\tau1$ and the second unit $\Delta\tau2$,
• • •
An electric circuit controller of the description including $\Delta\tau R$ being different in the delay time to the first periodic signal of the second periodic signal in the R unit.

22. A frequency detecting circuit comprising an electric circuit controller as claimed in (14)-(21) is done with 1 unit, and it is the electric circuit controller comprising the frequency detecting circuit that it is made a common use of in an above first periodic signal, and R unit is connected from the first unit in parallel, and it is, and in the delay time to the first periodic signal of the second periodic signal in the first unit in the delay time to the first periodic signal of the second periodic signal in $\Delta\tau1$ and the second unit $\Delta\tau2$,
• • •
an electric circuit controller of the description including $\Delta\tau R$ being different in the delay time to the first periodic signal of the second periodic signal in the R unit.

23. Because the electric circuit is AC/DC power inverter circuit of current control type or the voltage-controlled or DC/DC power inverter circuit, and the electric information is **characterized by** being chosen voltage appearing to the input voltage of the electric circuit, the input voltage of the above electric circuit, an element comprising an above electric circuit or the equipment, an above element or above equipment by current flowing, the output voltage of the above electric circuit, the group of the output current of the above electric circuit, an electric circuit controller as claimed in either from (14) to (22).

24. A periodic signal is generated from an electric information of at least one that an electric information (voltage / current / electric power / a phase) changing by the drive of the electric switch of at least one included in the electric circuit is detected more than one or one, and was chosen by these measuring signal, and it is a method to control an electric circuit by detecting the frequency of the note periodic signal, and in detection of the above frequency,
The electric circuit control method including it is detected whether the second periodic signal which retarded the first periodic signal for predetermined time is generated, and the first periodic signal and above second periodic signal are input, and period of a signal was included for period of a signal in above second period in above first period and/or whether period of a signal was included for period of a signal in above first period in above second period, and judgment signal is output, and driving an above electric switch depending on the judgement result.

25. The electric circuit control method as claimed in (24) including being chosen voltage appearing to the input voltage of the electric circuit, the input voltage of the electric circuit, an element comprising an above electric circuit or the equipment, an above element or above equipment as the electric information by current flowing, the output voltage of the above electric circuit, the group of the output current of the above electric circuit.

26. Including it is retarded without being based on the change of the electric information or the first periodic signal is retarded based on at least one of the above electric information, and outputting an above second periodic signal or it is an electric circuit control method as claimed in (24) (25).

27. An electric circuit control method as claimed in either from (24) to (26) including judging that the frequency of the above first periodic signal changes in a predetermined level of the low level side because the frequency of the above first periodic signal detects time when that it changes or the place set price of the rise direction side was reached is judged and/or a predetermined level of the high pass side included period of a signal for period of a signal in above first period in above second period by detecting time when the first period included period of a signal for period of a signal in the second period or the place set price of the drop direction side was reached.

28. An electric circuit control method as claimed in either from (24) to (26) including the frequency of the above first periodic signal judging that the frequency of the first periodic signal changes in a predetermined level of the high pass side in $\Delta\tau/i$ (an integer positive in i = 1,2,..., I, I) in delay time or period reached the place set price of the rise direction side by the i-th detection depending on the number of times when that the first period included period of a signal for period of a signal in the second period was detected.

29. The first period period of a signal,

$$\mathrm{T1+T2+ \ldots +TJ <= \Delta\tau < T1+T2+ \ldots +TJ+TJ+1 \ (an\ integer\ positive\ in\ J)}$$

An electric circuit control method as claimed in either from (24) to(26) including judging that the frequency of the above first periodic signal changes in a predetermined level of the high pass side in $\Delta\tau$ (j = J, ...,3,2,1) (1/j) in delay time or period reached the place set price of the rise direction side in j-th detection when that the second period included period of a signal for period of a signal in the first period was detected in ⑦ case.

30. The delay circuit including the delay time when an above detecting circuit generates by one end is connected to the input signal path of the detecting circuit, and other end is a delay circuit having an impedance circuit connected to a gland, and a plurality of electric switches to change the overall impedance of the above impedance circuit into when an on control signal or an off control signal was input, respectively, be included in an above impedance circuit, and changing the impedance of the above impedance circuit by the combination of the ON state of the electric switch of plural above or the off state changing.

31. The delay circuit as claimed in (30) including the thing including impedance (a resistance ingredient, a capacity ingredient, an inductance ingredient) that the electric switch of plural at least above has the impedance circuit and/or the impedance due to the electric wiring.

**32.** The impedance circuit including the thing including a resistance element, a capacitive element, one of the inductance elements or combinations thereof or it is a delay circuit as claimed in (30) (31).

**33.** A delay circuit as claimed in either from (2) to (3) including the electric switch being a gate electric switch (the buffer with the control terminal).

**34.** The delay circuit system including the thing comprising the delay control circuit which sends out an ON-OFF control signal to a delay circuit as claimed in (33) either hot and each electric switch.

**35.** The delay circuit including the delay time when an above detecting circuit generates by one end is connected to the input signal path of the detecting circuit, and other end is a delay circuit having a plurality of impedance circuit element connected to a gland, and open position is formed between an above input signal path and an above gland when an on control signal was input, and the electric switch which forms impedance between an above input signal path and an above gland when an off control signal was input be included in each impedance circuit element, respectively, and changing the impedance of the above impedance circuit by the combination of the ON state of each electric switch or the off state changing.

**36.** The delay circuit as claimed in (35) including the thing including impedance (a resistance ingredient, a capacity ingredient, an inductance ingredient) that at least electric switch has the impedance circuit element and/or the impedance due to the electric wiring.

**37.** The impedance circuit element including the thing including a resistance element, a capacitive element, one of the inductance elements or combinations thereof or it is a delay circuit as claimed in (35) (36).

**38.** A delay circuit as claimed in either from (35) including impedance is P unit comprised delay circuit in Z (1), Z (2), ..., impedance circuit element of Z (N), respectively, and being represented unit lag time as $\tau$ zero in Tk (Z (k)) = (P+1) k-1$\tau$0 (k = 1,2,...., N) Tk in delay time by each impedance circuit element to (37).

**39.** A delay circuit as claimed in either from (37) to (38) including the electric switch being a gate electric switch (the buffer with the control terminal.

**40.** A delay circuit as claimed in either from (35) to (39) including the impedance circuit element includes a buffer, and the gland side being provided with the buffer than the electric switch.

**41.** The detecting circuit is a delay circuit as claimed in either from (35) to (40) including the thing including the CR integrating circuit comprising capacitive elements and a resistance element, capacitive elements and resistance elements.

**42.** (35) The delay circuit system including the thing comprising the delay control circuit which sends out an ON-OFF control signal to a delay circuit as claimed in (12) either hot and each electric switch.
when frequency conversion is made, and voltage and the current of all parts are detected in an AC/DC converter, DC/DC converter, boost chopper, depression chopper, and (output current, output voltage, output power, input current, output voltage, input power) to control listing and input is controlled, the delay circuit system of "invention C" is particularly effective.

# Fig. 1

11(Frequency Detection Apparatus)

$f_1$ $F_1$

$F_1$

12

$t$

Delayed Signals Output Circuit

11

(Delay Time $\Delta\tau$)

$F_2$

Judgment Circuit

(A)

$f_1$

$F_1$

$f_{1,1}$

$\Delta\tau$

$t$

detected upper limit

(B)

$f_{1,1}$ upper limit

$F_1$

1    2    3   4   5   6  7  8 9 10

$F_2$

1    2    3   4   5  6 7 8 9 10

$\Delta\tau$    $\Delta\tau$    $\Delta\tau$

(C)

# Fig. 2

11(Frequency Detection Apparatus)

$f_1$

$F_1$

$t$

$F_1$

Delayed Signals Output Circuit
(Delay Time $\Delta\tau$ ) — 11

$F_2$

12

Judgment Circuit

Counter — 121

(A)

$f_1$

$F_1$

$f_{1,2}$

$f_{1,1}$

$t$

the First Time Detection of the Upper Limit

the Second Time Detection of the Upper Limit

(B)

the First Time Detection of the Upper Limit

$f_{1,1}$ $f_{1,2}$

12
11

$F_1$

1    2    3    4  5  6  7  8 9 10

$F_2$

1    2    3    4  5 6  7  8 9 10 11

the Second Time Detection of the Upper Limit

$\Delta\tau$      $\Delta\tau$    $\Delta\tau/2$  $\Delta\tau/2$

(C)

# Fig. 3

12(Frequency Detection Apparatus)

(A)

(B)

(C)

# Fig. 4

2(Frequency Detection Apparatus)

F$_1$

Judgment Circuit —22

Delayed Signals Output Circuit (Delay Time $\Delta \tau$) —21

Counter —221

F$_1$

F$_2$

(A)

f$_1$

f$_{1,2}$

f$_{1,1}$

F$_1$

t

the First Time Detection of the Lower Limit

the Second Time Detection of the Lower Limit

(B)

13Hz   f$_{1,1}$   f$_{1,2}$   1Hz

1 2 3 4 5 6 7 8 9 10

F$_1$

T$_1$

1 2 3 4 5 6 7 8 9 10

F$_2$

$\Delta\tau$

$\Delta\tau/2$

$\Delta\tau$

the Second Time Detection of the Lower Limit

the First Time Detection of the Lower Limit

(C)

# Fig. 5

3(Frequency Detection Apparatus)

(A)

Upper Limit
Detection

Lower Limit
Detection

(B)

# Fig. 6

# Fig. 7

3(Frequency Detection Apparatus)

(A)

(B)

# Fig. 8

# Fig. 9

4(Frequency Detection Apparatus)

# Fig. 10

# Fig. 11

# Fig. 12

# Fig. 13

# Fig. 14

$s_{AQ}$

$s_{BQ}$

$s_Q$

# Fig. 15

101

Electric Circut

one or more drive signals

102(Electric Circuit Controller)

1042

105

Driving Signal generation circuit

$V_{Gs}$

Judgement Circuit

$F_1$

$F_2$

Delayed Signal Output Circuit

1041

$\Delta_\tau$

103

Frequency Signal Generating Circuit

one or more Electric Signals (the First Signal Group)

104(Frequency Detection Circuit)

# Fig. 16

# Fig. 17

1:Power Conversion Equipment

# Fig. 18

1:Power Conversion Equipment

11

va ○

vb ○

vc ○

Power Converter
(Electric Circuit)

82

Load

Va_Gs

Vb_Gs

Vc_Gs

12c(c-Phase Controller)

12b(b-Phase Controller)

12a(a-Phase Controller)

c-Phase Electric Signal

b-Phase Electric Signal

a-Phase Electric Signal

# Fig. 19

1:Power Conversion Equipment

11:Power Converter
(Electric Circuit)

Load

12(Electric Circuit Controller)

14(Frequency
Detection Circuit)

13

Driving Signal
generation
circuit

Judgment Circuit

Delayed Signal
Output Circuit

Frequency Signal
Generating Circuit

$V_{GS}$

$S_Q$

$F_1$ $(f_1)$

$F_2$

$v_1$

$v_2$

$i_L$

$R_S$

$e_O$

L

$V=R_S \cdot i_L$

# Fig. 20

(A)

(B)

# Fig. 21

# Fig. 22

(A)

(B)

# Fig. 23

1:Power Conversion Equipment

11:Power Converter
(Electric Circuit)

11:Power Converter
(Electric Circuit)

$i_S$

116

L

$e_0$

82

111

$R_1$

112

115

Load

81

114

$i_D$

$V_1 = R_1 \cdot i_s$

$V_2 = R_2 \cdot i_D$

to Frequency
Signal
Generating
Circuit 13

Fig. 24

# Fig. 25

$\pi$

First Periodic Signal $F_1$
of Frequency Signal
Generating Circuit 23A

t

First Periodic Signal $F_1$
of Frequency Signal
Generating Circuit 23B

t

# Fig. 26

# Fig. 27

# Fig. 28

1:Power Conversion Equipment

11:Power Converter
(Electric Circuit)

111

L   $i_L$
R

112
114

113

115

71

72

Load

$V = R_s \cdot i_L$

14A(Frequency
Detection Circuit)

142

$F_1$ ($f_1$)

13

$S_Q$

Judgment Circuit

$F_{A2}$

Delayed Signal Output Circuit

Frequency Signal Generating Circuit

$v_1$

$v_2$

141

Driving Signal generation circuit

$e_0$

14B(Frequency
Detection Circuit)

$V_{GS}$

15

142

$F_1$ ($f_1$)

$S_Q$

Judgment Circuit

$F_{B2}$

Delayed Signal Output Circuit

141

$e_0$

# Fig. 29

(A)

(B)

(C)

# Fig. 30

2:Power Conversion Equipment

# Fig. 31

(A)

(B)

(C)

# Fig. 32

2:Power Conversion Equipment

21

Power Converter
(Electric Circuit)

81

82

Load

$V_{Gs}$

22(Electric Circuit Controller)

242

Judgment
Circuit

$F_{A1}$

$F_{A2}$

Delayed Signal
Output Circuit

23

Frequency Signal
Generating Circuit

$e_0$

241

$\Delta \tau$

25

Driving Signal
generation
circuit

224A(Frequency
Detection
Circuit)

242

Judgment
Circuit

$F_{B1}$

$F_{B2}$

Delayed Signal
Output Circuit

24B(Frequency
Detection
Circuit)

241

$\Delta \tau$

# Fig. 33

(A)

(B)

(C)

(D)

# Fig. 34

9:Power Conversion Equipment

**91**

Power Converter

**81**

**82**

Load

Control Pulse

Driving Signal Generating Circuit

Frequency Signal Generating Circuit

e0

**93**

**92**

# Fig. 35

# Fig. 36

# Fig. 37

1:Delay Circuit

Detection Circuit

11

$V_{SH Pre-set}$

Control Circuit

13

S1 S2 ... SN

Impedance Circuit

SD

Input Signal Path

15

$SW_1$ $SW_2$ ... $SW_N$

$z_1$ $z_2$ ... $z_N$

G

12

14

$z_0$ Rg

# Fig. 38

# Fig. 39

Fig. 40

# Fig. 41

# Fig. 42

1:Delay Circuit

S0

S0

SDA

SDB

SDC

14A  Input Signal Path  15A  11A  Detection Circuit

12A  Impedance Circuit  S1  S2  SN  Control Circuit  13

UA  $z_0$

14B  Input Signal Path  15B  11B  Detection Circuit

12B  Impedance Circuit  S1  S2  SN

UB  $z_0$

14C  Input Signal Path  15C  11C  Detection Circuit

12C  Impedance Circuit  S1  S2  SN

UC  $z_0$

# Fig. 43

2:Power Conversion Equipment

# Fig. 44

# Fig. 45

## INTERNATIONAL SEARCH REPORT

| | International application No. |
|---|---|
| | PCT/JP2008/071742 |

A. CLASSIFICATION OF SUBJECT MATTER
*G01R23/15*(2006.01)i, *G01R23/10*(2006.01)i, *H03D3/00*(2006.01)i, *H03K5/19* (2006.01)i

According to International Patent Classification (IPC) or to both national classification and IPC

B. FIELDS SEARCHED

Minimum documentation searched (classification system followed by classification symbols)
G01R23/00-23/20, H03D3/00, H03K5/00-5/02, 5/08-5/12, 5/15-5/26

Documentation searched other than minimum documentation to the extent that such documents are included in the fields searched
Jitsuyo Shinan Koho      1922-1996   Jitsuyo Shinan Toroku Koho   1996-2009
Kokai Jitsuyo Shinan Koho  1971-2009   Toroku Jitsuyo Shinan Koho   1994-2009

Electronic data base consulted during the international search (name of data base and, where practicable, search terms used)
CiNii, JSTPlus(JDreamII)

C. DOCUMENTS CONSIDERED TO BE RELEVANT

| Category* | Citation of document, with indication, where appropriate, of the relevant passages | Relevant to claim No. |
|---|---|---|
| A | JP 4-48271 A (Yokogawa Electric Corp.), 18 February, 1992 (18.02.92), Page 3, upper left column, line 12 to page 6, upper left column, line 5; Figs. 1 to 3 (Family: none) | 1-29 |
| A | JP 63-177070 A (NEC Corp.), 21 July, 1988 (21.07.88), Page 1, lower right column, line 17 to page 2, upper left column, line 18; Fig. 1 (Family: none) | 1-29 |
| A | JP 2000-214193 A (NEC Engineering, Ltd.), 04 August, 2000 (04.08.00), Par. Nos. [0021] to [0038]; Figs. 1 to 6 (Family: none) | 1-29 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 May, 2009 (20.05.09) | 02 June, 2009 (02.06.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/071742

C (Continuation).   DOCUMENTS CONSIDERED TO BE RELEVANT

| Category* | Citation of document, with indication, where appropriate, of the relevant passages | Relevant to claim No. |
|---|---|---|
| A | JP 63-281062 A  (Hitachi, Ltd.),<br>17 November, 1988 (17.11.88),<br>Page 2, lower left column, line 5 to page 3,<br>lower right column, line 18; Figs. 1 to 4<br>(Family: none) | 1-29 |
| A | Shohei SUKITA, Fujio KUROKAWA, "Improvement of Dynamic Characteristics of Model Control DC-DC Coverter", IEICE Technical Report, 19 July, 2007 (19.07.07), Vol.107, No.149, pages 1 to 4 | 1-29 |
| Y | JP 2003-332897 A  (Yamaha Corp.),<br>21 November, 2003 (21.11.03),<br>Par. Nos. [0012] to [0025]; Figs. 1 to 2<br>& JP 3818216 B2        & US 2004/32704 A1<br>Par. Nos. [0057] to [0076]; Figs. 1 to 2<br>& US 6903577 B2 | 30-42 |
| Y | WO 2007/125670 A1  (Matsushita Electric Industrial Co., Ltd.),<br>08 November, 2007 (08.11.07),<br>Par. No. [0270]; Fig. 17<br>& EP 2015230 A1<br>Par. No. [0270]; Fig. 17 | 30-42 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003344463 A
- JP 7154435 A
- JP 2002330545 A
- JP 2141029 A